Europäisches Patentamt

European Patent Office

Office européen des brevets

(11) Publication number: **0 212 328**
**A1**

## (12) EUROPEAN PATENT APPLICATION

(21) Application number: **86110247.3**

(22) Date of filing: **25.07.86**

(51) Int. Cl.⁴: **H 01 L 29/68, H 01 L 33/00**

(30) Priority: **26.07.85 US 759634**
**17.10.85 US 788594**

(43) Date of publication of application: **04.03.87**
**Bulletin 87/10**

(84) Designated Contracting States: **AT BE CH DE FR GB IT LI LU NL SE**

(71) Applicant: **ENERGY CONVERSION DEVICES, INC., 1675 West Maple Road, Troy Michigan 48084 (US)**

(72) Inventor: **Czubatyj, Wolodymyr, 2426 Walter, Warren Michigan 48092 (US)**
Inventor: **Hack, Michael G., 1225 Kenilworth, Clawson Michigan 48017 (US)**
Inventor: **Shur, Michael, 217 Janalyn Circle, Golden Valley Michigan 55416 (US)**

(74) Representative: **Müller, Hans-Jürgen, Dipl.-Ing. et al, Müller, Schupfner & Gauger Lucile-Grahn-Strasse 38 Postfach 80 13 69, D-8000 München 80 (DE)**

(54) Double injection field effect transistor.

(57) A field effect transistor (FET), which may be horizontally or vertically arranged, includes a body of semiconductor material extending between two current-carrying electrodes and forming a current path therebetween. Some embodiments are thin film devices; others are crystalline devices. Some have a semiconductor body that is substantially intrinsic; others have a semiconductor body that is doped. A control electrode or gate located adjacent to the current path projects a variable electric field over the path, which modulates current by controlling the amount of charge carriers injected into the semiconductor body. The preferred embodiments are double injection FETs, called DIFETs, which have ambipolar current in the current path and thus exhibit increased current flow. In the DIFETs, a single gate voltage controls charge carriers of both polarities simultaneously. Depending upon configuration and geometry, DIFETs can enhance and/or deplete ambipolar current. Alternate embodiments are single injection FETs, which have charge carriers of only one polarity in the semiconductor body.

Vertical embodiments, called VMITs, are formed by successively depositing various layers. The gate is typically formed as a layer within the semiconductor body. The body is located between the two current electrodes. The gate layer has at least one opening through which the material of the current path extends. The gate may be formed as a Schottky barrier, or a reverse junction, or may be insulated. Certain VMITs feature multiple gates, and may be configured as AND, NOR or other logic gates.

Some DIFETs use space charge neutralization, achieved by a fourth electrode or other techniques, for even higher current. Enhancement mode DIFETs exhibit significant increased channel depth over an equivalent single carrier device. Some DIFETs, made preferably of amorphous silicon alloys, exhibit light emission. A DIFET laser made from such alloys is disclosed. Modulation of the amplitude and/or frequency of the DIFET's optical output by varying gate voltage is disclosed.

ACTORUM AG

Tele'on: (0 89) 4 70 60 55/56
Telex: 5 23016
Telegramm / cable:
Zetapatent® München

Postfach 80 13 69
Lucile-Grahn-Straße 38
D-8000 München 80

Hans-Jürgen Müller
Gerhard D. Schupfner
Hans-Peter Gauger
Patentanwälte
European Patent Attorneys
Mandataires en brevets européens

3488. PT-EP
Energy Conversion Devices,
Inc.

## Double injection field effect transistor

The present invention relates generally to
semiconductor structures for analog or digital applications
which have ambipolar or unipolar current modulated by electric
fields produced due to a voltage applied to a control
electrode, and more particularly to two classes of field effect
transistor structures which may respectively be called DIFETs,
for double injection field effect transistors, and VMITs, for
vertical modulated injection transistors. Both DIFETs and
VMITs have an intrinsic or doped semiconductor region or body
located between two or more current path electrodes and at
least one gate or control electrode located adjacent to or
within the intrinsic region for modulating or switching the
ambipolar or unipolar current flowing between such current path
electrodes by voltage applied to the control electrode.

### BACKGROUND OF THE INVENTION

The explosive growth of semiconductor technology in
the past several decades has produced a variety of transistor
devices, almost all of which enable the current through two
terminals of such a device to be controlled by a signal
supplied to a third terminal. One such transistor is the
bipolar transistor, which includes an emitter formed of a first
conductivity type, a base formed of a second conductivity type,

-2-

Case 385

and a collector formed of the first conductivity type. At least one amorphous silicon (a-Si) bipolar transistor has been investigated, as described in the Japanese Journal of Applied Physics, pp. 714-15 (Sept. 1934).

The technology has produced a number of field effect transistors (FETs). In the typical field effect transistors, the current in the active region or conduction channel of the FET is formed by carriers of one polarity only, that is, the number of carriers of the other polarity in the current, if any, is operationally insignificant. One such FET is the junction field effect transistor, or JFET, in which the voltage supplied to a gate electrode varies the depletion width of a reverse biased p-n junction formed between the gate electrode and the current conducting channel. The conductivity of the channel is modulated by varying the percent of that channel which is depleted as a result of voltage applied to the gate. A similar device called the metal-semiconductor FET, or MESFET, has a gate electrode made of a metal which forms a Schottky barrier with the semiconductor material of the conducting channel. Another well known type of field effect transistor is one in which the gate electrode is separated from the semiconductor channel by an insulator. Perhaps the most well known of such insulated gate transistors is the metal-oxide-semiconductor FET, or MOSFET, in which a metal gate is separated from a semiconductor channel by a silicon oxide insulator.

Case 885

Also relevant to the background of the present invention are those earlier field effect transistors in which the semiconductor material connected between the two current path electrodes is sufficiently conductive to allow current flow in the absence of either an applied field created by a control electrode. Such transistors include the JFETs and MESFETs described above, in which the depletion region formed by contact of the transistor's semiconductor channel region with its gate electrode can be expanded or contracted by applying a control voltage to the gate electrode.

A somewhat similar device is the depletion-mode MOS transistor. This transistor differs from the JFET and the MESFET just described in that its gate electrode is electrically insulated from its semiconductor channel. However, it is similar to those devices in that its semiconductor channel is normally "on", or conducting, in the absence of a voltage applied to its gate electrode and requires the application of a voltage to its gate electrode to shift the Fermi level of its channel so as to deplete that channel of majority carriers, and turn the transistor "off" to make it non-conducting.

The MOSFETs mentioned above also can be operated in an enchancement mode, wherein a voltage is applied to the gate to induce a channel of minority carriers in a doped substrate between the source and drain, thereby allowing the minority carriers to flow therein in response to a voltage applied to the source and drain. Enhancement mode MOSFETs have found wide application, and, for example, are the building blocks from which CMOS devices are made.

-4-

Case 835

Various transistor structures having a gate or grid electrode inside the transistor between two current-carrying electrodes have also been disclosed over the past three decades. In U.S. Patent No. 3,385,731 to P.K. Weimer (1968), there is disclosed thin film transistor having an insulated grid disposed in the outer of a body of semiconductor material such as cadium sulfide, with metallic current-carrying electrodes on the top and bottom of the semiconductor body. S. Teszner and R. Gicquel, "Gridistor -- A New Field Effect Device," Proc. IEEE, Vol. 52, pp. 1502-1513 (1964), discloses a plurality of epitaxially grown multichannel FETs each having an embedded grid and provides characteristic curves of drain-current versus drain-voltage with both negative and positive gate voltages. The grid is composed of a diffused semiconductor of a type opposite to the semiconductor it is embedded in. R. Zuleeg, "Multi-channel Field-Effect Transistor Theory and Experiment", Solid-State Electronics, Vol. 10, pp. 559-576 (1967), discusses experimental and theoretical results for a unipolar multichannel FET having a vertical channel arrangement constricted from a crystalline substrate using diffusion, masking and sequential epitaxial growth. C.O. Bozler et al., "Fabrication and Microwave Performance of the Permeable Base Transistor", IEEE Technical Digest, Int. Electron Device Meeting, pp. 384-387 (1979), describes a transistor having an embedded base electrode. It is somewhat similar in basic concept to the MESFET described above. It is a vertical structure having a crystalline $n^+$ gallium arsenide substrate on top of an emitter contact, an n-type crystalline gallium arsenide layer over the substrate, and a thin metal layer of tungsten deposited over the n-type layer. The

- 5 -

Case 805

tungsten layer forms a Schottky barrier with the n-type gallium arsenide. The tungsten is patterned using X-ray lithography to create extremely fine slits which expose portions of the n-type layer beneath it. Epitaxial overgrowth is then used to build a layer of n-type crystalline gallium arsenide over the patterned metal film, in order to continue the conductive path formed by the n-type gallium arsenide below the metal layer. Then a collector contact is placed over this top n-type layer. The use of X-ray lithography enables the spacing between the slits in the tungsten film to be sufficiently narrow so that the Schottky barrier formed by the interface between the tungsten and the n-type gallium arsenide forms a potential barrier that extends across the slits in the metal film. This barrier greatly reduces current flow between the emitter and the collector of the device. By applying a positive voltage to the metal layer, however, the width and strength of the Schottky barrier which extends across the slits can be greatly reduced, which greatly increases the conductivity between the emitter and the collector. Thus, the conductivity of the channel between the emitter and the collector can be greatly modulated by applying voltages to the tungsten layer, which serves as a kind of gate electrode.

J. Nishazawa et al., "Field-Effect Transistor Versus Analog Transistor (Static Induction Transistor)", IEEE Transactions, Vol. ED-22, pp. 185-197 (1975), discloses another FET having an epitaxially grown gate or grid. In one version, the vertically arranged channel between source and drain must be pinched off by application of a negative bias to the gate; in another, the vertical channel is pinched off without any

Case 885                    -7-

gate bias voltage applied. U.S. Patent No. 4,466,173 to B.J. Baliga (1984) discloses an all crystalline FET having a buried grid formed by etching deep grooves and using planar epitaxial growth to refill them with silicon of the opposite conductivity.

The aforementioned Nishizawa reference also discloses that a thyristor structure constructed using the principles of the static induction transistor (SIT), which is comprised of a forward-biased diode provided with a line- or mesh-type gate embedded in the n-type semiconductor portion of the diode. D.E. Houston et al., "A Field Terminated Diode", IEEE Transactions, Vol. ED-23, pp. 905-911 (1976), discloses two somewhat similar thyristor devices called a field terminated diode (FTD) and a field controlled thyristor (FCT). These three terminal devices both feature a $p^+$ anode an $n^-$ base, and an $n^+$ cathode. The FCT includes a p-type grid embedded in the $n^-$ base. The FTD, includes a p-type grid adjacent to the $n^-$ base. Both devices are fabricated in crystalline form using standard photolithographic, diffusion and epitaxial techniques. When the devices are in their on condition, the anode and cathode junctions are forward biased and the grid contact is open. The holes and electrons injected into the $n^-$ base region between the anode and cathode lower its resistivity resulting in a low on state voltage drop. To turn off the devices, a reverse bias is applied to the grid with respect to the cathode. The current from anode to cathode is diverted to the grid since it is now an efficient collector of holes. The FTD disclosed, however, cannot fully interrupt the current due to ohmic drops along the length of its fingers which limit the amount of current which can be carried by the

Case 835

grid. If the applied grid bias is large enough, the n-type material next to the grids is depleted of free carriers so that the depletion regions meet under the catnode and establish a potential barrier. The potential well thus established is a barrier to electrons which prevents them from being injected at the cathode. Without a source of electrons, holes cannot be injected at the anode, and thus the device is maintained in a forward blocking state. B.J. Baliga, "Grid Depth Dependence Of The Characteristics of Vertical Channel Field Controlled Thyristors", Solid-State Electronics, Vol. 22, pp. 237-239 (1979), reports that increasing tne depth of the grid in such a device results in exponential increase in the differential blocking gain, and a significant decrease in turn-off time.

The unijunction transistor is a three-terminal device having a high-impedance off state and low-impedance on state. It has one emitter junction and two base ohmic contacts which all contact a body of semiconductor material which may be of the n-type. The emitter junction, which normally is reverse-biased, injects holes into the semiconductor body when it is forward-biased, thereby turning on the device by increasing the conductivity of the bar between the emitter junction and the more negative base.

The aforementioned thryristor devices, like the unijunction transistor, utilize current whicn in at lease a portion of the active region of the device, is composed of carriers of both polarities in quantities which are operationally significant. However, these thryistor devices only operate in a depletion mode, i.e., the electrical field

-8-

applied by the grid or gate serves only to reduce the over-all current flow from what it would have been in the absence of this applied field.

The aforementioned transistor devices have proved useful for many purposes, as is witnessed by the tremendous growth of the semiconductor industry in the recent past. However, there are disadvantages associated with most of the aforementioned transistor technologies. For example, the vast majority of transistors made today are formed of crystalline semiconductor materials, which generally can only be formed on crystalline substrates. At present crystalline substrates are limited in size to little more than six inches in diameter, which greatly restricts the use of crystalline transistors for very large area integrated circuits, such as is desirable for the fabrication of large area flat panel displays or ultra large scale integration electronic circuitry. Most of the transistors described above are crystalline devices as shown and discussed in the literature of solid state electronics. Thus, they suffer from these and other limitations. For example, the permeable base transistor described above not only is limited to construction on a crystalline substrate, but requires the use of the relatively complex, slow, and high temperature procedure of epitaxial growth in order to form its crystalline conducting channel between and above the metal fingers formed in its gate electrode.

Efforts are being made to fabricate transistors of non-crystalline semiconductor materials, such as amorphous silicon alloys. By the term "amorphous" is meant an alloy or

Case 885

material which has long-range disorder, although it may have
shorter intermediate order or even contain at times some
crystalline inclusions, which are sometimes referred to as
microcrystalline material. Such transistors are normally
formed of thin films of deposited conductive, insulating, and
amorphous semiconductor materials, and therefore are often
called thin-film transistors, or TFTs. Such TFTs are normally
transistors in which the gate is insulated from the conductive
channel between its two current path electrodes, and in which a
voltage must be applied to the gate in order to shift the Fermi
level in the conduction channel sufficiently so as to make a
normally nonconducting channel conducting. The assignee of the
present invention has contributed to the development of the art
of TFTs, as is indicated by the following partial list of its
U.S. patent applications: Serial No. 529,299, entitled "Thin
Film Transistor", filed on September 6, 1983 by Flasck, et al;
Serial No. 549,996, entitled "High Performance, Small Area Thin
Film Transistor", filed November 8, 1983 by H. Fritzsche, et
al.; Serial No. 550,234, entitled "High Performance Thin Film
Transistor Having Improved Carrier Injection", filed November
8, 1983 by Yaniv, et al.; Serial No. 549,979, entitled "Thin
Film Transistor Having Annealed Gate Oxide and Method Of Making
Same" filed November 8, 1983 by Hansell, et al.; Serial No.
590,941, entitled "Short Channel Thin Film Field Effect
Transistor" filed December 5, 1983 by Yang, et al.; Serial No.
590,836, entitled "Improved Reduced Capacitance Narrow Channel
Thin Film Transistor And Method Of Making The Same", filed
March 19, 1984 by Yaniv, et al.; and Serial No. 625,142,
entitled "Proximity Doped Semiconductor Devices", filed June
27, 1984, by Ovshinsky, et al. Of these U.S. patent

Case 885

applications, Serial Nos. 529,299, 549,996, 550,234, 549,979 and 625,142 are of interest because, among other things, they disclose vertical transistors having amorphous silicon alloy conduction channels, and Serial Nos. 590,941 and 590,836 are of interest because, among other things, they disclose planar TFTs made with amorphous silicon alloys. The above-referenced U.S. patent applications are hereby incorporated herein by reference.

Although the TFTs previously disclosed by the assignee of the present invention and others have a tremendous advantage of not requiring crystalline substrates or the use of epitaxial growth, there is an on-going desire to improve the speed, current carrying capacity, over-all performance, reliability and ease of fabrication of such devices, which provided one of the major reasons for creating the present invention.

## SUMMARY OF THE INVENTION

Conventional field effect transistors typically operate as noted above, by modulating the concentration of unipolar charge carriers in a channel, either by changing the volume concentration of carriers by band-bending, as in a MOSFET, or by pinching off the normal cross-section of the channel, as in a JFET or in a MESFET. We have established both theoretically, by performing computer simulation, and experimentally, by fabricating a solid-state device, that one can also modulate the density and/or cross-section of ambipolar current, which may be thought of as a plasma of electrons and holes, using an electric field that extends along the current path and typically projects perpendicularly into the current path.

0212328

Case 885

Our new electronic devices are preferably constructed as field effect transistors which have ambipolar current in the body of the semiconductor material between their current-carrying electrodes. Accordingly, our new FET may be called a double injection FET or DIFET. The ambipolar current in the semiconductor body of our DIFET is subject to control by an electric field created when a voltage is applied to the control electrode of the device, which is preferably an insulated gate or grid. Our DIFETs, depending upon geometry and structural configuration, can operate in an enhancement mode, in a depletion mode, or in both modes. This summary shall briefly describe some of the many possible configurations and operating modes of our new devices.

The present invention provides a solid-state electronic device having first and second electrodes, a body of semiconductor material formed in a current path between the first and second electrodes, and means for ambipolar carrier injection into the current path in response to an externally applied voltage. In several preferred embodiments, this electronic device also includes an electric field means for exerting an electric field substantially along the length of the current path to increase ambipolar current flow in the current path. The exerted electric field is distinct from the electric field induced by the applied voltage, and typically is substantially transverse to the nominal direction of the ambipolar current flow in the current path. The exerted electric field may be produced by at least one control electrode adapted to receive an applied control voltage, which is preferably independent of the voltage applied to the first

-12-

0212328

and second electrodes. The control electrode should extend substantially along the length of and be in close proximity to the current path between the first and second electrodes.

In several preferred embodiments, the electronic device of the present invention is a solid-state light emitting device having first and second electrodes, a body of semiconductor material formed in a current path between the first and second electrodes, and means for ambipolar current injection into the current path in response to an externally applied voltage. Such light emitting embodiments also include electric field means for exerting an electric field along at least a portion of the current path to produce radiative recombination of holes and electrons in the current path resulting in a useful level of optical emissions. The exerted electric field in these embodiments is also distinct from the electric field induced by the voltage applied between the first and second electrodes.

The electronic devices of the present invention may each include barrier means for minimizing leakage current between the control electrode and the current path. Barrier means may include an insulating material disposed between the control electrode and the current path, a Schottky barrier, or a reverse biased semiconductor-to-semiconductor junction.

When the electric field is exerted by the electric field means while the voltage between the first and second electrode is applied, the effective conductivity of the current path is changed. Specifically, the electric field means causes increased density of carriers of both polarities in at least a portion of the current path. The increased density of carriers of both polarities causes increased conduction between the first and second electrodes. The increased densities of carriers of both polarities may, depending on device configuration, constitute an enhanced conduction channel between the first and second electrodes. If the semiconductor body has a substantial number of defect states, the increased density of carriers may fill a substantial portion of the defect states in the conduction channel. In many of the DIFET embodiments, the current in the current path will substantially equal the rate of recombination of charge carriers in the current path. During operation of the DIFET, the space charge due to the carriers of the first polarity will typically neutralize at least a portion of the space charge due to carriers of a second and opposite polarity. In the enhancement mode DIFETs, a conduction channel of at least the carriers of one polarity is typically created along the current path in the semiconductor body where the exerted electric field is relatively strong. The depth of this conduction channel may increase due to neutralization, and typically may at least double. Moreover, the ambipolar current may increase due to the neutralization as well, and will typically at least double due to the neutralization.

Several embodiments of the DIFETs of the present invention include means for optimizing the space charge neutralization. Such optimizing means may include matching effective areas of the first and second electrodes, or electrode means for extracting charge carriers of one polarity

Case 835

from the current path. This latter optimizing means may also include either a preselected amount of overlap between the second electrode and that portion of the current path extending between the first electrode and the electrode means just mentioned or may include biasing means for controlling the rate of injection of charge carriers of the first polarity into the current path.

Our light emitting devices may also include means for producing optimal space neutralization in at least a portion of the current path. To produce a laser, such devices may also include optical cavity means, including an optical cavity, for causing the optical emissions to lase within the cavity, thereby producing coherent light emission from the device. The light emitting devices may also include means for changing the frequency of optical emissions by varying the exerted electric field, or means for varying the amplitude of the optical emissions by varying the exerted electric field. Moreover, these light emitting devices may include means for producing optimal space neutralization in the current path to increase the rate of radiative recombinations.

The ambipolar carrier injection means mentioned above is typically comprised of the first and second electrodes. The first and second electrodes may each include a region of heavily doped semiconductor material for efficient injection of one polarity of charge carriers into the aforementioned body of semiconductor material. The electrodes may also each include a metal region which makes ohmic contact with its respective heavily doped semiconductor region.

Case 885

The present invention also provides a family of field effect transistor devices in various novel configurations, many of which are preferably vertically arranged. Most of these novel devices include two current path electrodes, a body of semiconductor material between the two or more current path electrodes to form a unipolar or ambipolar current path between them, and one or more control electrodes located adjacent to the current path to exert a controllably variable electric field over it so as to create a controllably variable enhancement or impediment to the flow of the unipolar or ambipolar current through the transistor. The various embodiments of these transistors described below can be grouped into two categories: single injection field effect transistors which have unipolar current, and the preferred double injection field effect transistors or DIFETs which have ambipolar current and significantly enhanced performance, as will be explained below.

In the preferred ambipolar embodiments of the present invention, the transistor may be constructed by using crystalline, polycrystalline or amorphous semiconductors and may be a horizontal structure, a vertical structure, a V-shaped structure, or any other suitable structure. For example, one possible configuration and structure is a monolithic or crystalline configuration having a horizontal structure. Typically, such structures, when made using formed integrated circuit techniques, have all electrodes of the transistors formed or brought to the top surface.

Case 885

Another possible configuration and structure of the ambipolar transistor is an amorphous configuration having a vertical structure comprising a substrate, a bottom electrode formed on the substrate, a body of substantially amorphous semiconductor material deposited over the bottom electrode, and a top electrode formed over the body of semiconductor material. The control electrode defines at least one layer between the top and bottom electrodes, and has at least one opening through which the semiconductor material extends to form the current path between the top and bottom electrodes. The control electrode is positioned and its opening is sized to exert a controllably variable electric field over a portion of the current path, so as to create a controllably variable enhancement or impediment to the flow of current between the top and bottom electrodes. As will become more apparent from the following description, the control electrode in the ambipolar embodiments may be effectively utilized to modulate the rate of injection of both positive and negative charge carriers into the semiconductor material, and the control electrode in the unipolar embodiments may be effectively utilized to modulate the rate of injection of either negative or positive charge carriers into the semiconductor material. The various vertical embodiments may each be called a vertical modulated injection transistor or VMIT.

The ambipolar embodiments of the transistor of the present invention, may operate in either an enhancement mode, a depletion mode, or both modes, depending upon the particular structure involved. In each mode, the presence or absence of a particular gate voltage or range of gate voltages to the

Case 885

control electrode basically determines whether or not the transistor's current channel is rendered substantially conductive, as will be explained.

In some embodiments of the present invention, the control electrode is designed to create a field which tends to turn off the transistor in the absence of an applied gate voltage, and the application of a gate voltage turns the transistor on, that is, enhances the flow of current between tne top and bottom electrodes. In other embodiments the transistor is on in the absence of an applied gate voltage and the application of a gate voltage creates an electric field over a portion of the current path which tends to turn the transistor off, that is, impedes the current flowing between the top and bottom electrodes. In other words, these embodiments can be used to implement normally on or normally off transistors. The phrase "controllably variable impediment" as used herein with respect to those embodiments where the gate is a physical impediment which constrains the main current of the transistor to flow through its opening or openings, encompasses both of these variations in operation, since the amount of current may, depending upon the specific embodiment, be enhanced or impeded by the application of a selected voltage to the gate, as will be further explained below.

According to certain embodiments of the invention the transistor comprises a body of substantially intrinsic semiconductor material and the two current path electrodes include an electron injecting electrode, preferably made with an $n^+$ semiconductor material which tends to inject many more

electrons than holes into the intrinsic material, and a hole injecting electrode, preferably made with a $p^+$ material which tends to inject many more holes than electrons. In such embodiments, the semiconductor material connected between the two injecting electrodes forms an ambipolar current path in which both electrons and holes contribute to current flow. Such ambipolar transistors tend to have much larger "on" currents than similar devices which are unipolar. In such ambipolar, or double injection, embodiments, the control electrode is located adjacent to at least part of, and preferably substantially all of, the ambipolar current path so as to exert a controllably variable electric field over a portion of it, and thus create a controllably variable impediment or enhancement to the flow of both electrons and holes between the two injecting electrodes. The preferred ambipolar embodiment which is to be used mostly or exclusively to create a controllably variable impediment or enhancement to ambipolar current is formed as a amorphous transistor having a vertical structure of the type described above. The preferred configuration and structure of an embodiment which is to be used mostly or exclusively to create a controllably variable enhancement to ambipolar current is an amorphous crystalline, polycrystalline or microcrystalline horizontally arranged insulated gate field effect transistor.

Not all embodiments of the invention are of the ambipolar, or double injection, type just described. In the single injection embodiments, which are shown herein only as vertical structures, both the top and bottom electrodes have the property of injecting substantially only charge carriers of a single polarity into the body of semiconductor material of the current path. Such embodiments of the invention can also be referred to as unipolar embodiments. In such embodiments it is preferred that both current path electrodes have a layer of $n^+$ (or of $p^+$) semiconductor material in contact with a current path formed of substantially intrinsic semiconductor material.

It is preferred in both the single injection and double injection embodiments of the invention that the semiconductor material of the current path be formed of a intrinsic or doped semiconductor material, such as an amorphous alloy of silicon including hydrogen or fluorine, or preferably both hydrogen and fluorine, as density of states reducing elements.

In some embodiments of the invention the control electrode is made of material which forms a rectifying junction with the semiconductor material of the current path. In some of these embodiments the current path extends through the one or more openings in the control electrode opening or openings which may be made so sufficiently narrow that the field generated by the rectifying junction of the control electrode extends across those openings without the application of an external voltage to the control electrode. Such transistors tend to be turned off in the absence of the application of a voltage to their control electrode. In other embodiments one or more layers of electrically insulating material are used to insulate all, or a major portion, of the control electrode from the current path.

Case 835

In certain vertical embodiments of the invention the size of the opening(s) in the control electrode and the spacing between the control electrode and the two current path electrodes, respectively, is selected so that the transistor can be changed from a state in which it is substantially on to a state which is substantially off, and vice versa, by the application of voltages to the control electrode which lie within a range defined by the voltage applied to the top and bottom electrodes. In certain horizontal embodiments of the invention the same results may be achieved by transversely positioning the gate electrode adjacent the current channel at a selected place along the length of the current channel between current path electrodes.

In some vertical embodiments of the invention the control electrode includes two layers, one above the other, separated from each other by a layer of semiconductor material, with each of the control electrode layers including at least one opening through which the current path extends. In such an embodiment the openings in the two layers of the control electrode may be staggered relative to each other to increase the effective length of the passage through the openings. Also, if desired, the portion of the passage between the two layers may be made substantially narrower than the openings within either of the two layers. In some horizontal embodiments of the invention, the control electrode may include two horizontal strips or regions spaced apart from one another adjacent to the conduction channel and traverse to the length thereof to achieve substantially the same results as having two layers in the control electrode as just described.

-21-

In other alternate embodiments of the invention, the transistor includes a plurality of control electrodes, which are electrically separate from one another and which each have a separate electrical input.  In such an embodiment each of the control electrodes is located to exert controllably variable electric field over a portion of the current path, enabling the transistor to function as a multiinput logic gate.

These and other aspects, features and advantages of the present invention will become apparent from the subsequent description and the appended claims taken in conjunction with the accompanying Figures.

## BRIEF DESCRIPTION OF THE DRAWING

Figure 1 is a schematic representation of a partial cross-section of a transistor according to a first vertical embodiment of the present invention, which transistor includes a gate layer.

Figure 2 is a schematic plan view of one possible gate layer for Figure 1.

Figure 3 is a schematic view of a partial cross-section of the Figure 1 transistor, illustrating one possible technique for fabricating the gate layer of the transistor.

Figure 4A is a schematic view of a partial cross-section of a unipolar embodiment of the transistor 1; and Figure 4B is a graph illustrating the electric fields produced by the gate layer as a function of horizontal position along the opening in the gate layer.

Figures 5 through 9 are partial cross-sectional schematic views of the gate layer of the Figure 4A transistor, with a graph of electrical field intensity similar to that shown in Figure 4B superimposed in the opening of the gate wherein:

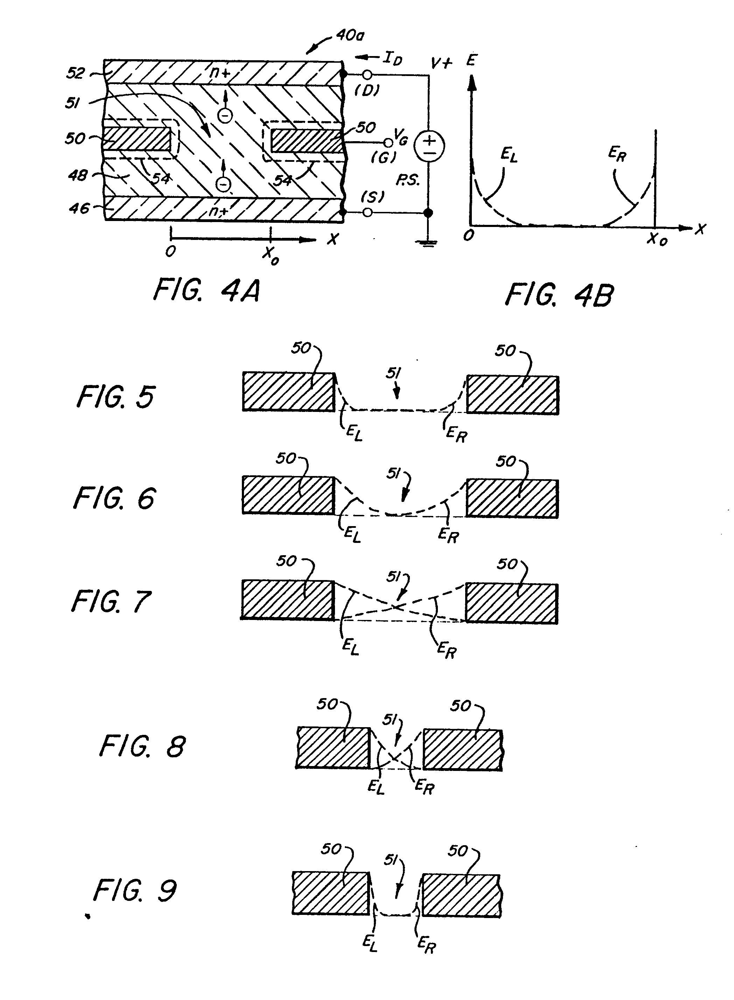

Figure 5 shows the electric field intensity in the absence of an applied voltage to the gate;

Figure 6 shows the electric field intensity produced by a small voltage applied to the gate;

Figure 7 shows the electric field intensity produced by larger voltage applied to the gate;

Figure 8 illustrates that the electric fields will extend entirely across the opening even in the absence of the applied voltage when the opening is made sufficiently narrow; and

Figure 9 illustrates that the electric fields of Figure 8 may be reduced by a voltage applied to the gate.

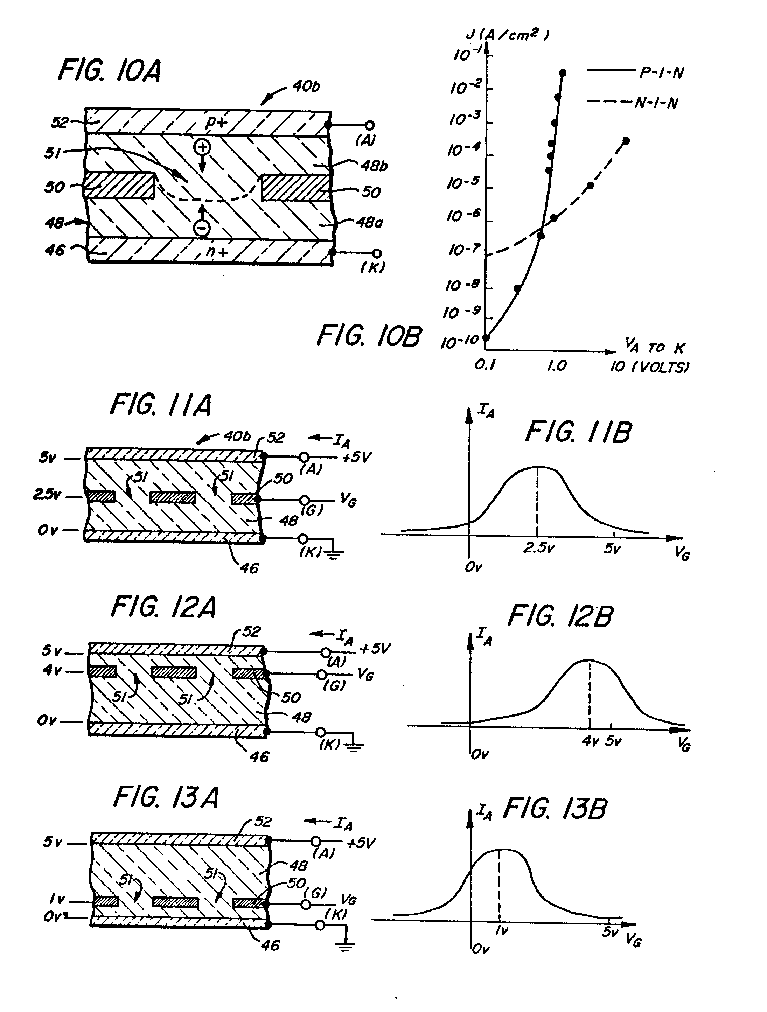

Figure 10A is a schematic view of a partial cross-section of another embodiment of the present invention having top and bottom ohmic layers formed of differing semiconductor materials, thus allowing ambipolar current to flow; and Figure 10B is a graph of two current·voltage curves comparing unipolar and ambipolar conduction.

Case 835

Figure 11A is a schematic diagram of the Figure 10A embodiment showing how the voltage naturally tends to drop between the top and bottom electrode in the intrinsic layer; and Figure 11B is a graph of the channel current versus gate voltage curve for the device of Figure 11A.

Figure 12A is a schematic view showing a cross-section of the Figure 10 embodiment of the transistor of the present invention with the gate substantially closer to the top electrode than the bottom electrode; and Figure 12B is a graph of the channel current versus gate voltage curve for the Figure 12A device.

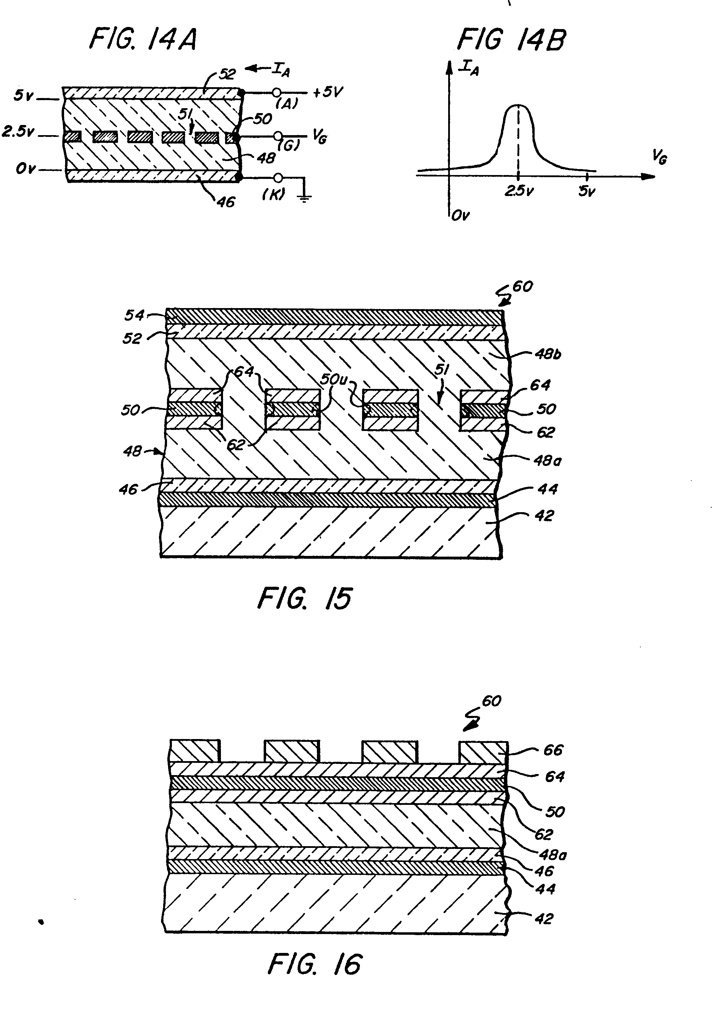

Figure 13A is a schematic view of a cross-section of the Figure 10 embodiment of a transistor of the present invention with the gate much closer to the bottom electrode than the top electrode; and Figure 13B is a graph of the channel current versus gate voltage curve for the Figure 13A transistor.

Figure 14A is a schematic view of a partial cross-section of the ambipolar device of Figure 10 wherein the openings in the gate are spaced closer together; and Figure 14B is a graph of the current-gate voltage curve of the Figure 14A device.

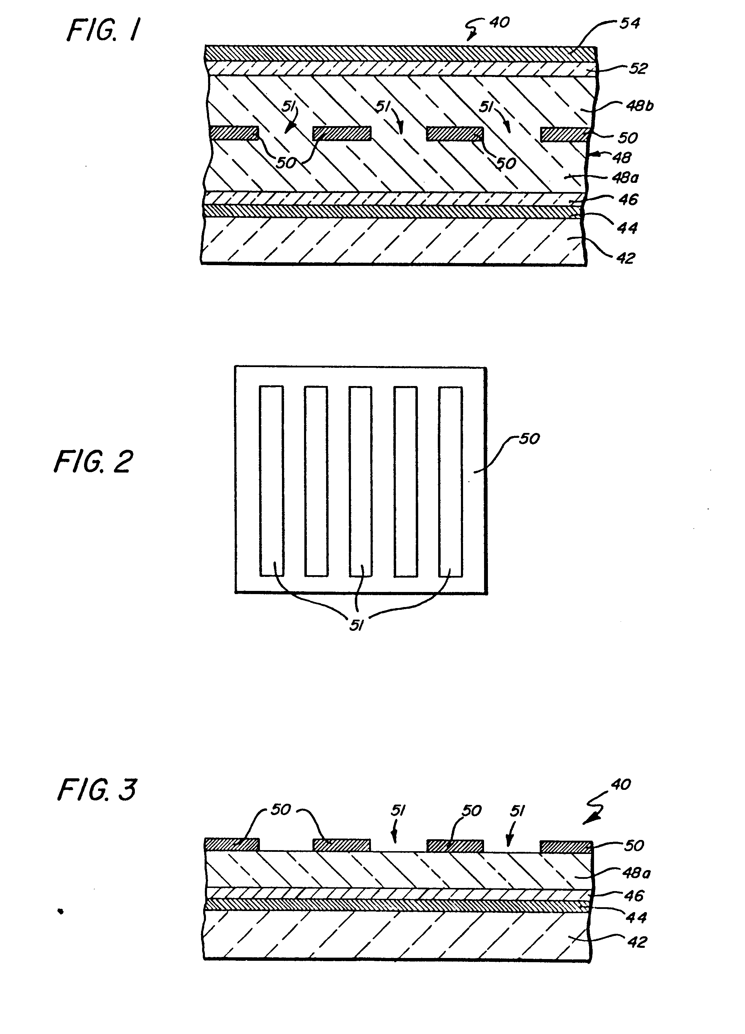

Figure 15 shows a variation of the Figure 1 device having a layer of insulating material above and below the gate layer.

Case 885                                            -25-

Figure 16 shows the transistor of Figure 15 in a partially constructed state and ready for an etching step.

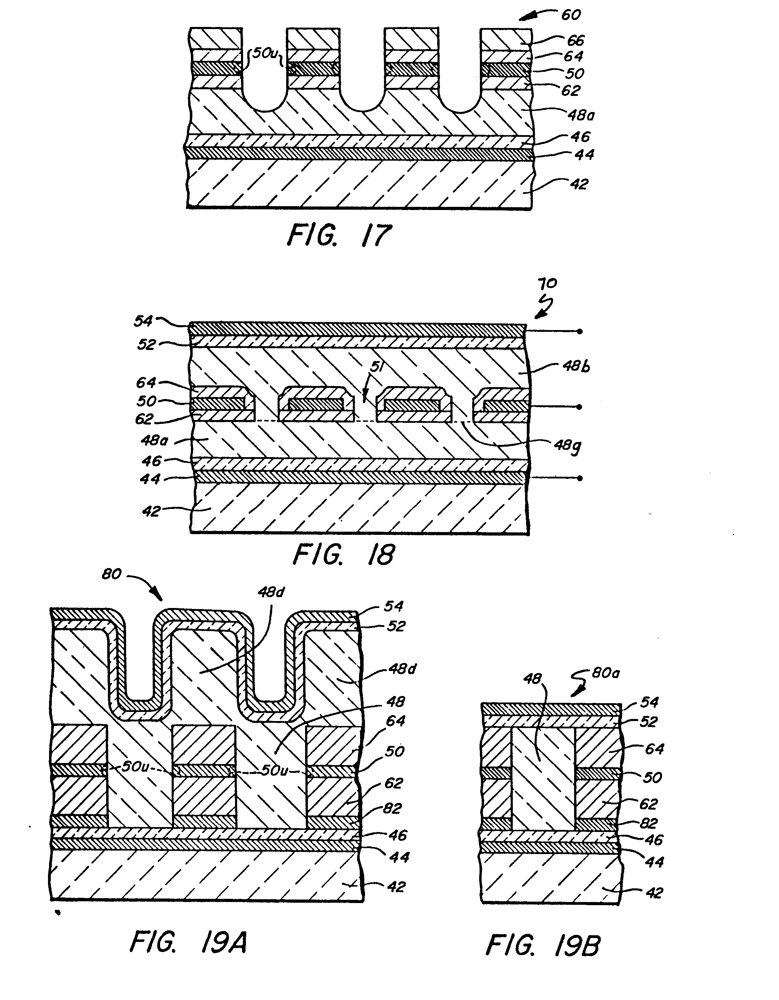

Figure 17 shows the partial transistor structure of Figure 16 after several layers have been etched.

Figure 18 is another version of the Figure 1 device having an insulating layer that totally envelopes the gate layer in the vicinity of its openings.

Figure 19A shows an alternate embodiment of the transistor of the present invention which has a high operating speed; and Figure 19B shows a variant of the Figure 19A embodiment.

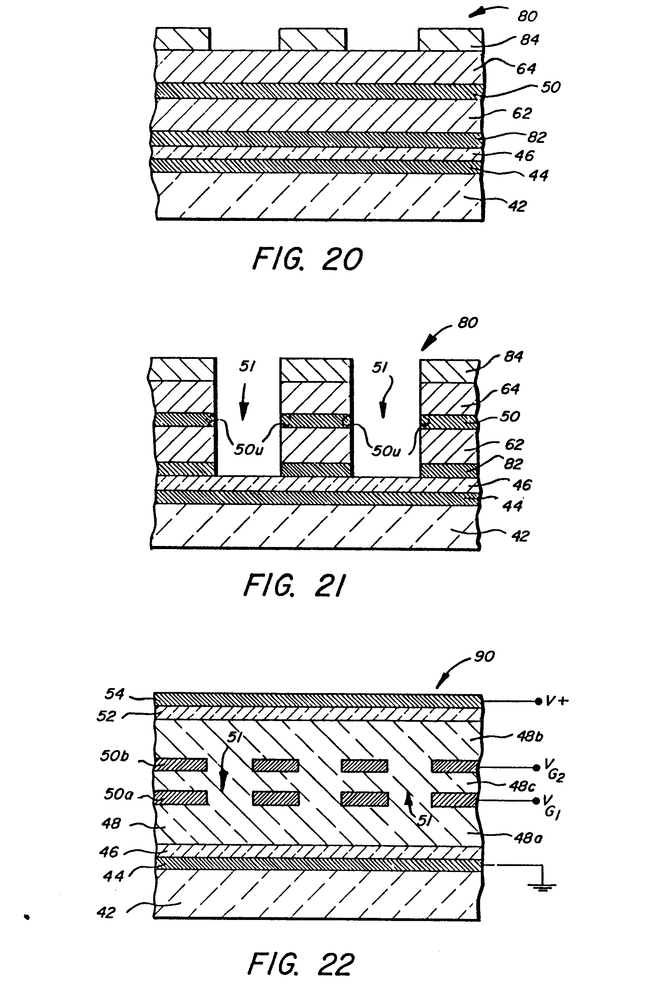

Figure 20 shows a schematic view in cross-section of a partially constructed transistor of Figure 19 before etching.

Figure 21 shows the structure of Figure 20 after etching.

Figure 22 schematically shows a partial cross-section of an alternate embodiment of the transistor of the present invention having two gate layers.

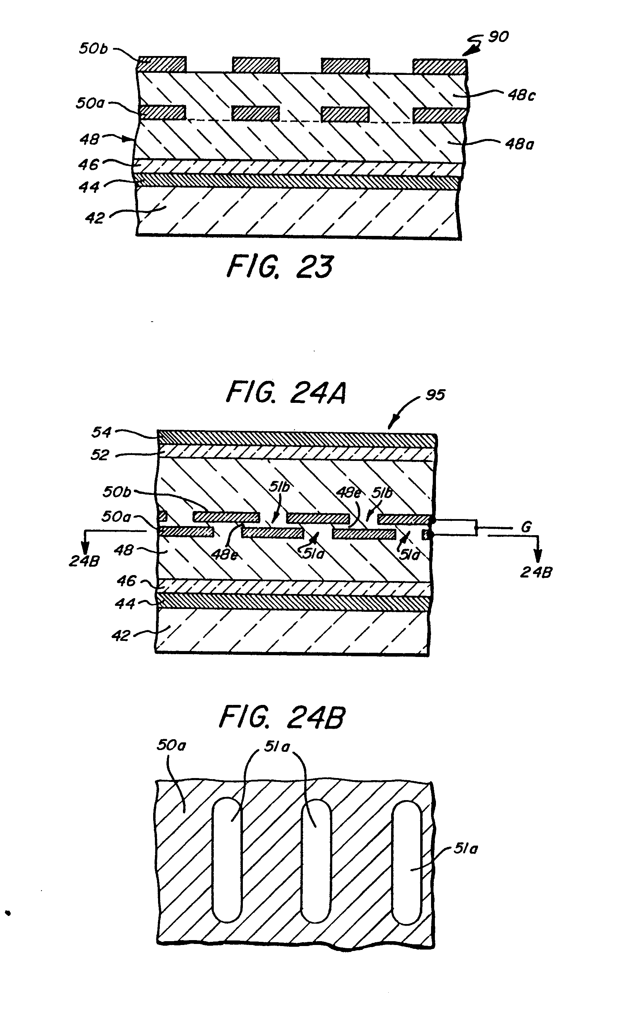

Figure 23 schematically illustrates how the device of Figure 22 may be formed.

Case 885

Figure 24A schematically shows a partial cross-section of an alternate embodiment of the transistor of the present invention which has staggered gate layers; and Figure 24B is a partial cross-section of the gate layer of the Figure 24A device taken along lines 24B-24B.

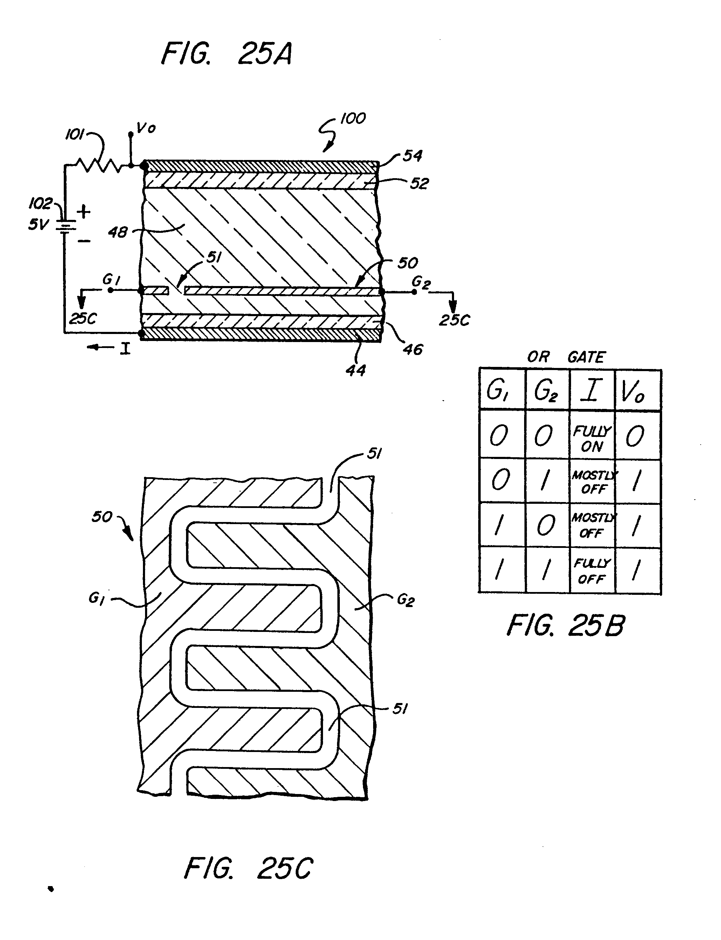

Figure 25A schematically shows a partial cross-section of an embodiment of the invention attached to an external circuit so as to form an OR gate; Figure 25B is a truth table for the Figure 25A logic gate; and Figure 25C is a partial cross-section of the gate layer of the Figure 25A device taken along lines 25C-25C.

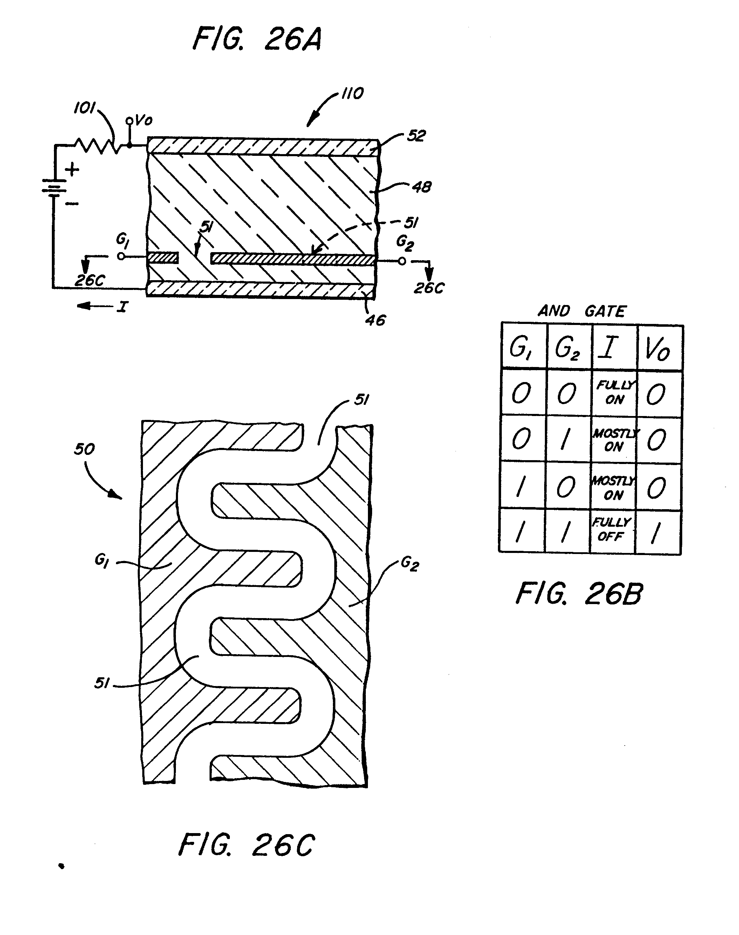

Figure 26A schematically shows a partial cross-section of an embodiment of the invention attached to an external circuit so as to form an AND gate; Figure 26B is a truth table for the Figure 26A logic gate; and Figure 26C is a partial cross-section of the gate layer of the Figure 26A device taken along lines 26C-26C.

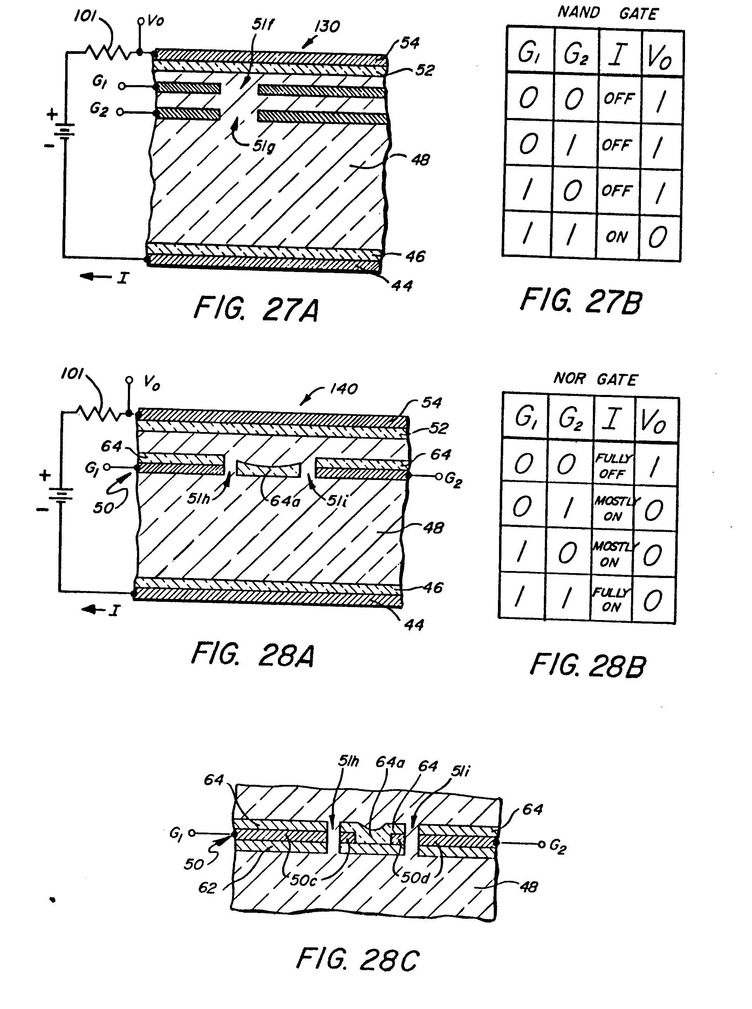

Figure 27A schematically shows a partial cross-section of an embodiment of the invention having a plurality of electrically distinct gate layers connected to an external circuit so as to form a NAND gate; and Figure 27B is its truth table.

Figure 28A schematically shows a partial cross-section of an embodiment of the invention having a gate layer partially covered by an insulating layer connected to an external circuit so as to form a NOR gate; Figure 28B is its truth table; and Figure 28C is an alternate embodiment of its gate layer.

-26-

Case 885

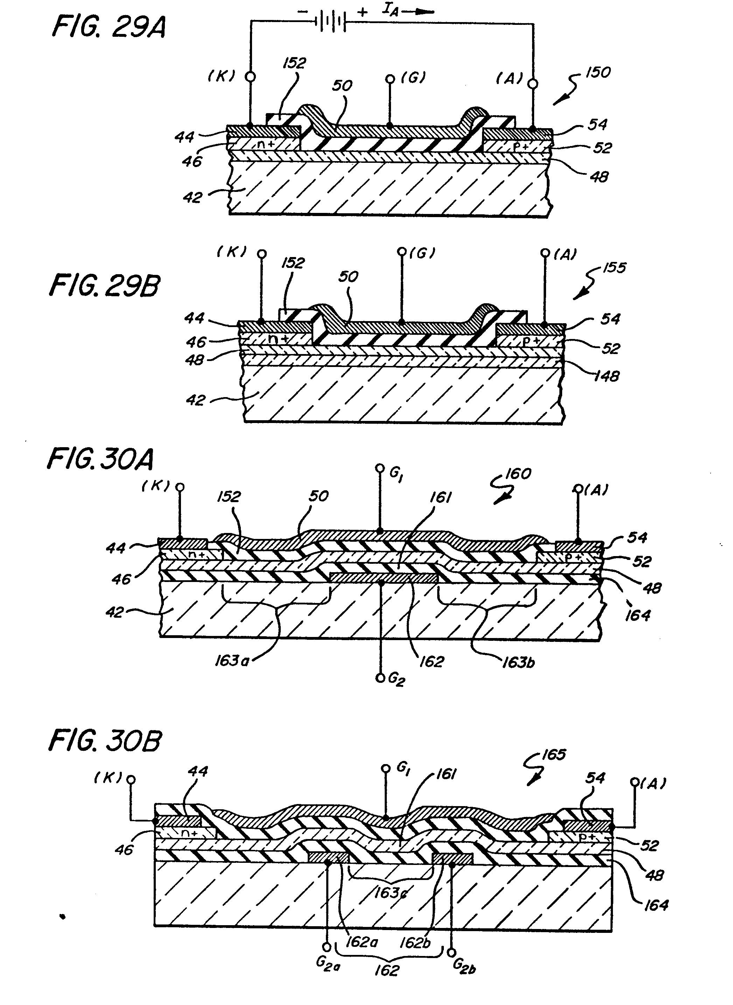

Figure 29A shows an alternate embodiment of the transistor of the present invention in which it is formed as a horizontal DIFET shown in an amorphous embodiment; and Figure 29B is another DIFET embodiment having an extra layer of semiconductor material beneath the channel layer to improve turn-off time.

Figure 30A shows another embodiment of the horizontal DIFET of the present invention which is similar to that shown in Figure 29A except that it has a second gate for more complete channel shut off; and Figure 30B is a version of the Figure 30A having an alternative arrangement for the second gate.

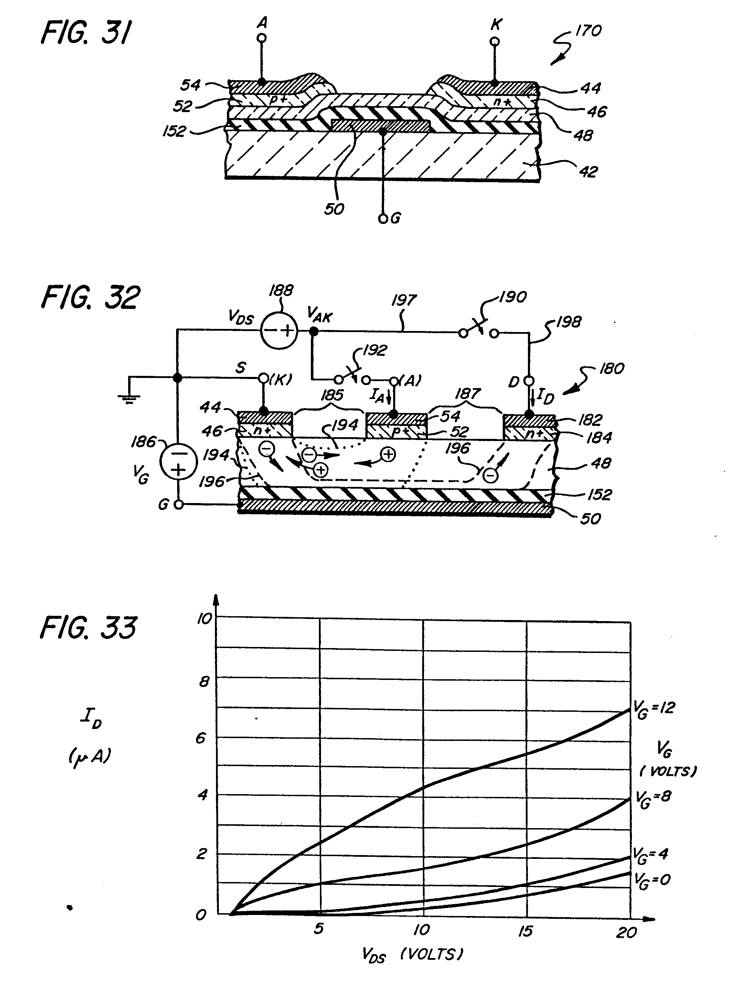

Figure 31 schematically shows a partial cross section of a horizontal ambipolar embodiment of the invention having a gate layer adjacent the substrate.

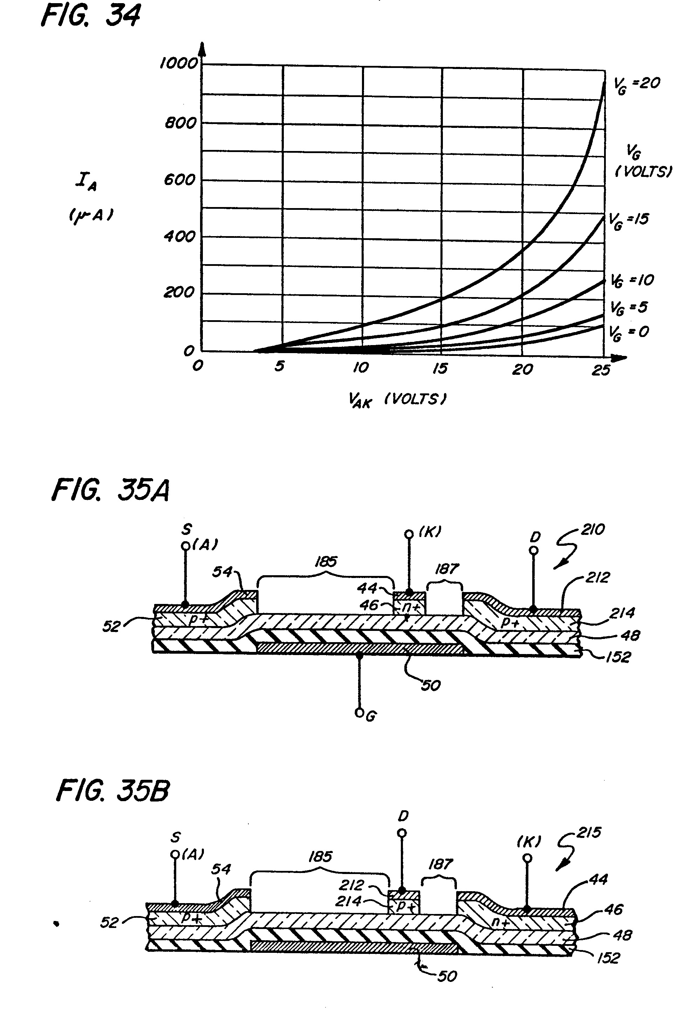

Figure 32 shows a four terminal embodiment of the transistor structure of the present invention used to produce the device curves shown in Figures 33 and 34.

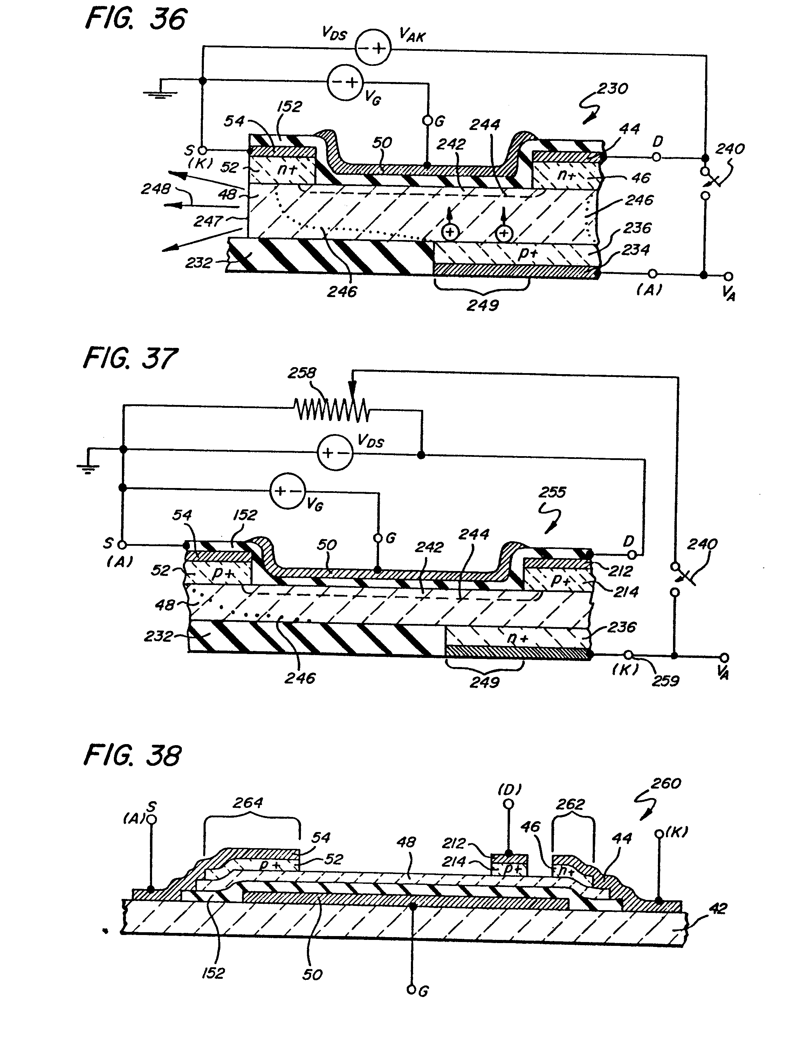

Figure 33 is a plot showing the common-source drain characteristics of the n-i-n transistor structure of Figure 36 with the anode electrode open circuited.

Figure 34 is a plot of the common cathode anode characteristics of the n-i-p transistor structure of Figure 36 with the drain electrode open circuited.

Case 885

Figure 35 schematically shows two more embodiments of the present invention similar to that of Figure 32, wherein: in Figure 35A, the conductivity type of the current-carrying electrodes is reversed and the electrode spacing is altered from that of Figure 32; and in Figure 35B, the location of cathode and drain electrodes is reversed from that of Figures 32 and 35A.

Figure 36 shows another ambipolar embodiment of the transistor of the present invention having four terminals, illustrating one configuration for maximizing current by carrier balancing.

Figure 37 is an alternate embodiment of the four terminal ambipolar transistor device of the present invention illustrating another current balancing technique

Figure 38 is an alternate embodiment of the four terminal transistor device featuring current-balancing and electroluminescence.

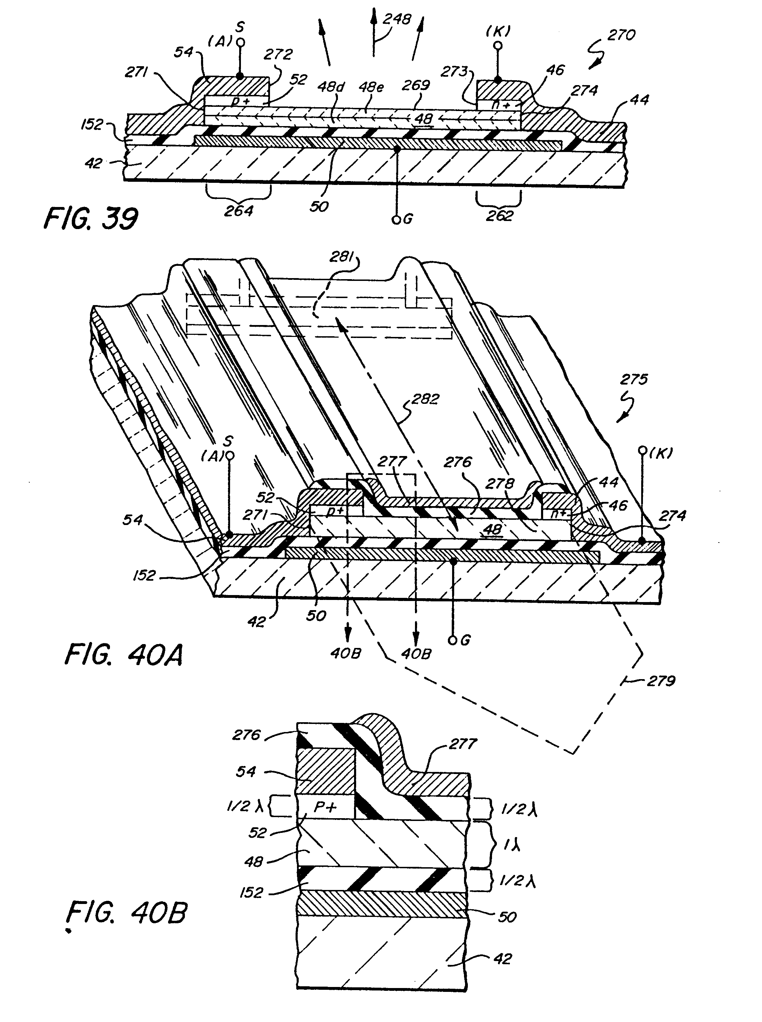

Figure 39 is an electroluminescent ambipolar transistor of the present invention having a plurality of step-graded junctions in the conduction region for producing a variable frequency optical output.

Figure 40A is a perspective view of a light emitting ambipolar transistor of the present invention having a tuned optical cavity for coherent light emission; and Figure 40B is a partial cross-section of the Figure 40A device taken along lines 40B - 40B showing the thickness of various layers in terms of wavelength.

Case 885

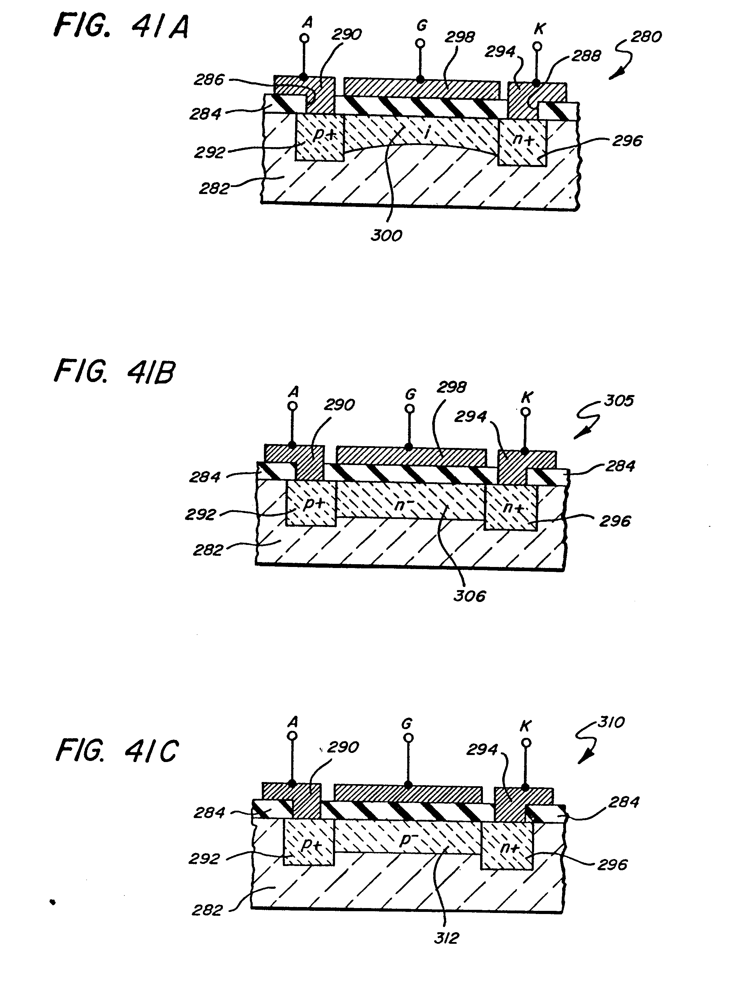

Figure 41A schematically shows a crystalline embodiment of the ambipolar transistor of the present invention having a conduction channel region of intrinsic semiconductor material; Figure 41B shows an alternative crystalline embodiment having a nu-type conduction channel region; and Figure 41C shows another crystalline embodiment having a pi-type conduction channel region.

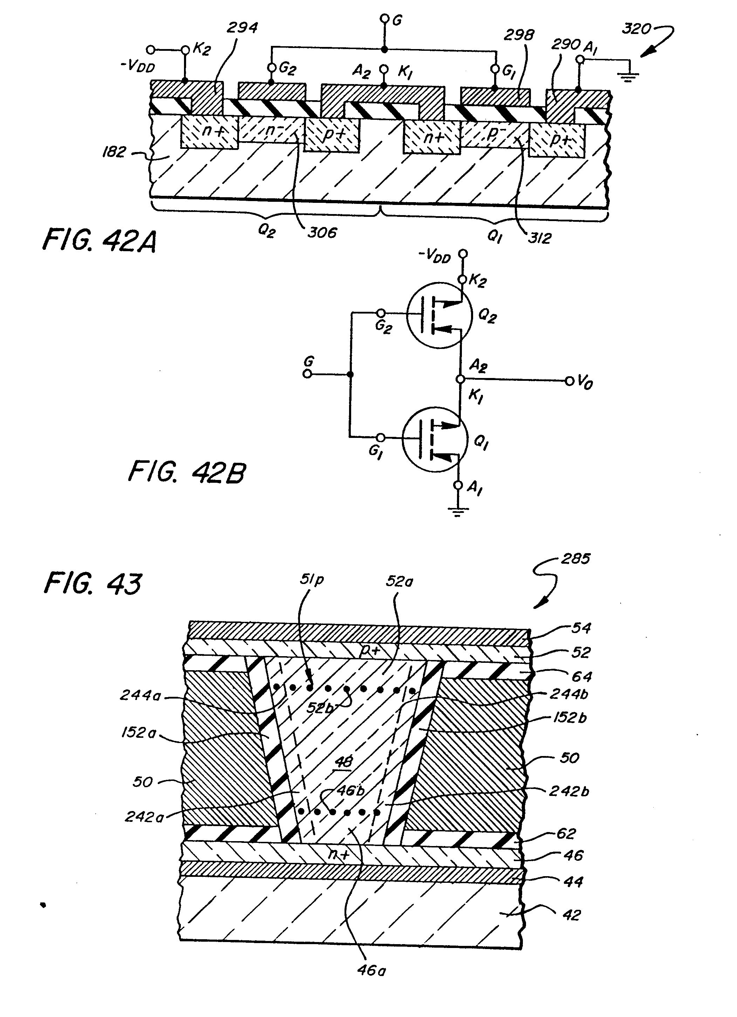

Figure 42A schematically shows a CMOS-like application of two ambipolar transistors of the present invention connected together to form an inverter; and Figure 42B shows a circuit symbol for the two transistor circuit of Figure 42A.

Figure 43 schematically shows a partial cross-section of a vertical DIFET of the present invention shown in an amorphous embodiment.

## DETAILED DESCRIPTION OF THE PREFERRED EMBODIMENTS

Various aspects of the present invention are described below in the following general sequence: vertically formed unipolar transistors and vertically formed ambipolar transistors (i.e., vertical DIFETs) which are a subset of the DIFET, which for convenience may both be called VMITs; preferred methods of making various VMITs; VMIT structures for implementing various logic functions; horizontal ambipolar transistor structures constructed with amorphous semiconductor materials; horizontal ambipolar transistor structures constructed with crystalline semiconductors; and four terminal ambipolar transistors including electroluminescent versions.

Case 835

In reading the following detailed description of the preferred
embodiments, however, it is to be understood that the practice
of the present invention is not limited to the exact transistor
devices and methods described herein.

Referring now to Figure 1, the transistor 40,
according the the present invention, is shown.  Transistor 40
is a vertical thin film transistor formed of materials
deposited on a substrate 42, which substrate can be formed of a
wide variety of materials including glass.  Deposited upon the
substrate 42 is a conductive layer of metal 44 which is used to
form one of the two current path electrodes of the transistor
40.  The metal layer 44 may be molybdenum, chrome, or aluminum
for example.  Over the metal layer 44, a layer 46 of doped
amorphous silicon alloy, either $n^+$-type or $p^+$-type, is
deposited.  On top of the layer 46, a layer 43 of substantially
intrinsic amorphous silicon alloy is deposited, which forms the
conduction channel or current path of the transistor 40.  (For
convenience, layer 43 is often hereinafter referred to as the
i-a-Si, the intrinsic layer, or simply as the i layer.)  A gate
layer 50, which may take the form of a grid, is located in the
i layer 48.  In the embodiment of the invention shown in Figure
1, the gate layer is made of a material which forms a
rectifying junction with the semiconductor material of the
layer 48.  The material of the gate 50 can comprise a metal,
such as platinum, which forms a Schottky barrier with the
intrinsic material of the layer 48, or it can be formed of a
doped semiconductor material which forms a rectifying
semiconductor junction with that material.  The gate 50 is
formed as a layer containing openings 51 through which the semiconductor material of layer 48 extends. Above the layer 48 a second layer 52 of doped amorphous silicon alloy is placed. As is described below, this layer may be made of either $n^+$ or $p^+$ material. Finally, over the layer 52, a layer 54 of conducting material, such as molybdenum, chromium or aluminum metal, is deposited to form the second current path electrode of the transistor.

The thicknesses of the various layers of transistor 40 can be tailored to obtain desired electrical properties. The metal electrode layers 44 and 54 should be thick enough to provide efficient conduction to their associated ohmic contact layers 46 and 52. For most uses a thickness of 500 to 3,000 angstroms should be sufficient. The ohmic contact layers 46 and 52 need be no thicker than 500 angstroms. The thickness of the intrinsic layer 48 in general should be determined by a trade-off between the increased current injection which results from the layer 48 being thin, versus the increased ability to withstand voltages caused by increasing the thickness of the layer. Since intrinsic amorphous silicon alloys can withstand approximately fifty volts per micron without semiconductor breakdown, a device in which the layer 48 is one micron thick will provide satisfactory operation for most low voltage applications. The thickness of the gate layer 50 may be varied in accordance with the desired operating characteristics of the transistor 40. Preferably the gate should be thick enough that its conductivity is sufficient to enable its various parts to maintain a relatively uniform voltage (i.e., to ensure there is no appreciable voltage drop within the gate layer itself). If the gate is made of a conductive metal, a thickness of 200 to

1000 angstroms should be sufficient. If the gate layer is made of a doped semiconductor material (without a metal core), the gate layer may have to be somewhat thicker. The desired geometry of the openings 51, especially the width of the openings, may also influence the thickness chosen for gate layer 50. The openings 51 may thus range in size from a few tenths of a micron to several microns.

Figure 2 shows a top view of one embodiment of gate 50 in which the openings 51 are formed as a plurality of parallel slots. It is to be understood, however, that the openings 51 in this embodiment and most of the other embodiments may be formed in other shapes, such as circular holes, and depending on the application, may vary in number from one to many. Also, in a number of applications the openings need not be of the exact same size or uniformly spaced apart one from another. They may even be positioned in a relatively random fashion in the gate layer.

Preferably the amorphous silicon alloy of layers 46, 48 and 52 contain hydrogen and fluorine as density of states reducing materials to improve their semiconductor properties. The doped semiconductor layers 46 and 52 greatly improve the ohmic nature of the contact between their associated current path electrodes and the intrinsic material of layer 48. When the material of layer 46 or 52 is doped to be $n^+$ type, it has the characteristic of being able to inject many more electrons, or negative charge carriers, into intrinsic semiconductor material than holes, or positive charge carriers. On the other hand, when the material of either of those contact layers is doped to be $p^+$-type, it has just the opposite property, and injects many more holes into intrinsic semiconductor material than electrons.

-32-

Case 885

Methods of depositing the materials used to form transistor 40 are well known in the art. Amorphous silicon alloys can be deposited in multiple layers over large area substrates to form a multitude of circuits in high volume continuous processing systems. These circuits may be designed to employ many structures of the type shown in Figure 1. Continuous processing systems for the fabrication of amorphous silicon alloy circuit elements are disclosed, for example, in U.S. Patent No. 4,400,409, issued August 23, 1933 and entitled "A Method of Making P-Doped Silicon Films and Devices Made Therefrom"; U.S. Patent Application Serial No. 244,386, filed March 46, 1984 for "Continuous Systems for Depositing Amorphous Semiconductor Material"; U.S. Patent No. 4,410,553, issued October 18, 1933 and entitled "Continuous Amorphous Solar Cell Production System"; U.S. Patent No. 4,438,723, issued March 27, 1984 and entitled "Multiple Chamber Deposition and Isolation System and Method"; and U.S. Patent Application Serial No. 359,825, filed March 19, 1982 for "Method and Apparatus for Continuously Producing Tandem Amorphous Photovoltaic Cells". As disclosed in these patents and patent applications, which are incorporated herein by reference, a substrate may be continuously advanced through a succession of deposition chambers, wherein each chamber is dedicated to the deposition of a specific material.

In making the layers 46, 43 and 52 shown in Figure 1, a single deposition chamber system can be used for batch processing, or preferably, a multiple chamber system can be used wherein a first chamber is used for depositing, for example, a $n^+$-type amorphous silicon alloy for layer 45, a

Case 885

second chamber is used for depositing an intrinsic amorphous silicon alloy for layer 48, and a third chamber is used for depositing an $n^+$ or $p^+$-type amorphous silicon alloy for layer 52. Since each deposited alloy, and especially the intrinsic alloy, must be of rather high purity, the deposition environment in the intrinsic deposition chamber is preferably isolated from undesirable doping constituents within the other chambers to prevent the diffusion of doping constituents into the intrinsic chamber. In the previously mentioned patents and applications, wherein the systems are primarily concerned with the production of photovoltaic cells, isolation between the chambers is accomplished by gas gates through which unidirectional gas flow is established and through which an inert gas may be "swept" about the web of substrate material.

Deposition of the amorphous silicon alloy materials is accomplished by glow discharge decomposition of process gases. Among these processes, radio frequency energy glow discharge processes have been found suitable for the continuous production of amorphous semiconductors. An improved process for making amorphous semiconductor alloys and devices is disclosed in U.S. Patent No. 4,517,223, issued May 14, 1985 and entitled "Method of Making Amorphous Semiconductor Alloys and Devices Using Microwave Energy", which patent is hereby incorporated herein by reference. This process utilizes microwave energy to decompose the reaction gases to cause the deposition of improved amorphous semiconductor materials. This process provides substantially increased deposition rates and reaction gas feed stock utilization. Microwave glow discharge processes can also be utilized in high volume mass production

Case 865

of devices, as disclosed in U.S. Patent No. 4,515,107, issued May 7, 1985, entitled "An Improved Apparatus for the Manufacture of Photovoltaic Devices", which patent is hereby incorporated by reference herein.

The gate 50 may be formed in the intrinsic semiconductor layer 48 in the manner indicated in Figure 3. As is indicated in Figure 3, a partial portion 48a of layer 48 is deposited, and then a layer of material out of which the gate 50 is to be formed is deposited on top of the partial layer 48a. Then the gate layer 50 is patterned by conventional photolithographic or electron beam techniques or the like so as to create the openings 51. At this point the partially completed transistor 40 has the appearance shown in Figure 3. Then further deposition of the intrinsic amorphous silicon alloy is performed on top of the gate 50, filling openings 51 and forming partial portion 48b of layer 48, so as to create the composite layer 48 indicated in Figure 1.

As can be understood by those skilled in the art of intergrated circuit fabrication, photolithographic techniques can be used to provide electrical contact to the bottom electrode 44 at one location, to the gate electrode 50 at a second location, and to the top electrode 54 at a third location. As can also be understood by those skilled in the integrated circuit art, a plurality of transistors such as the transistor 40 can be formed by photolithographic means on one substrate and can be connected with each other and other electronic circuits components to create more complex electronic circuitry.

Referring now to Figure 4A, a unipolar, or single injection, embodiment 40a of the present invention is shown in schematic form, with the substrate 42 and the metal layers 44 and 54 of the current path electrodes omitted to simplify the Figure. In this single injection embodiment both of the doped semiconductor layers 46 and 52, which form the ohmic contacts for the two current path electrodes, are made of $n^+$ material. As was stated above, $n^+$ material is efficient at injecting electrons into intrinsic semiconductor material but very inefficient at injecting holes into such material. As a result, when one of the $n^+$ electrodes is connected to the negative terminal of a power supply and the other is connected to positive terminal of a power supply, the current which tends to result in the current path in the intrinsic semiconductor material 48 between them is comprised almost exclusively of electrons. Since this current consists substantially of charge carriers of only one polarity, the device of Figure 4A is properly called a unipolar device. When device 40a is connected to a power supply PS as shown in Figure 4A, the electron current $(-I_D)$ flows from current electrode 46, which acts as the source (S), to current electrode 52, which acts as a drain (D). It should be clear to those in the art that transistor 40a may just as readily be connected to a voltage source to make layer 46 the drain and layer 52 the source.

In the transistor 40a, the gate electrode 50, when uninsulated, is preferably made of a material which forms a rectifying junction with the intrinsic semiconductor material of layer 48. This rectifying junction helps prevent current leakage from the gate electrode into the material of layer 48 when a voltage is applied to the gate to modulate current flow through the transistor. In the transistor 40a, as was stated above, both the current path electrodes have $n^+$ ohmic contacts and the current flow is comprised substantially only of electrons. Thus the application of a negative voltage $V_G$ to the gate 50 creates a barrier to the flow of electrons through the opening 51 that tends to turn the transistor 40a off. For this reason, the gate 50 of the transistor 40a is preferably made of a metal such as a platinum or a semiconductor material such as $p^+$ doped amorphous silicon alloy which forms a reverse biased junction with intrinsic amorphous silicon alloy when it has or is given a potential or voltage equal to or lower than that of the surrounding material of layer 48. In this manner, the material of gate 50 forms a small negative electric field E extending into the portion of layer 48 which immediately surrounds it, thereby creating a depletion region as is indicated in Figure 4A by the dotted lines 54. Figure 4B shows a qualitive graph of the magnitude and extent of the fields $E_L$ and $E_R$ along the "x" direction between two opposing left and right elements of the gate 50 when the potential of the gate is allowed to float. In Figures 5 through 9, qualitive graphs of the electrical field intensity $E_L$ and $E_R$ similar to that shown in Figure 4B are superimposed between opposing elements of gate 50. As is shown in Figure 5, in the absence of an applied voltage to the gate 50, the fields $E_L$ and $E_R$ extend only partially across the opening 51, and thus do not substantially bar the flow of electrons across the channel 51 of transistor 40a. As is shown in Figure 6, however, as the voltage applied to the gate 50 relative to the intrinsic material of layer 48 which surrounds

Case 885

it is increased, the fields $E_L$ and $E_R$ which extend across
the opening 51 increase, so that a much larger portion of the
opening 51 has a net negative field which tends to repel the
flow of electrons across it. This effectively narrows the size
of opening 51 to electrons and decreases the current flowing
between the contacts 46 and 52. As is shown in Figure 7, if
the negative voltage applied to the electrodes 50 is increased
even further, the combined negative field of $E_L$ and $E_R$ will
extend all the way across the opening 51, so as to
substantially cut off the flow of electrons in the current path
of the transistor 40a.

It should be clear from the foregoing description of
transistor 40a that the application of an appropriate biasing
voltage to gate 50 will tend to turn transistor 40a off, and
that the absence of such a biasing voltage on gate 50 allows
transistor 40a to be on. It is possible, however, to fabricate
a transistor similar to transistor 40a which is off in the
absence of an applied voltage, and which turns on with the
application of a positive gate voltage. This can be done by
making the opening between the gate elements 50 very narrow, as
is indicated schematically in Figures 8 and 9, and by selecting
the material of the gate 50 so that the depletion region in the
intrinsic material which surrounds the gate extends all the way
across the openings between its elements in the absence of an
applied voltage, as is indicated in Figure 8. In such a
device, electron flow through the opening 51 will be
substantially prevented in the absence of an applied gate
voltage. However, if a positive voltage is applied to the gate
50, the width of the depletion region surrounding the gate will

Case 835.

be decreased, as is indicated in Figure 9, and the barrier to electron flow through the opening 51 will be reduced, thereby increasing current through the transistor containing such a gate. To prevent current conduction between the gate 50 and the current-carrying electrodes 46 and 52, especially when the gate is forward-biased with respect to either current-carrying electrode. The gate is preferably substantially or completely insulated as will be further described in conjunction with the embodiments of Figures 15 and 18.

In the discussion above, the unipolar transistor 40a has two $n^+$ ohmic contact layers 46 and 52 and has substantially only electrons as the current carriers. It should be understood, however, that a unipolar device of the opposite polarity can be created by fabricating a similar transistor in which both of the current path electrodes have $p^+$ ohmic contact layers. In such an embodiment of the present invention, the gate 50 is formed of a material which tends to form a depletion region in the surrounding portion of the layer 48. In such a device the $p^+$ layer supplied with a relatively positive voltage tends to inject only holes into the semiconductor material of the layer 48, and thus the current flow consists substantially only of positive charge carriers. In such a device, the application of a positive voltage to the gate 50 would tend to increase the extent and magnitude of a positive field generated by the gate, causing that field to extend across the one or more openings 51, creating a barrier to the flow of holes through those openings, and thus tending to reduce the current flow across such a transistor.

Case 895

Figure 10A shows another embodiment of the present
invention. The transistor 40b shown in Figure 10A is
substantially identical to the transistor 40a shown in Figure
4A except that its top ohmic layer 52 is formed of a $p^+$
semiconductor material rather than the $n^+$ semiconductor
material shown in Figure 4A. This small difference in
construction results in a substantial change in operation. It
causes the current flowing in the transistor 40b to be
ambipolar, that is, comprised of carriers of both polarities,
i.e., both holes and electrons, rather than just carriers of
one polarity, as is the case with regard to the transistor
40a. This difference results from the fact that the $p^+$
material of layer 52 in Figure 10 tends to inject holes into
the intrinsic material of layer 48 when it is supplied with a
positive voltage relative to layer 48. Thus, when the
transistor 40b is electrically connected as indicated in Figure
11A with the $n^+$ layer 46 connected to a relatively negative
voltage and the $p^+$ layer 52 connected to a relatively
positive voltage, the layer 46 (which may be called the
cathode) injects electrons into the intrinsic layer 48 which
are attracted towards the positive voltage on layer 52, and the
layer 52 (which may be called the anode) injects holes into the
layer 48 which are attracted towards the negative voltage on
layer 46. Because both electrons and holes are injected into
its layer 48, the transistor 40b is also referred to as a
double injection device. In such devices, it is preferable to
insulate the gate 50 to minimize conduction through the gate to
either of the current-carrying electrodes 46 or 52.

-40-

Case 385

The ambipolar, or double injection, nature of transistor 40b provides a very important advantage over the unipolar transistor of Figure 1: it enables significantly larger currents to flow. Although the amount of current which flows in both single and double injection devices depends on many variables, such as temperature, thickness of the semiconductor current path, and applied voltage, it is easily possible for ambipolar devices to have on currents a thousand times greater than those obtained by similar single injection devices under the same operating conditions. This is illustrated by Figure 10B, which shows experimentally produced current density versus voltage (anode to cathode) curves of similar single injection (n-i-n) and double injection (p-i-n) a-Si alloy diodes at 25°C. M. Hack, et al., "A Comparison of Single And Double-Carrier Injection In Amorphous Silicon Alloys", Journal of Applied Physics, Vol. 58, pp. 1554-1561 (1985), presents results from both experimental and theoretical studies which explain in detail the mechanisms of single and double injection in unipolar and ambipolar diodes formed from such alloys, including the curves shown in Figure 11B. This article by M. Hack, et al is hereby incorporated herein by reference.

The reason an ambipolar device makes such an increase in current possible may be explained as follows. In the unipolar device of the type shown in Figure 4A substantially all of the conduction is performed by charge carriers of one polarity, such as electrons. As more electrons are injected into the current path of the unipolar transistor, the negative space charge created by excess electrons in the intrinsic layer

Case 885

48 tends to retard the injection of further electrons, and thus tends to limit the rate at which current may increase in proportion to increases in applied voltage between the top and bottom electrodes. This effect is known in the art as space charge limited conduction. However, in an ambipolar device an increase in voltage between the top and bottom electrodes causes an increased number of charge carriers of both polarities to be injected into its current path, and thus there tends to be a very much smaller increase in space charge caused by an increase in charge carriers, since the positively charged holes tend to cancel the space charge caused by the negatively charged electrons. The increase in the number of charge carriers made possible by double injection makes ambipolar devices capable of handling much larger currents than single injection devices for the same bias. In addition, the increased number of charge carriers made possible by double injection tends to fill a high percent of the traps or defect states which occur in amorphous silicon alloys at energies in the forbidden gap, increasing the drift mobility of both electrons and holes and thus further increasing the conductivity of double injection transistors.

The foregoing results of ambipolar operation may be explained in slightly more theoretical terms as follows. In both amorphous and crystalline semiconductor materials, electron band mobility is known to exceed hole band mobility. Accordingly, n-p-n bipolar transistors and n-channel MOSFETs may generally have a greater current capability while operating at a given bias voltage than do corresponding p-n-p bipolar transistors and p-channel MOSFETs. In the p-i-n transistor 40b

0212328

Case 885

of the present invention described above, the net space charge, defined as the excess of electrons over holes per unit volume of intrinsic semiconductor material in the conduction channel, still operates to limit channel conduction, but at much higher current levels than are possible in a similarly constructed unipolar FET. When the p-i-n transistor is turned on by application of a suitable gate voltage (or allowing the gate to float), a current path or channel, which extends in a generally vertical direction through the intrinsic material above and below the gate layer, is formed. The channel may, for example, narrow to fit through the channel opening(s) and flare outwardly therefrom above and below in an hourglass shape. Both electrons and holes begin to move or flow in the channel on account of the electric field created by the anode-cathode voltage. The number of electrons throughout most of the channel is greater than the number of holes, due to the superior band mobility of the electrons as well as the asymmetrical density of states distribution in the band gap of undoped a-Si material. For convenience, then, electrons may be called the primary or dominant charge carriers, and holes may be called the neutralizing or compensating charge carriers. (This condition can also be reversed, as will be explained in greater detail later.) The forward bias at the p-i junction at the boundary between layers 52 and 48 reduces the barrier height at the junction, allowing more holes to diffuse into the intrinsic channel from the p+ current path electrode. (The forward bias at the i-n junction between layers 48 and 46 similarly allows more electrons to diffuse into the intrinsic channel from the $n^+$ current path electrode 46.) Once in the intrinsic channel, the holes, upon application of forward bias,

Case 885

tend to be drawn toward the negatively biased current electrode due to the over-all field in the channel. The additional holes or compensating carriers tend to neutralize the space charge due to excess electrons or primary carriers in the channel, which allows even more electrons to enter the channel. The foregoing process continues until other mechanisms, perhaps such as hole mobility or the rate at which the $p^+$ layer 52 is able to efficiently inject holes into the intrinsic layer 48, limit the number of holes which can be simultaneously present with electrons in the channel. As that equilibrium point is reached, the number of excess electrons levels off due to the net space charge creating space charge limited conduction. The significance of the double injection process over single injection may be more forcefully presented by the following simplistic illustration. Let us assume that on account of space charge limited conduction, the maximum net charge per unit volume throughout most of the channel region adjacent the insulated gate is ten carriers for a specified gate voltage. Thus, in a unipolar system operating under these assumptions, the maximum the number of carriers contributing to conduction per unit volume cannot exceed ten carriers. However, in an ambipolar system operating under these assumptions and having the same mobilities, the maximum number of carriers may be, for example, 1,010 primary carriers and 1,000 neutralizing carriers, resulting in 2,010 carriers contributing to conduction per unit volume. Note that the net space charge is still ten carriers (1010 - 1000 = 10). Accordingly, in this illustration, the current in the ambipolar system is 201 times higher than the current of the unipolar system for the same mobilities.

Case 885

Those in the art should appreciate that the teachings of the present invention can be applied to create ambipolar devices having holes as the dominant charge carrier and electrons as the compensating charge carrier. This is done, for example, in VMITs which operate by stopping the flow of the holes through the opening in their gates, which greatly diminishes the flow of electrons through the opening as previously explained. Our computer modeling indicates (or at least suggests) that in the operation of an ambipolar device of the present invention, the dominant carriers are controlled directly by the voltage applied to the gate, and the compensating carriers are controlled indirectly by the voltage applied to the gate, in that the compensating carriers are primarily responding to the current and space charge density fluctuations of the primary carriers. In other words, a gate voltage of one polarity controls charge carriers of both polarities. Other exemplary embodiments of the present invention having holes as the dominant charge carrier are shown in Figures 39 and 40.

Our computer modeling for a-Si alloy ambipolar devices of the present invention also indicates that in general the holes are distributed relatively uniformly throughout the conduction channel, and that the recombination of holes and electrons occurring in the conduction channel consumes most, if not all, holes injected into the intrinsic material by the p+ current path electrode. It shows that a heavy concentration of majority carriers very near the i-n junction (i.e., electrons) consumes any holes which may have travelled that far, or which are created near the vicinity of the i-n junction. There may

Case 885

be other localized perturbations to the generally uniform distribution of holes, such as at the p-i junction or at the interface or boundary between the insulated gate and intrinsic semiconductor region. When the intrinsic material is an amorphous semiconductor, such as an alloy of silicon, the greatly increased number of holes and electrons is believed to fill many or most of the defect states or traps in the material, thus allowing more of the injected electrons to go into the conduction band and the injected holes to go into the valence band. This trap-filling phenomenon pushes the electron quasi-Fermi level further toward the conduction band and the hole quasi-Fermi level further toward the valence band than is possible in a comparable unipolar system. The phenomenon should also split the quasi-Fermi levels in semiconductor material, such as polycrystalline material, which does not have nearly as many defect states as amorphous material. This process leads to ambipolar devices having increased current flow for any given channel depth as compared to unipolar current flow.

In any semiconductor electrons and holes can recombine both radiatively and non-radiatively. When the quasi-Fermi livels are split by an energy approximately equal to the band gap of the material, a significant amount of the carrier recombination will be radiative and hence the device will exhibit electroluminescence. Yet another advantage of the trap-filling phenomenon is that it is possible to construct ambipolar transistor devices of the present invention from amorphous silicon alloys which exhibit electroluminescence. When the injection levels become sufficiently high so that the

Case 835

difference between the quasi-Fermi levels becomes comparable to or greater than the energy gap, then light emission, and, with the incorporation of a suitable optical cavity, coherent light emission (i.e., lasing) may occur as will be explained in greater detail later with respect to Figures 39 and 40.

One more significant advantage of the ambipolar operation is that wider conduction paths or channels can be achieved for a given gate voltage than is possible with the n-i-n or p-i-p transistor devices on account of neutralization of space charge. This enables higher current for almost any given transistor geometry. This advantage will be explained in more detail in conjunction with the horizontal ambipolar embodiments shown in Figures 29A and 36.

The expected current-voltage curve of the transistor 40b is shown in Figure 11B. As indicated in Figure 11A, which is a schematic diagram of another version of transistor 40b similar to that shown in Figure 10A, there is a voltage drop across the intrinsic layer 48. The voltage drop within the layer 48 is generally nonlinear with respect to distance between the current path electrodes and varies with the amount of current flowing therethrough. For the purposes of the following discussion, however, we will assume a relatively linear voltage drop through layer 48. This voltage drop causes the voltage of the material of layer 48 to range from approximately zero volts at the portion of that layer which touches the $n^+$ layer or cathode 46 to approximately five volts at the portion of the layer which touches the $p^+$ layer or anode 52. If the gate 50 is located approximately midway

Case 885

through the layer 48, the voltage of the intrinsic material
with which it is in contact, based on the assumption of
linearity, will be approximately 2.5 volts. The gate 50, if
allowed to float, will be at approximately that voltage. As is
shown in Figure 11B, the current flowing through the transistor
has its maximum value when the gate 50 is at approximately 2.5
volts. If a voltage is applied to the gate 50 which is lower
than this floating potential, the gate tends to, depending on
the applied gate voltage, more weakly attract or even repel
electrons, which tends to decrease the flow of electrons
through the opening between its gate elements. Preliminary
experimental results suggest that the application of a voltage
below the floating potential of the gate decreases not only the
flow of electrons through the openings in the gate, but also
decreases the flow of holes, although the decrease in the flow
of holes is somewhat less than the decrease in the flow of
electrons. This decrease in the flow of holes is caused by the
tendency to maintain space charge neutrality. Similarly, if a
voltage is applied to the gate 50 which is above the gate's
floating potential, the positive field induced at the gate may
tend to initially increase the flow of electrons (and by
compensation, holes) through its openings 51. However, the
reduction in electric potential between the gate electrode and
the anode electrode reduces the device current, as shortly will
be further explained. The graph of Figure 11B illustrates in a
general way how the anode current $I_A$ may vary as a function
of gate voltage $V_G$ in the field effect transistor device 40b
of Figure 11A. As will also be explained, a number of factors
will influence precise shape of this curve.

Case 885

The most likely explanation for why the application of a voltage to gate 50 which more weakly attracts or repels carriers of one polarity also repels carriers of the opposite polarity or at least reduces their number is as follows. Energy considerations create a strong preference for space charge neutrality throughout the current path between the electrodes 46 and 52. If a voltage is supplied to the gate 50 which tends to keep charge carriers of one polarity out of the opening 51, the tendency toward space charge neutrality tends to greatly reduce the presence of charge carriers of an opposite polarity in that opening since there is a limit to overall net charge that can be contained in any given volume.

The floating potential of the gate 50 in the Figure 11B transistor is a function of the voltage drop across the thickness of the layer 48 between the positive and negative potentials of five and zero volts, respectively, applied to contacts 52 and 46. If, as is shown in Figure 12A, the gate 50 is placed nearer the $p^+$ layer 52 than the $n^+$ layer 46, the gate will tend to float at a voltage which is nearer five volts than zero volts. Assuming for purposes of example that the gate in Figure 12A floats at approximately four volts, then the anode current $I_A$ of the Figure 12 device should vary with applied gate voltage $V_G$ roughly as shown in Figure 12B, and should reach its peak at a gate voltage of approximately four volts, as shown. On the other hand, if the gate 50 is placed substantially closer to the $n^+$ contact 46 than to the $p^+$ contact 52, as is shown in Figure 13A, the gate 50 will tend to float at a voltage which is substantially closer to zero volts than five volts. Assuming for purposes of example that the gate 50 in Figure 13A is placed in a position so that it floats at approximately one volt, then the current-voltage curve of the resulting device, should be roughly as is shown in Figure 13B, and will tend to reach its maximum current at a gate voltage of approximately one volt, as shown.

The current-voltage curves of Figures 11B, 12B and 13B show that by controlling the position of the gate 50 relative to the current electrodes 46 and 52, it is possible to greatly alter the current-voltage characteristic of a device of the general type shown in Figure 10A. The current-voltage curve shown in Figure 11B is that of a device which is substantially off when the voltage of either of its two current path electrodes is applied to its gate, but which is turned on to a maximal current flow when the gate is supplied with a suitable intermediate voltage, or is allowed to float. The current-voltage curve shown in Figure 12B is that of a device which is substantially on when its gate is supplied with a voltage close to that of its higher voltage current path electrode (anode), but is substantially off if its gate is supplied with the voltage close to that of its lower voltage current path electrode (cathode). The current-voltage curve shown in Figure 13B is just the opposite, since it is that of a device which is substantially on when its gate is supplied with the voltage close to that of its lower voltage current path electrode, and is substantially off when its gate is supplied with the voltage close to that of its higher voltage current path electrode.

Figures 14A and 14B illustrate how the current-voltage curve of the ambipolar device of the present invention can be tailored in another significant way. The width of that portion of the curve in which the transistor is substantially on can be narrowed or widened as a function of the width of the openings 51 between the elements of its gate 50. If the openings 51 are narrowed, smaller voltages between the gate and its surrounding intrinsic semiconductor material are capable of generating an electric field of sufficient strength to substantially stop current flow all the way across the openings 51, and thus substantially turn the transistor off. This greater sensitivity to gate voltages is shown in Figure 14B. On the other hand, if the gate openings 51 are widened, much stronger (i.e., more positive or negative) voltages must be applied to the gate relative to the surrounding intrinsic material in order to generate a field of sufficient strength to substantially limit current flow all the way across the openings 51. Thus in a transistor with such widened openings 51, the sensitivity of the device to changes in gate voltages will be decreased.

It should be understood that the current-voltage diagrams shown in Figures 11B, 12B, 13B and 14B are logarithmic in their vertical direction, and that the change in current flow between a transistor 40b which is on and which is off may vary by several orders of magnitude depending upon device geometry. It should also be understood that these diagrams are only approximate, since the actual shape and position of such curves depends upon many factors. For example, one very important factor is the size of the opening(s) 51. Another is

Case 885

the thicknesses of the upper intrinsic layer 48a and the lower
intrinsic layer 48b. Also, in transistors of the present
invention in which the gates are made of a material which
creates a depletion region in neighboring intrinsic material in
the absence of an applied voltage, the current-voltage curve
will tend to be shifted to either the right or the left by the
presence of such a self-generating field across the openings
51. In addition, since the mobility of electrons and holes are
not identical, the current-voltage diagram is not symmetrical
about its point of maximum current. The current-voltage curve
also tends to be asymmetrical because the number of defect
states in amorphous silicon alloy at energies close to the
conduction band, in which electrons are trapped, is different
than (i.e., lower than) the number of defect states at energies
close the the valence band, in which holes are trapped. The
thickness of the gate layer 50 relative to the size of the
openings 51 can also be an important factor, since it
influences the shape of the electric field induced by a voltage
applied to the gate. In addition, the relative strength of the
voltage applied across the current path electrodes 46 and 52
has a bearing upon the resultant current-voltage curve.

In both the unipolar and ambipolar embodiments of the
invention where it is desired that the transistor have a high
current capacity, the semiconductor material of the current
path should be selected to provide relatively long carrier
lifetimes. When the current path is made of amorphous silicon
alloy, this normally means the current path should be made of
intrinsic amorphous silicon alloy, since such intrinsic
material has far less defect states than doped amorphous

Case 885

silicon alloys. In certain ambipolar embodiments of the transistor of the invention where it is desirable to turn off the transistor rapidly, certain elements may be mixed in with the amorphous silicon alloy of the current path to reduce carrier lifetimes. For example, materials such as gold may be mixed into the silicon alloy to create recombination centers having energy levels approximately half way between the energies of the conduction and valence bands. The benefit of such recombination centers is that they greatly increase the rate at which holes and electrons recombine in the current path, and thus they shorten the length of time it takes the current path to be cleared of carriers when the transistor is turned off.

Figures 12A and 13A show that the gate 50 may be asymmetrically placed with regard to the two current path contacts 46 and 52 to shift the current-voltage curve. In certain ambipolar embodiments of the invention, however, there is another reason for asymmetrical placement of the gate 50 with regard to the contacts 46 and 52. This reason relates to the reduction of leakage current. In ambipolar embodiments of the invention in which the gate 50 is made of an $n^+$ or $p^+$ material that forms a rectifying junction with the material of the current path, unacceptable levels of current will tend to leak from the planar surfaces of the gate unless its junction with the current path is reverse biased. If the planar surfaces of the gate covers a relatively large area, such gate leakage current could be substantial even though the gate leakage current density is relatively low. If, however, the gate is supplied with a voltage between that of the two

Case 885

current path electrodes 46 and 52, as is described above with regard to Figures 12B through 14B, the gate will be forward biased with regard to both the anode and the cathode, which creates substantial and undesirable currents between both current-carrying electrodes 46 and 52 and the gate 50. Accordingly, it is highly recommended that the gate 50 be almost fully or fully insulated for those ambipolar embodiments of the invention to be operated with gate voltages between that of the two current path electrodes 46 and 52.

The leakage current between the gate 50 and the current path electrode 46 or 52 which has the same conductivity type as the gate is unipolar due to single injection. Such a single injection gate current path (for voltages greater than about 0.7 volts) normally conducts substantially less current than does a double injection current path between the gate and the current path electrode of the opposite conductivity type. These facts may be utilized to minimize overall gate leakage current to or from both of the planar surfaces of the gate in the following ways. First, the transistor may be operated in a voltage range in which the gate is reverse biased with regard to the electrode with which it forms the double injection leakage path, and forward biased with regard to the electrode with which it forms the single injection gate current path. This substantially shuts off leakage current in the more conductive double injection gate leakage path, and limits it to the less conductive single injection gate leakage path. Second, asymmetrical placement of the gate 50 allows the single injection leakage current to be reduced even further, i.e., the gate is placed so the single injection gate leakage path is

Case 885

longer than the double injection gate leakage path. Such shortening of the double injection gate leakage path has little adverse effect on double injection gate leakage current, which is virtually zero due to the aforementioned reverse bias. But the lengthening of the forward biased single injection gate leakage path substantially reduces gate leakage current, since the conductivity of a single injection current path decreases rapidly with increasing leakage path length.

The devices in all of the embodiments of the invention discussed in detail above which do not include an insulating layer around the gate rely upon depletion regions formed between the gate 50 and the intrinsic material of layer 48 to prevent or reduce the leakage current from the gate into the layer 48, and through that layer to the transistor's current path electrodes. Although such depletion regions do significantly reduce leakage current, experiments have indicated that substantially increased performance can be obtained by insulating as much of the surface of the gate 50 from the layer 48 as possible.

Referring now to Figure 15, the transistor 60 therein shown is substantially identical to the transistor 40 shown in Figure 1 except that the bottom of its gate 50 is insulated from the lower portion 48a of intrinsic material 48 by a bottom insulating layer 62 and the top of its gate 50 is insulated from the upper portion 48b of layer 48 by a top insulating layer 64. Such a device may be readily fabricated in the manner indicated in Figures 16 and 17.

Figure 16 shows the transistor 60 in a partially constructed state in which the bottom current path electrode 44 and its $n^+$ ohmic contact 46 have been deposited upon the substrate 42 and have been covered by the bottom portion 48a of the intrinsic layer 48. On top of the layer 48a the bottom insulating layer 62 has been deposited. The conductive material of the gate 50 has been deposited upon the layer 62. Finally, the top insulating layer 64 has been deposited on top of the gate layer 50. Preferably, the layers 62 and 64 are formed of deposited insulating material such as silicon oxide ($Si_xO_y$) or silicon nitride ($Si_xN_y$). Preferably, each of these insulating layers is between 200 and 5,000 angstroms thick. A layer 66 of photoresist is deposited upon the top insulating layer 64 and is patterned by exposure to actinic radiation through a patterning mask and by subsequent development. After the photoresist 66 has been patterned, the partially completed transistor 60 has the appearance shown in Figure 16. Then the structure is submitted to a plasma etch, such as an $NF_3$ etch or a $CF_4$ and $O_2$ etch, which removes the portion of the insulating layer 64 exposed through the openings in the photoresist layer 66. The structure is next submitted to an acid or plasma etch of a type known in the art (such as a $CHCl_3$ etch) to remove the metal material of the layer 50, so as to form the openings 51. Preferably the structure should be submitted to this etch for a sufficient length of time to cause some undercutting in the layer 50 (indicated by dotted lines 50u in Figures 15 and 17) so that upon the next deposition of intrinsic semiconductor material to fill openings 51 and form the top portion 48a of layer 48, the intrinsic material will not contact the gate 50, thus reducing leakage at the uninsulated edges of the layer 50 which define the openings 51. After the portions of the layer 50 which are not covered by the photoresist 66 have been removed by such an etch, the structure is submitted to another etch, such as an $NF_3$ etch, to remove the insulating material of layer 62 that is exposed through the openings in the photoresist 66. Care should be taken in performing this final etch, since most etchants that will remove materials such as silicon oxide and silicon nitride used in layer 62 will also tend to etch amorphous silicon alloys of the type used in layer 48a. Thus this final etch step should be timed so as to allow the entire exposed portion of layer 62 to be removed, while minimizing the amount of subjacent intrinsic layer 48a which is also removed.

Once this final etch has been completed, the partially constructed transistor 60 has the structure shown in Figure 17. At this point the photoresist layer 66 is removed, and then a second deposition of intrinsic silicon alloy is performed, so as to create the upper portion 48b of the layer 48. After this has been done, the $n^+$ or $p^+$ layer 52 and the metal electrode 54 are formed in the manner described above with regard to Figure 1.

As was stated above, the structure shown in Figure 15 has markedly less leakage current between its gate electrode and its current path electrodes than the previously shown embodiments of the invention. The previously mentioned undercutting of the metal of its gate layer 50 should make it possible to substantially avoid electrical contact between the gate 50 and the layer 48. Figure 18A shows another way to

Case 885

virtually eliminate the leakage current from the gate electrode 50. In the Figure 18A device 70, the electrode 50 is made smaller in horizontal extent than either the top or bottom insulating layers 62 and 64, and thus it is totally electrically insulated by them. As can be understood by those skilled in the photolithographic art, such a structure is made by depositing the layer 62 upon the top surface of the layer 48a, which top surface is indicated in Figure 18 by the dotted line 48g. Then the gate layer 50 is formed upon the insulating layer 62 and is patterned via photolithographic techniques. Then the top insulating layer 64 is formed as a continuous layer over the patterned gate 50. After the deposition of the insulating layer 64, photolithographic techniques are used to etch through portions of the layers 64 and 62 located between the fingers of the gate 50. The photolithographic process is designed, however, so that portions of the layer 64 which cover the top and side surfaces of the layer 50 are not removed. Then the top portion 48b of the intrinsic layer 48 is deposited in the manner described above, followed by the ohmic layer 52 and the electrode layer 54.

Referring now to Figure 19A, a transistor 80 according to an alternate higher speed embodiment of the invention is shown. The transistor 80 is somewhat similar to the transistor 60 shown in Figure 15, but the insulating layers 62 and 64 above and below its gate electrodes are much thicker, and the intrinsic semiconductor material 48, instead of surrounding the gate electrode 50, as is shown in Figure 15, instead is only deposited in openings between the gate electrodes in the transistor 80. The benefits of the transistor 80 include

-58-

Case 885

reduced leakage from its gate electrodes due to the thicker insulator layers, and reduced capacitance between its electrodes since the relative permittivity of the insulator layers is higher than that of the intrinsic amorphous silicon alloy of layer 48. Reduced capacitance is important, since it increases the speed of operation of such a transistor. In addition, the greater distance between the top electrode 54 and the gate 50, due to the thickness of the layer 48 which overlies the gate 50, results in a further reduction in capacitance in the transistor 80, thus increasing speed of operation.

As is shown in Figures 20 and 21, the transistor 80 is constructed by depositing a plurality of layers of different material upon the substrate 42, etching through a group of those layers to create the structure shown in Figure 21, and then depositing the intrinsic layer 48 and the top ohmic and electrode layers 52 and 54.

Before the etching steps take place, the bottom current path electrode layer 44, preferably made of a conductive metal such as chrome or molybdenum and preferably 1,000 to 5,000 angstroms thick, is deposited. On top of that a layer 46 of $n^+$ material is deposited for purposes of making an electron injecting ohmic contact. This layer is preferably approximately 500 angstroms thick. On top of the layer 46 a thin layer 82 of aluminum or molybdenum is deposited preferably about 500 angstroms thick. As is described below, this layer functions as an etch stop or end point detector. Over the metal layer 82 a relatively thick layer of insulating material

62 is deposited. Preferably layer 62 is made of a deposited insulator such as silicon oxide or silicon nitride. The preferred thickness for the layer is between 200 and 5,000 angstroms. Next a layer of metal preferably about 200 to 1,000 angstroms thick is deposited to form the gate layer 50. A plurality of different metals can be used for this purpose, including chromium and molybdenum. Above the layer 50, an insulating layer 64 is deposited, preferably made of the same material and of the same thickness as the layer 62. Once all of these layers have been deposited, a layer of photoresist 84 is deposited on top of the layer 64 and is patterned by exposure and subsequent development, so as to create a patterned etch mask as is shown in Figure 20.

After the photoresist layer 84 has been patterned, the entire structure shown in Figure 20 may be submitted to a plurality of etches so as to etch through the layers 64, 50, 62, and 82 and thus produce the structure shown in Figure 21. An etch, such as an $NF_3$ etch or a $CF_4$ and $O_2$ plasma etch, is used to remove the portion of the top insulating layer 64 which is exposed through the photoresist mask 84. Then the structure is submitted to an acid or plasma etch of a type designed to remove the metal material of layer 50 exposed by the photoresist mask 84. After that, the structure is submitted to another $NF_3$ etch or $CF_4$ and $O_2$ etch to remove the insulating material in layer 62 exposed by the mask 84. This etches the layer 62 down to the metal layer 82, which is either an etch stop or the end point indicator for a laser detection system. An etch stop is necessary with an $NF_3$ etch, and most other etches which are effective in removing

Case 885

materials such as silicon nitride, since they also tend to be effective etchants against amorphous silicon alloys. After the exposed portion of the bottom insulating layer 62 has been removed, the structure is submitted to a second acid or plasma etch of a type which removes the exposed portions of the metal in the layer 82.

When layers 50 and 82 are made of a suitable metal, such as molybdenum, a suitable plasma etch such as a $CF_4$ and $O_2$ etch, may be used to remove the insulating layers 62 and 64 and the metal layers 50 and 82 in one continuous etching step. A laser end point detection system may be employed during such a step to monitor the progress of the etching. As is known in the art, such a detection system works by illuminating the layered structure to be etched with the laser and then monitoring the changing reflectivity due to interference as the etchant successively exposes each underlying layer. The reflectivity increases as each molybdenum layer is encountered and decreases when an intrinsic, $n^+$, $p^+$ or insulating layer is encountered. Accordingly, the drop in reflectivity immediately subsequent to the second rise in reflectivity indicates that the etching has reached layer 46, and therefore should be stopped. After completing the foregoing processing steps, the partially constructed transistor 80 has the structure shown in Figure 21, in which a complete opening has been made through the multilayered structure formed by layers 64, 50, 62 and 82 in the gaps 51 between the gate elements 50, and in which the $n^+$ layer 46 of the bottom electrode is exposed in each of these openings.

Case 885

Once this has been done, the photoresist layer 84 is removed and a layer 48 of substantially intrinsic amorphous silicon alloy is deposited, as shown in Figure 19A. It is important to remove the photoresist layer 84 before depositing the semiconductor layer 48, because otherwise the organic compounds in the photoresist may contaminate the layer 48 and severely damage its electronic properties. The thickness of the layer 48 deposited should be sufficient to fill the openings formed in the multilayered structure formed of layers 64, 50, 62 and 82. Once layer 48 has been deposited, a layer 52 of doped amorphous silicon alloy is deposited having a thickness of approximately 500 angstroms. Then on top of the layer 52 a layer 54 of metal, such as chromium, molybdenum or aluminum, preferably having a thickness of 300 to 5,000 angstroms, is deposited to form the top current path electrode.

Preferably the etching steps in which the metal of layer 50 and the metal of layer 82 are removed are allowed to continue sufficiently long so that the metal in the layer 50 is sufficiently undercut, as is indicated in dotted lines 50u in Figures 19A and 21, so as to reduce the likelihood of contact between the conductive metal of layer 50 and the deposited intrinsic amorphous semiconductor of layer 48. If this is done the gate electrode 50 should be substantially electrically isolated from the layer 48, thus reducing leakage current from the gate almost to zero.

As was stated above, one of the major advantages of the transistor 80 is its low capacitance. The capacitance of this transistor can be reduced even further if the bottom

-62-

Case 885

electrode comprising layers 44, 46 and 82 are patterned before the deposition of layer 62 so as to not cover the portion of the substrate 42 which is to be covered by the gate elements 50. Similarly the top electrode comprised of layers 52 and 54 may also be patterned by photolithographic means so as not to cover the portions of the transistor 80 above the gate elements 50. Such a removal of the top and bottom electrodes from the portions of the transistor in which the gate elements 50 are located will substantially further reduce the capacitance between the current path electrodes and between the current path electrodes and the gate, thus increasing the speed of the transistor. Also, by using ion milling or other suitable techniques, the portions 43d of layer 43 above the top insulating layer 64 may be removed so as to have the intrinsic material and current conducting path therethrough substantially confined to the openings in the layers 62, 50 and 64. Finally, transistor 80 may, if desired, be constructed with a single opening, rather than the plurality of openings indicated in Figure 19A.

The transistor 80a shown in Figure 19B is an example of a transistor structure which is basically constructed like transistor 80, but which incorporates the last two suggestions. Note that transistor 80a advantageously provides a planar top surface upon which further layered structures or elements may be deposited or otherwise formed.

Although the transistor 80 can be constructed to be unipolar by having the ohmic contact layers 46 and 52 be doped to have the same conductivity type, such as $n^+$ conductivity

-63-

type, it is preferred that one of the ohmic contact layers be $n^+$ and the other be $p^+$, so that the transistor 80 will be an ambipolar device in which current conduction is performed by both holes and electrons. As is described above, such an ambipolar device has the great advantage of a much greater current flow. Such an increase in current flow not only results in the ability of the transistor to handle more power, but also tends to increase the speed of the transistor by reducing the time required to charge and discharge the capacitances associated with its electrodes.

Referring now to Figures 22 and 23, an alternate embodiment of the invention, in the form of a transistor 90, is shown. The transistor 90 is substantially identical to tne transistor 40 shown in Figure 1 except for the fact that it has two gate layers 50a and 50b, instead of the single gate layer 50 shown in Figure 1.

The two gate layers 50a and 50b are each formed in substantially the same manner as is the single gate layer 50 of the transistor 40 discussed above. In fact, the first gate layer 50a is formed in exactly the same manner as the gate 50 shown in Figure 3. After the deposition of a first portion 48a of the intrinsic layer 48, the first layer 50a is deposited and patterned by photolithographic means. In Figure 23 the upper boundary of this first portion 48a of the intrinsic layer is shown in dotted lines. Then a second or middle portion 48c of the intrinsic layer 48 is deposited, and after its deposition, a second gate layer 50b is deposited by photolithographic means. Over this structure the upper and final portion 48b of

Case 885

the layer 48 is deposited and then the ohmic contact layer 52 and the metal electrode layer 54 are deposited to complete the construction of the transistor 90.

One advantage of the transistor 90 with its multilayered gate is that since each of its gate layers 50a and 50b is capable of turning on or off the transistor 90, the transistor acts as a two input logic gate with each of its gate layers functioning as a separate logic input. It is to be appreciated, of course, that it would be possible to have more than two gate layers function in such a manner so as to create a three or more input logic gate. It is also to be understood that by varying the position of the individual gate layers, 50a and 50b, relative to the current path electrode at the top and bottom of the structure, the voltage at which each such gate will turn off current flow can be varied in the manner described above with regard to Figures 11A and 11B through 14A and 14B. It is also to be understood that a multigate transistor of the type shown in Figure 90 can also be constructed in which the gates are insulated in the manner shown in Figures 15, 18 and 19.

In at least those VMITs having an insulated gate 50 whose openings 51 are sufficiently small, it should be possible to substantially turn off the device by applying a voltage to gate 50 which is about equal to the voltage of the more distant of the two current-carrying electrodes 46 and 52. With suitably small openings 51, such a gate voltage will effectively reduce the voltage drop across the portion of layer 48 which is between the gate and the more distant electrode to

Case 825

very near zero volts. Accordingly, charge carriers will no longer drift rapidly across this portion of layer 48. In general, this technique of shutting off a VMIT should also work if the voltage applied to the gate is made the same as the closer of the two current-carrying electrodes, provided that the portion of layer 48 between the gate and the closer electrode is sufficiently thick relative to the size of the openings 51.

VMITs of the type illustrate by transistor 90 in Figure 22, which have a plurality of gates spaced vertically apart by a sufficiently thick layer 48c, may be turned off even more completely by creating a reverse bias across layer 48c, or alternatively across layers 48a and 48b. Once again, each of these techniques assumes that the relative size of the openings 51 in the plurality of gate layers is sufficiently small to allow the voltage applied to gate layer to extend across the openings. The reverse bias across layer 48c can be created in the Figure 22 device, for example, by making gate voltages $V_{G1}$ and $V_{G2}$ two-thirds of V+ and one-third of V+, resp. V+ is the voltage applied to electrode 54 when electrode 44 is grounded, i.e., at zero volts. To create a reverse bias across layers 48a and 48b, the gate voltage $V_{G1}$ can be made lower than zero volts, and the gate voltage $V_{G2}$ can be made higher than V+. In both cases, each reverse biased portion of layer 48 tends to be depleted of charge carriers which effectively interrupts almost all current flow. Accordingly, extremely low off currents may be achieved in VMITs having a plurality of vertically spaced control gates.

-65-

Case 885

Referring now to Figure 24A, an alternate embodiment of the invention is shown in the form of a transistor 95. The transistor 95 is substantially identical to the transistor 90 shown in Figure 22, except that its two gate layers or electrodes 50a and 50b are staggered relative to each other, so that the openings 51a between the elements of gate layer 50a are substantially covered or masked in a vertical direction by gate elements in gate layer 50b, and the openings 51b between the elements of gate layer 50b are substantially covered or masked by gate elements in gate layer 50a. One possible arrangement for gate layer 50a is shown in Figure 24B, which is a partial cross-section taken along lines 24B-24B of Figure 24A. A major advantage of such staggered gate layers is that they make it very easy to fabricate a combined gate structure in which the passages in the gate structure through which the current path in layer 48 extends are longer, and if desired very narrow. It is presently much easier in the fabrication of deposited semiconductor structures to finely control the vertical distances between structures, such as thickness of portion 48e of intrinsic layer 48 between gate electrodes 50a and 50b, which are determined by the thickness of one or more deposited layers, than it is to finely control the horizontal distances between structures, which are normally determined by photolithographic techniques. Thus, for example, by controlling the thickness of intrinsic semiconductor material deposited between gate layers 50a and 50b it is quite easy to cause the spacing of portions 48e of intrinsic layer 48 between such layers to be less than a half or a quarter of a micron in thickness, although it would be much more difficult to obtain such a submicron spacing for the width or length openings

Case 885

between the elements of a single gate layer by photolithographic means, such as openings 51a or 51b. The ability to fabricate such small spacings between gate layers makes it easier to fabricate transistors in which the depletion region caused by the gate electrodes are sufficient to make the device be turned off in the absence of any applied voltage, as is discussed above with regard to Figures 8 and 9. Such close spacing also makes possible transistors which can be turned on and off with smaller applied gate voltages, as is indicated above in the discussion regarding Figures 14A and 14B. Note that even if portion 48e is an order of magnitude thicker (e.g., five microns) the staggered gate arrangement is still very beneficial in that it may be used to increase the over-all length of any given current path through the gate layers, which allows a weaker electric field produced by the gate layers to choke off as much current as a somewhat stronger electric field applied over a somewhat shorter current path.

It should be understood that the two gate layers 50a and 50b of transistor 95 need not be electrically connected as indicated in Figure 24A. For example, each of the two gate layers can be connected to a different electrical input, causing the transistor 100 to function as a logic gate in a manner analogous to the transistor structure configured as a logic gate and described below with respect to Figure 27A.

Referring now to Figures 25A through 28C alternate embodiments of the present invention are shown in circuit configurations which illustrate four of the basic types of logic gates. Figure 25A shows a transistor structure 100 which is designed to perform an OR gate function as indicated in the truth table of Figure 25B. The transistor 100 has a gate layer 50 formed of two coplanar, electrically separate electrodes $G_1$ and $G_2$ that are separated by an opening 51, through which the current path between the bottom and top contacts 46 and 52 extends. The gate layer 50 is placed closer to electrode 46 than it is to electrode 52 in accordance with the teachings of the Figure 13A embodiment. This vertical positioning of the gate layer 50, the spacing of the opening 51, resistance value of resistor 101, and the thickness of the gate layer are selected so that when a voltage signal representing a "logical 1" (e.g., approximately +5V) is applied to either of the two gates $G_1$ or $G_2$, it produces an electric field sufficient to turn off most of the portion of the current path lying in the opening 51. When both gate electrodes are at a logical 1 value, the current through the current path will be fully off. Thus only when a "logical 0" (e.g., approximately zero volts) is applied to both gate electrodes $G_1$ and $G_2$ will a relatively large current be allowed to flow through opening 51. In the circuit configuration shown in Figure 25A, a pull-up resistor 101 in series with DC power source 102 serves to make output terminal $V_0$ a logical 1 whenever current I is mostly off or fully off, and a logical 0 whenever current I is relatively large. As a result the transistor 100 in the circuit configuration of Figure 25A acts as an OR logic gate which is turned on if either of its two gate inputs $G_1$ or $G_2$ receives an input which represents a logical 1.

Figure 25C shows a partial cross-sectional view of one possible arrangement of gate layer 50 of Figure 25A taken along lines 25C-25C, wherein each of the gate electrodes $G_1$ and $G_2$ has a plurality of fingers interdigitated with the fingers of the other gate electrode. The opening 51 provided between the interdigitated fingers is thus an elongated channel of substantial length which advantageously provides transistor 100 with increased current handling capacity.

Figure 26A shows an alternate embodiment of the invention in a circuit configuration which functions as an AND gate as indicated in the truth table of Figure 26B. The transistor 110 shown in Figure 26A has two coplanar, electrically separate gate electrodes $G_1$ and $G_2$ that are separated by an opening 51 in a manner very similar to that of the Figure 25A device, except that its opening 51 is substantially wider. The opening 51 may take the elongated channel form showing in Figure 26C, which is a partial cross-sectional schematic view of the gate layer of transistor 110. The opening 51 in transistor 110 is sufficiently wide so that, in order to create a depletion region all the way across opening 51 to turn off the current flow through the opening, both gates $G_1$ and $G_2$ must have a logical 1 voltage value applied to them. Accordingly, transistor 110 operates as an AND gate.

Figure 27A shows a transistor 130 in a circuit configuration which operates transistor 130 as a NAND gate, as indicated in the truth table of Figure 27B. The transistor 130 is basically identical to the transistor 90 discussed above with regard to Figure 22, except that the two gate electrodes $G_1$ and $G_2$ have been moved upward toward the more positive of two current path electrodes to obtain the type of gate operation described with respect to the Figure 12A transistor. Accordingly, each of the openings 51f and 51g is able to conduct when a logical 1 voltage is applied to its associated gate $G_1$ or $G_2$. Since the openings 51f and 51g are electrically in series with each other, the entire current path across the transistor 130 will be turned on only if both of the openings 51f and 51g are turned on. Thus the transistor 130 functions as a NAND gate in the circuit configuration illustrated in Figure 27A.

Figure 28A shows an alternate embodiment of the invention in a circuit configuration which forms a NOR gate, that operates as indicated in the truth table of Figure 28B. The transistor 140 shown in Figure 28A has two coplanar electrodes 50c and 50d whose top surfaces are covered by insulator layer 64. The electrodes $G_1$ and $G_2$ are arranged to be much closer to electrode layer 52 than electrode layer 54 to obtain operating characteristics like those disclosed in Figure 12B. The gate electrodes $G_1$ and $G_2$ are separated from one another by openings 51h and 51i and a portion 64a of insulating layer 64. Those skilled in the art will appreciate that transistor 140 including insulating layer 64 with portion 64a can be readily formed, for example, by modifying somewhat the method steps disclosed with respect to the construction of transistor 60 shown in Figure 16. The insulating layer 64 confines current flowing through intrinsic layer 48 to pass either through openings 51h or 51i. Opening 51h is sized so

Case 885

that a logical 0 input voltage applied to gate electrode $G_1$ shuts off virtually all current flowing through opening 51h, and so that a logical 1 input voltage allows current to flow between current path electrodes 52 and 46 via the portion of the path in the intrinsic layer 48 that passes through opening 51h. Opening 51i is sized in the same manner with respect to logical 0 and logical 1 input voltages applied to gate electrode $G_2$. Moreover, openings 51h and 51i are each sized so that it can pass sufficient current by itself to cause output $V_0$ to assume a logical 0 state when the opening is biased to conduct. Accordingly, the transistor 140 circuit configuration will operate as a NOR gate.

The gate layer 50 shown in Figure 28A is comprised of a plurality of control or gate electrodes 50c and 50d which define in part openings 51h and 51i. Insulating portion 64a defines the remainder of openings 51h and 51i.

An alternate arrangement for the gate layer 50 of transistor 140 is shown in Figure 28C. Gate layer 50 shown therein has a plurality of coplanar gate electrodes 50c and 50d covered by insulating layers 62 and 64 and horizontally separated from each other by a volume of space filled with a portion 64a insulating material from layer 64.

The foregoing discussion concerning Figures 25 through 28 serves to illustrate that the transistor of the present invention may typically be configured in more than one way to achieve any given logic gate function. Alternative implementations for various logic gate functions may be readily

-72-

Case 885

created by those skilled in the art by selectively combining various teachings of the present invention. Also, even though the embodiments of Figures 25 through 28 show only two inputs for each of the logic gates, an advantage of the transistor of the present invention is that multiple (e.g., three, four or more) inputs may simply and readily be provided by including additional gate or control electrodes. Those in the art will also appreciate that significantly changing the operating voltages, for example from five to fifteen volts, will typically necessitate changing the spacing and/or geometry of the transistor's structure to preserve the selected logic gate function. Moreover, changing the vertical position of the gate layer(s), or changing (such as reversing) the operating voltages may alter the logic gate function performed by the transistor in a manner that is qualitively predictable based upon the teachings of the present invention. Thus, another important advantage of the present invention is that it provides a basic transistor whose operating characteristics can be modified to a remarkable degree to implement a wide variety (perhaps entire families) of analog (i.e., linear) device functions and digital (i.e., switching) device functions.

Referring now to Figure 29A, a horizontal embodiment 150 of the ambipolar transistor of the present invention is shown. The transistor 150 is similar in appearance to certain planar thin film transistors known in the art. However, it should be noted that ohmic contact layers 46 and 52 are of different conductivity types, and that the transistor functions as an ambipolar device, rather than as a unipolar device.

Case 885

The ambipolar transistor 150 is formed by depositing a layer 48 of substantially intrinsic amorphous silicon alloy, such as a-Si:H with or without fluorine added as a density of states reducing element, upon an insulating substrate 42. Photolithographic techniques may then be used first to pattern an $n^+$ contact 46 and then a separate $p^+$ contact 52. This may be done by depositing and then patterning layers of $n^+$ and $p^+$ amorphous silicon alloys. After the ohmic contact layers 46 and 52 are formed, a layer of metal is deposited and patterned to form the electrical contacts 44 and 54. Then a layer 152 of gate insulating material is deposited and patterned to cover the gap between the contacts 44 and 54. Finally a layer of gate metal is deposited and patterned to form a gate 50.

Transistor 150 may be operated as a depletion mode FET or as an enhancement mode FET. When operated as a depletion mode device, the length of the conduction channel in layer 48 between ohmic contacts 44 and 54 is preferably made sufficiently small so that the channel is substantially conducting in the absence of a voltage applied to gate 50. In the depletion mode, the application of a suitable voltage to gate 50 directly repels the dominant charge carriers from the channel, which also tends to deplete the channel of charge carriers of the other polarity (i.e., the compensating charge carriers) due to the tendency toward space charge neutrality described above.

Case 885

Transistor 150 is preferably operated as an enhancement mode device. For such operation, the length and width of the conduction channel between the ohmic contacts 44 and 54 should be chosen as a suitable compromise between speed and the ease and cost of fabrication, which generally is a function of feature size. The channel is preferably substantially non-conducting in the absence of the application of a voltage to gate 50 that induces charge carriers of the dominant polarity in the channel region, even though an electric potential ($V_{AK}$) is applied between current path electrodes 44 and 54. When a suitable voltage is applied to gate 50, dominant carriers will be drawn from within the intrinsic layer 48 and from the current path electrode which readily injects such carriers toward the insulated gate, and will tend to accumulate predominantly in the intrinsic layer adjacent to the gate insulating layer 152, and will form a conduction channel therein. For example, if the intrinsic layer 48 is made of hydrogenated amorphous silicon alloy, and a positive voltage is applied to gate 50, an excess of electrons will be drawn toward the gate, forming a conduction channel, as in a conventional, horizontally formed n-channel MOSFET. In a conventional insulated gate FET (IGFET), which has substantially only charge carriers of one polarity, the depth of the conduction channel is limited by the self-screening effect of the induced charge carriers drawn into localized states and the conduction band in the channel by the applied gate voltage. The intensity of the screening field is dependent to the net charge density, which in conventional crystalline IGFETs is virtually equal to the majority charge carriers in the conduction band, and in amorphous IGFETs, is

-75-

Case 885

equal to the sum of the trapped and mobile majority charge carriers in the conduction channel. In the ambipolar devices of the present invention, however, the compensating charge carriers from one electrode tend to greatly neutralize the space charge created by the primary carriers from the other electrode, thus greatly reducing the electric field generated by the primary carriers. Our computer modeling shows that the strength of this gate induced field and the density of both types of charge carriers in general monotonically decreases in the channel region with increasing distance from the gate. Nevertheless, since the electric field induced by the applied gate voltage sees reduced space charge per unit volume in the intrinsic region, it extends to a greater depth in the intrinsic layer. Thus, the depth of the conduction channel in the ambipolar IGFETs of the present invention is at least few or several times greater than that of the unipolar insulated gate FETs, which allows substantially increased currents to flow.

In conventional horizontal IGFETs having an n-i-n structure wherein the i layer is composed of alloys of amorphous silicon, the depth of the conduction channel is very shallow due to the high charge density in the localized states. Alternatively stated, relatively high charge densities are experienced in such devices which limit channel depth. This is due in large part to the large number of electrons utilized in filling just some of the many traps in the band gap. These trapped electrons significantly contribute to the net space charge without contributing much to increased electron conduction. The accumulated space charge screens the

-76-

Case 885

gate-induced field over a short distance, so that substantially all of the current in such devices is constrained to flow in a very shallow region adjacent the insulated gate-intrinsic material interface. Moreover, although the overall depth of the band-bending region increases with increasing gate voltages, the effective channel depth of conventional a-Si IGFETs operating in an enhancement mode has been shown to decrease when higher gate voltages are applied. (The effective channel depth has sometimes been quantitively defined as the thickness of the portion of the channel region where 90% of the current flows.) As gate voltage is increased, apparently more of the traps are filled, thus leading to an even higher charge density. For very large gate voltages, the channel depth may be less than 100 angstroms. Shallow channel depth limits the current capabilities of these conventional unipolar FETs.

Since the ambipolar devices of the present invention have much greater channel depth, they can largely overcome the shallow channel depth problem of conventional a-Si FETs. Our calculations show that our first prototype DIFET, which is further described in conjunction with Figure 32, achieved a channel depth about four times thicker than an equivalent n-i-n IGFET would have. By fine turing the DIFET structures of the present invention to more closely balance the number of primary carriers with the number of compensating carriers, greater channel depth and increased transistor currents will undoubtedly be achieved. Some of the DIFET structures, such as the embodiments shown in Figures 36 through 39, have been designed with this goal in mind. In the limit, virtually the entire intrinsic region between the two current path electrodes may be filled with charge carriers of both types.

Case 885

Increased channel depth, however, only partially explains the increased current flow which is achievable by our ambipolar FETs. Our computer modeling also shows that the conduction channel of ambipolar devices of the present invention has a far higher number of majority charge carriers per unit volume than do unipolar FETs of either the n-i-n or p-i-p type. This may be explained by the fact that a slightly fewer number of minority or compensating charge carriers are also present in any given unit volume of the conduction channel, and they tend to neutralize the localized space charge created by the primary or majority carriers. Hence for any given net space charge density in an ambipolar system, the number of carriers contributing to conduction can be much greater than the number in an unipolar system.

Moreover, as described in the Shockley--Read--Hall recombination model, further developed for amorphous alloys by Simmons and Taylor, at $0^{\circ}K$ the probability of occupation by an electron of traps lying between the trap quasi-Fermi levels is less than unity, and hence any given amount of charge will fill more traps in an ambipolar system than in a unipolar system, where the occupation probability is unity below the Fermi level. Hence, for any given level of net space charge, it may be said that more of the traps are filled for an ambipolar system than in a unipolar system. Similar arguments apply for temperatures greater than temperatures greater than $0^{\circ}K$. For further details regarding the aforementioned recombination model for amorphous alloys, see the following article, G.W. Taylor and J.G. Simmons, Journal of Noncrystalline Solids, Vols. 8 to 10, p. 940 et. seq. (1972), which is hereby incorporated by reference.

-73-

Case 835

In a-Si unipolar FETs operated at sufficiently high gate field and source-drain voltages, the space charge residing in the localized states is the principal factor which limits mobile charge density, and therefore current density. The foregoing discussions show that ambipolar currents of the double injection transistors of the present invention provide a technique for overcoming the space charge limitations imposed by the localized states in a-Si FETs and in other types of unipolar FETs which have a relatively large density of trapped charge in the semiconductor material of the channel region.

In intrinsic crystalline silicon at $300^{\circ}K$ (i.e., room temperature), electron mobility is roughly in the range of 1300 to 1400 $cm^2$/V-s, while hole mobility is roughly in the range of 400 or to 500 $cm^2$/V-s. Thus, achieving relatively substantial currents in crystalline FETs in response to reasonably low applied source-drain and gate voltages has not been difficult. In FETs constructed of amorphous semiconductor materials, however, achieving substantial currents in response to relatively low source-drain and gate voltages has been difficult, and many scientists in the amorphous semiconductor materials field have long sought ways to achieve a field effect electron mobility as high as 1.0 $cm^2$/V-s. The achievement about a few years ago of an field effect electron mobility of about 1.0 for amorphous silicon, after almost a decade of research, by using fluorinated and hydrogenated amorphous silicon alloys to reduce the number of dangling bonds and other defects, is considered a major accomplishment. Research in this area continues. The ambipolar currents produced in the transis. FETs of the present invention do not alter the fundamental physical properties of such amorphous silicon

-79-

Case 885

alloys, yet they do effectively provide channel currents which would require electron band mobilities of at least five in conventional unipolar FETs, and quite possibly far higher. The ambipolar FETs of the present invention have high switching speeds. They turn on fast, since they have relatively high current. Also, a plentiful number of both holes and electrons are always present in the conduction channel of the FETs of the present invention, allowing them to be turned off very quickly, when the voltage applied to the gate electrode is removed, on account of carrier recombination in the channel. The large number of recombination centers in a-Si material helps reduce turn-off time. Turn-off time can be further improved by the use of a recombination layer as disclosed in the Figure 29B embodiment of the present invention, and possibly by the use of a second insulated gate to assist in obtaining complete turn-off as disclosed in the Figure 30 embodiments.

The increased current capability of ambipolar devices also leads to the faster charging and discharging the various device capacitances, which greatly improves switching speeds. Realistically, switching speeds of at least several tens of megahertz can be achieved by certain ambipolar amorphous silicon embodiments of the present invention, especially if the device geometry is optimized for speed by reducing device capacitances for example, and/or by alloying the intrinsic amorphous semiconductor material of the intrinsic layer using well-known techniques to optimize carrier lifetimes. Switching speeds of 100 MHz or more may be obtainable by the ambipolar transistor devices of the present invention, since research and development of the ambipolar devices of the present invention has just begun.

Case 885

The presence of relatively large currents in the conduction channel, as a result of a plentiful number of holes and electrons allows the ambipolar thin film FETs of the present invention to have channel lengths in the range of about five to about twenty microns or more, and still achieve switching speeds of at least several megahertz to several tens of megahertz. This is a substantial advantage, since it means that high performance ambipolar FETs can be fabricated using conventional five or ten micron photolithography, which is far less expensive than many techniques used to form smaller channel lengths and other micron- or submicron-sized device features. In very large area thin film transistor applications, such as active matrix displays which require extremely high yield over areas in excess of 100 mm by 100 mm, the use of conventional five or ten micron (or larger) photolithography should be very advantageous. Those in the art will also appreciate, however, that the DIFETs of the present invention can also be constructed with short channel lengths, (e.g., submicron to five microns) to drastically improve frequency response. Such short channel devices may be of the type disclosed herein with appropriately small feature sizes, or may be of the type already known in the art.

The DIFET 155 shown in Figure 29B is identical in construction to the DIFET 150 shown in Figure 29A, with one exception: it has an additional layer 148, which may be called a recombination layer, adjacent to and in intimate contact with layer 48. Layer 148 is comprised of a deposited semiconductor material having a far greater number of defect states, which trap electrons and holes, than does the material of layer 48.

Case 885

Suitable materials for layer 148 include pure amorphous silicon or an amorphous silicon alloy without any density of states reducing elements like hydrogen or fluorine. Layer 148 is positioned on the side of layer 48 opposite from the insulated gate 50, so that the traps in layer 148 do not significantly reduce or otherwise interfere with maximum current conduction when transistor 155 is turned on. Layer 48 is preferably made thick enough so that the electric field induced by the voltage applied to gate 50 is mostly or fully screened by the net accumulated charge that defines the depth of the conduction channel in layer 48 when the transistor 155 is fully on. For low gate voltages, such as under fifteen volts, a thickness for layer 48 in the range of 250 to 800 angstroms should be sufficient. Layer 148 may be 50 to 10,000 angstroms thick, and is preferably 100 to 300 angstroms thick.

In operation, layer 148 speeds up the turn-off time of DIFET 155 by providing recombination centers and traps for mobile electrons and holes extremely close to the conduction channel, which, as soon as the gate field is removed, tend to be drawn toward the anode and cathode respectively, or diffuse away from the interface between gate insulator 152 and layer 48. In the DIFET 155 shown in Figure 29B, excess electrons and holes initially in the channel of layer 48 when the gate 50 has just been turned off tend to typically travel somewhat perpendicularly to the channel length toward layer 148 on account of diffusion effects, which at least initially predominate over the applied field between anode 52 and cathode 46. Thus, the DIFET 155 may turn off up to an order of magnitude or more faster than the DIFET 150, which itself has a considerably faster turn off time than a similarly constructed unipolar FET whose excess charge carriers must be swept out of the channel to fully turn off the device.

Figure 30A shows a transistor 160 which, just like transistor 150 shown in Figure 29A, may be operated in an enhancement mode to turn it on. However, transistor 160 can be turned off harder (that is, have lower off current between current-carrying electrodes 46 and 52) than transistor 150 can, due to a second gate electrode 162. Gate 162 is preferably formed of a metal such as aluminum, molybdenum, chrome, or the like deposited upon insulating substrate 42. Like gate layer 50, gate layer 162 need only be thick enough, such as about 200 to 1,000 angstroms, to ensure there is no appreciable voltage drop within the gate layer itself during the operation of the transistor, especially when quickly changing the voltage applied to the gate. Gate 162 is shown disposed below and juxtaposed near the center portion 161 of the channel layer 48, and so that it is between and horizontally spaced apart from each of the current-carrying electrodes 46 and 52 so as to define spaces 163a and 163b respectively. Gate 162 may juxtapose or overlap less than fifty percent, and preferably less than twenty percent, of the channel length. Gate 162 extends tranversely across the entire channel width, preferably perpendicular to the channel length. Gate 162 is vertically spaced apart from and is insulated from the channel region layer 48 by a thin film layer 164 of insulating material, which is preferably deposited silicon oxide or nitride that may be annealed after deposition for improved dielectric strength. Layer 48 and the subsequent layers are then formed in the same manner used to make the of Figure 29A transistor.

Case 885

When the Figure 30A device is turned on, gate 162 is preferably allowed to float. In many of the applications presently contemplated for DIFETs such as transistors 150 and 160, the transistor will be turned off by removing the applied voltage from the gate 50 and allowing gate 50 to float, or by reducing the applied gate voltage to near zero volts, while the anode to cathode voltage remains applied. As is further explained elsewhere, this leaves the p-i-n diode formed respectively by layers 52, 43 and 46 forward biased, allowing some off current to flow even though the transistor is nominally off. This off current may be considerable, depending upon geometry of layer 48 and its conduction channel (e.g., short channel length) and the type of semiconductor material from which the body layer or body 48 is made (e.g., leakage current will be greater if doped crystalline, polycrystalline, or other relatively conductive semiconductor material is used for the channel body or region 48). To largely or completely eliminate such off current in transistor 160 shown in Figure 30A, a biasing voltage is applied to gate 162 which, depending upon its polarity and amplitude, will tend to repel one of the charge carriers injected into layer 48 by the current-carrying electrodes, or at least greatly slow their drift along the length of layer 43. For example, a bias voltage on gate 162 which is lower than the cathode voltage will repel electrons away from the central portion of the channel located adjacent to (i.e., above) gate 162. A bias voltage slightly above the cathode voltage will not necessarily stop all electrons from being injected into layer 48 at the n-i junction, but will greatly reduce their drift speed once in the layer 48, since there will only be a slight difference in potential between the cathode and the portion of the layer 48 adjacent to gate 162. As previously explained, any reduction in the number of charge carriers of one polarity entering layer 48 eventually results in a corresponding and almost equal reduction in charge carriers of the other polarity entering layer 48.

Those in the art should recognize that the transistor turn-off operation performed by gate 162 in transistor 160 utilizes the principles of operation associated with the VMITs discussed earlier herein. Accordingly, the relative size of the spaces 163a and 163b between gate 162 and each of the electrodes 46 and 52 may be varied to enhance the ability of gate 162 to help turn off. Specifically, the spacing between the gate and the current-carrying electrode which is reverse-biased or at about the same potential as the gate may be enlarged, while the spacing between the gate and other current carrying electrode is correspondingly reduced.

Figure 30B shows DIFET 165 which is constructed in a manner similar to and operates like the DIFET 160 in Figure 30A, but has an alternative arrangement for the second gate 162. In transistor 160, the second gate 162 is comprised of a plurality of electrode portions or elements 162a and 162b spaced horizontally apart from each other and from the cathode and anode electrodes 46 and 52. Like gate 162 in Figure 30A, gate portions 162a and 162b each preferably traverse the entire width of the conduction channel in layer 48, and are each in close proximity to the central portion of layer 48 and spaced apart therefrom by insulating layer 164. Like gate 162, the gate portions 162a and 162b may be formed by deposition of a

Case 885

layer of suitable conductive material such as a metal, which is then photolithographically or otherwise conventionally formed into separate elements.

By removing the biasing voltage applied to gate 50 to turn on transistor 165, the conduction channel of transistor 165 will turn off. By applying an appropriate voltage or voltages to gate portions 162a and 162b, the transistor 165 can be turned off more completely. As a first example, gate portions 162a and 162b are biased with the same voltage (which may be any voltage), the induced fields extending from the gate portions will cause the central section 161 of layer 148 above space 163c and above the gate portions to be electrically neutral, that is, no potential difference will exist in the section. Accordingly, charge carriers will move through the section 161 substantially only as a result of diffusion. This greatly reduces speed of the carriers through the section, and substantially increases the effective resistance of the section and, hence, of the overall layer 48. As a second example, the same voltage, which is either below or above the voltage applied to the cathode 46 or anode 52 respectively, is applied to gate portions 162a and 162b. Such a voltage will reverse bias at least a portion of the layer 48 with respect to one of the current-carrying electrodes. This bias will effectively prevent the injection of charge carriers at that junction, thus greatly reducing any off current between the current-carrying electrodes.

Case 885

Gate portions 162a and 162b may be constructed so that they are electrically connected to one another by a common longitudinal connecting member (not shown) which may be made of the same material and at the same time as the gate portions. This would be advantageous if the transistor is to be operated in the manner described in the two foregoing examples.

As a third example, gate portions 162a and 162b may be electrically isolated as shown in Figure 30B and different voltages applied tnereto to more completely turn off transistor 165. For instance, five volts and zero volts may be respectively applied to gate portions 162a and 162b. In the absence of an overriding voltage applied to gate 50, this will create a potential barrier which strongly inhibits the flow or diffusion of both electrons and holes through the central section 161 of layer 48, thus greatly reducing off current when transistor 165 has no voltage applied to its first gate 50. Those in the art will appreciate that the potential difference between gate portions 162a and 162b in this example may range, for example, from a few tenths of a volt to much greater than five volts.

Although the embodiments shown in Figures 29B through 30B are ambipolar FETs, those in the art will readily appreciate that the structures and operating principles of these devices may be readily adapted for use in unipolar FETs as well. Specifically, novel horizontal a-Si alloy IGFETs of the unipolar type may be readily constructed in the same basic configuration as the transistors shown in Figures 29B, 30A and 30B by simply changing layer 52 therein from $p^+$-type material to $n^+$-type material.

Case 885

The horizontal transistors 150, 155, 160 and 165 can be formed by the thin film deposition techniques described above with regard to the formation of the vertical transistor 40 shown in Figure 1. In these horizontal transistors, unless otherwise previously specified, the channel layer 48 is preferably 200 to 10,000 angstroms thick, the ohmic contact layers 46 and 52 are preferably 100 to 500 angstroms thick, the metal contact layers 44 and 54 are preferably 500 to 3000 angstroms thick, the insulating layer 152 is preferably 200 to 5000 angstroms thick, and the gate layer 50 is preferably 500 to 3000 angstroms thick.

Although the present invention can be built using horizontal structures, as Figures 29A through 30B show, it is believed that for a number of applications the use of vertical structures, such as those shown in Figures 1 through 28, will be preferred. This is because of the ease in fabricating short inter-electrode distances by means of vertical deposition techniques. Vertical embodiments of the present invention also have the advantage of making it easy to fabricate transistors having many conductive openings 51, enabling such transistors to handle much larger currents.

Figure 31 shows a horizontally formed ambipolar thin film transistor 170, which has a conductive gate layer 50 deposited upon an insulating substrate 42. An insulating gate layer 152 is next deposited or otherwise formed over gate 50. If desired, the insulating layer 152 may be annealed to reduce the number of its internal defects and improve its insulating properties, which allows the layer to be made thinner than would otherwise be possible. Next, amorphous semiconductor
layer 48 is deposited. Photolithographic techniques may then
be used to selectively deposit the n+ layer of contact 46 and
the p+ layer of contact 52, and the corresponding metal layers
44 and 54 respectively above them, in the locations shown in
Figure 31. The transistor structure 170 has reduced
capacitance between its gate 50 and its current-carrying
electrodes in comparison to transistor 150, and is simpler to
construct.

Transistor 170 helps illustrate that the horizontal
DIFETs and horizontal unipolar FETs of the present invention
may be configured in any number of ways. For example,
transistors 160 and 165 may, like transistor 170, be
constructed with gate 50 as the bottom layer and gate 162 as
the top layer of the device.

Transistors 150 through 170 all feature substantially
reduced inter-electrode capacitance since overlap between the
gate layer 50 and the two current path electrodes is
minimized. When these transistors are used as enhancement mode
FETs in applications where extremely high speed is not
required, it is preferred to utilize conduction channels having
a length of five or ten microns to a few tens of microns or
more, not only because such feature sizes are easily achieved
by inexpensive photolithographic techniques, but also because
of the higher effective resistivity of such channels when the
DIFET is in its off state. For low anode-cathode voltages, the
channel resistance of an ambipolar FET when off (e.g., no
voltage applied to the gate) is a function carrier injection in a forward-biased p-i-n diode, as discussed in the earlier-cited journal article by Hack, et al. Nevertheless, it is also dependent on the length of the channel, and inversely dependent the cross-sectional area of the channel. Thus, it may be readily appreciated that the off-state resistance may be varied by altering the device geometry. Alternatively, the channel may be doped to modify channel resistance and/or change carrier lifetimes. In conventional TFTs made with intrinsic a-Si:H channel material, channel lengths are often minimized to improve transconductance and to decrease turn-off times. The conductivity of the channel when the transistors are turned on with normal gate voltages is typically fairly low as previously mentioned (electron mobilities as high as about 1.0 $cm^2$/V-s). With the ambipolar TFTs of the present invention, however, channel lengths can be much longer, since the transconductance is substantially improved due to the ambipolar current in the channel, which also greatly decreases turn-off times due to carrier recombination as previously explained.

As is known in the art, it is beneficial if reduced operating gate voltages are desired, to keep insulating layer 152 as thin as possible, while still being thick enough to avoid tunneling or punch-through. As previously explained, the neutralization of space charge in ambipolar FETs on account of the second or minority carrier in the conduction channel allows substantially thicker conduction channels to be formed at any given gate voltage than was previously possible with unipolar insulated gate FETs operating in the enhancement mode. Accordingly, those in the art will appreciate that ambipolar FETs can be operated at gate voltages which are even further reduced in comparison to conventional unipolar insulated gate FETs.

Case 885

Figure 32 shows a simplified schematic diagram of a test circuit used to test a prototype FET 180 of the present invention, which is schematically illustrated therein in partial cross-section.  FET 180 is a four terminal device having two current-carrying aluminum electrodes 44 and 182 with $n^+$ ohmic contact layers 46 and 52 thereunder, one aluminum electrode 54 with $p^+$ ohmic contact layer 52 underneath, an intrinsic a-Si:H layer 48, a gate insulating layer 152 of silicon nitride, and a aluminum gate electrode 50.  FET 180 is constructed on a glass substrate (not shown).  The approximate thicknesses of the various layers are as follows:  gate 50 -- 1,000 angstroms; insulator 152 -- 2,000 angstroms; intrinsic layer 48 -- 5,000 angstroms; ohmic contact layers 46, 52 and 184 -- 500 angstroms; and metal electrode layers 44, 54 and 182 -- 1,000 angstroms.  Electrodes 44, 54 and 182 and the horizontal distance 185 separating them were photolithographically defined and formed.  The separation distances 185 and 187 between adjacent electrodes is about twenty microns, which is the approximate channel length between the $p^+$ electrode 52 and the $n^+$ electrode 46.  The channel length between the two $n^+$ electrodes 46 and 184 is about sixty microns, since it includes the the separation distance 187 as well as length of $p^+$ electrode 52, which is about twenty microns.  The width of the channels is about 1,000 microns, resulting in a W/L ratio of about 50 for the ambipolar p-i-n FET formed with $n^+$ electrode 46 and $p^+$ electrode 52, and a W/L ratio of about 16.7 for the unipolar n-i-n FET formed with $n^+$ electrodes 46 and 184.

Case 835

The test circuit for FET 180 included a conventional curve tracer having two variable voltage DC power supplies 136 and 138 for respectively supplying the applied gate voltage $V_G$ and the applied drain-source voltage $V_{DS}$ or the applied anode-cathode voltage $V_{AK}$. Two position switches 190 and 192, shown schematically and in their open position in Figure 32, permitted FET 180 to be operated either as a unipolar n-i-n FET by closing switch 190 and opening switch 192, or as an ambipolar p-i-n FET by opening switch 190 and closing switch 192. The direction of the travel for electrons and holes in both of these FETs within FET structure 180 is schematically snown is Figure 32, as is the relative position of the conduction channels in the two FETs.

The n-i-n FE⁻ of FET structure 180 produced the various $I_D$-$V_{DS}$ curves shown in Figure 33 at the gate voltages indicated therein. The p-i-n FET produced the various $I_A$-$V_{AK}$ curves shown in Figure 34 at the various gate and indicated therein. Our analysis of the data presented in Figures 33 and 34, which took geometrical and channel size differences irto account, indicates that the Figure 34 curves obtained with the ambipolar FET could only be obtained by an equivalently sized unipolar n-i-n a-Si:H FET which had field effect mobilities of about five. Alternatively, our analysis also indicates that such results could be achieved if the conduction channel in the ambipolar FET was about five times thicker than it would have been for an equivalently sized unipolar n-i-n a-Si:H FET. For reasons previously explained, it is likely that increased currents were achieved and accordingly the increase in actual channel depth would have

Case 885

been correspondingly less. Nevertheless we believe substantially increased channel depths were obtained in our prototype ambipolar FET in comparison to the unipolar n-i-n FET built and tested at the same time, as is suggested by the dotted lines 194 and dashed line 196 shown within the intrinsic layer 48 of FET structure 180, which respectively represent the possible boundaries of the conduction channels formed by operation of the aforementioned ambipolar and unipolar FETs of transistor structure 180.

Transistor 180 can be operated as a unipolar FET having a super-enhancement mode of operation characterized by ambipolar operation. To operate as a normal, unipolar FET, switch 190 is closed and switch 192 is opened. To operate in its super-enhancement mode, switch 190 is opened and switch 192 is closed. Alternatively, switch 190 could be continuously closed or eliminated by shorting electrical lead wires 197 or 198 together, and the normal and super-enhancement mode selected by opening and closing switch 192 respectively. When switches 190 and 192 are both closed, FET 180 operates as a four terminal DIFET.Tests on prototype FET 180 operating with both switches 190 and 192 closed at the same time shows that almost all of the current flows through the $n^+$ electrode 52 and almost none flows through the $p^+$ electrode 214.

Other embodiments of a four terminal DIFETs are illustrated in Figures 35 through 40. The following discussion describes how at least certain of these DIFETs can more readily achieve a closer balance between the number of holes and electrons in the conduction channel through various "carrier-balancing" techniques and configurations, which leads to higher current capabilities, light emission and even lasing.

0212328

Case 885

Figure 35A shows an alternate embodiment of the present invention which is similar to FET 180 in Figure 32. FET 210 has spaced apart $p^+$ electrodes 54 and 212 with ohmic contact layers 52 and 214 underneath, one aluminum electrode 44 with $n^+$ ohmic contact layer 46 underneath, and intrinsic layer 48 of amorphous semiconductor material such as a-Si:H, a gate insulator 152, and gate electrode 50. Separation distance 185 between $p^+$ electrode 52 and $n^+$ electrode 46 is substantially larger than the separation distance 187 between $n^+$ electrode 46 and $p^+$ electrode 214. Accordingly, large ambipolar currents are produced over a greater portion of the over-all device than occurs when FET 180 is operated a four terminal FET.

Figure 35B shows FET 215, which is quite similar to FET 210 in Figure 35A, except that the position of the cathode electrode 44 with $n^+$ ohmic contact 46 has been interchanged with the drain electrode 212 with $p^+$ ohmic contact 214. Given the same voltage on electrodes 46 and 214, arrangement should allow a greater number of holes in the conduction channel to enter the drain electrode than happens in the Figure 35A device, and help promote ambipolar current flow over the full channel length of layer 48. Since FETs 210 and 215 are also four terminal devices capable of either ambipolar or unipolar operation, they each can be operated in all of the modes associated as the Figure 32 device, as can the other four terminal FETs described below.

-94-

0212328

Yet another four terminal embodiment of the ambipolar transistor of the present invention is shown in Figure 36. The upper half of transistor 230 resembles a normal insulated gate field effect transistor with gate 50, gate insulator 152, and $n^+$ ohmic contacts 52 and 46 respectively connected to metal electrodes 54 and 44. The bottom half of transistor 230 is preferably formed on an insulating substrate (not shown), and consists of two distinct portions, the left portion being an insulating material 232 and the right portion being a conductive layer 234, such as a metal, upon which is deposited a layer of $p^+$ semiconductor material 236. (The insulating portion 232 merely serves to provide a planar surface upon which the next layer can be placed and could be omitted if desired.) The next layer 48 is doped or intrinsic semiconductor material, preferably a deposited substantially intrinsic amorphous silicon alloy. Once layer 48 has been deposited or otherwise formed, the layers above may be deposited or formed in a manner similar to the technique described with respect to Figure 29. Preferably conductive layer 234 is 500 to 3,000 angstroms thick. The ohmic contact layers 46, 52 and 236 need be no thicker than 500 angstroms, since any additional thickness will have no appreciable effect upon the ability of these ohmic contacts to efficiently inject charge carriers into the intrinsic layer 48.

The two current conducting electrodes 52 and 46 of transistor 230 made of the same type of heavily doped semiconductor material may be called the source S and the drain D, respectively. The source S may also be called the cathode K, since it is negatively biased with respect to the anode A

Case 895

The source and drain are spaced apart from one another and each is in electrical contact with a layer of substantially intrinsic amorphous semiconductor alloy into which a channel of charge carriers of a first polarity, such as electrons, is induced by an appropriate bias applied to the insulated metal gate electrode 50 and between the source and drain. The transistor 230 also includes a fourth electrode called the anode A (or sometimes the base) comprised of a metal layer 234 and a semiconductor layer 236 which is heavily doped with impurities of the type opposite of that from those of the source and drain electrodes, so that it tends to inject charge carriers of the opposite polarity from that of the source electrode 52. Charge carriers of a first polarity, namely electrons, are injected by the source S into the intrinsic layer 48, where they travel along the conduction channel to either the drain electrode 46, or the base electrode 236. Charge carriers of a second polarity, namely holes, are injected by the anode A into the intrinsic layer 48, and tend to migrate upward toward the charge carriers of opposite polarity in the conduction channel and horizontally toward the source S on account of the localized electrical fields produced by the negative space charge of the electrons resident in the conduction channel and the fields induced by the source-drain voltage and the anode-cathode voltage. Holes injected in this manner in an ambipolar transistor device 230 of the present invention in general tend to distribute themselves throughout the conduction channel, where they recombine with electrons at recombination centers within the intrinsic material. The recombination current is significant, and hence current conduction in the device is enhanced.

Case 885

With the p$^+$ electrode 236 (i.e., the anode A) out of the circuit, as is represented schematically by two position switch 240 being in its open position in the circuit of Figure 34, transistor 230 behaves as a standard planar n-i-n a-Si FET. As such, it has a channel 242 of very short depth as suggested by dashed line: 244 in Figure 36. With the anode A in the circuit of Figure 36, as would occur when switch 240 is moved to its closed position, the operation of transistor 230 does not change significantly with the gate off, but changes dramatically when the gate is on. With no voltage applied to the gate 50, the off current from the p$^+$ contact 236 will be relatively low, especially if the distance between anode and cathode is relatively large, such as 5 to 10 microns. When the gate 50 is turned on by application of a positive voltage, such as +10 volts, electrons initially tend to accumulate in the channel region indicated by dashed lines 242, but the holes drawn into the channel region from p$^+$ contact 236 neutralize almost all of this negative charge thus largely reducing self-screening field produced by the electrons within conduction channel 242, which allows the externally applied field of gate 50 to extend much further into the intrinsic layer 238, as previously explained. The increased number of electrons and holes in the material fills a substantial percentage of the traps in the intrinsic layer 238, thus allowing a substantial number of free carriers, i.e., electrons in the conduction band and holes in the valence band, to contribute to the channel current. The channel size also increases substantially since the neutralization of the space charge by the injected holes allows the electric field of the gate to project much further into the channel, as suggested by

Case 885

dotted lines 246 representing possible boundaries of the ambipolar channel. Modulation of current through the transistor is still possible due to the number of charge carriers of one polarity, namely electrons, being slightly greater than the number of charge carriers of the opposite polarity, namely holes.

Those in the art will appreciate that if transistor 230 succeeds in pushing the quasi-Fermi levels of the electrons closer to the conduction band, and also fills a very substantial number of the traps or defect states present in the intrinsic layer 48, that the transistor should exhibit electroluminescense. The wavelength of this electroluminescense can be altered by alloying the amorphous semiconductor material of layer 233 to vary the band gap. The band gaps for amorphous silicon alloys are about 1.7 eV which corresponds to wavelengths in the deep red range of the electromagnetic spectrum. The band gap may be widened with silicon alloys containing elements such as carbon, nitrogen or oxygen, or lowered with silicon alloys containing elements such as germanium, tin or boron. Additional detailed information about how to adjust the band gap of various amorphous semiconductor materials is given U.S. Patent No. 4,342,044 to Ovshinsky et al. (1982), which is hereby incorporated by reference, and other patents and publications from the photovoltaic arts. In light of the foregoing transistor 230 may be used as a light emission device in the same manner that an LED is. In Figure 36, light rays 248 are shown being emitted from side surface 247 of layer 48, which may be formed by etching through and removing a portion of layers 54, 52 and 48.

Case 885

To achieve maximum current in an ambipolar FET, it is highly desirable to adjust the densities of dominant and compensating charge carriers in layer 48, especially in the conduction channel, so as to achieve optimal space charge neutralization. This increases channel width and/or current density, which allows the gate-induced field to modulate the greatest possible number of carriers in layer 48. Figures 36, 37 and 38 disclose three exemplary ways to achieve such optimal space charge neutralization. Any technique employed to achieve such neutralization should preferably take in account the charge due to free carriers in layer 48, as well as the charge arising from any ionized dopants (if present) in layer 48, and the trapped charge (if any) which accumulates in the defect states (if any) of layer 48, during operation of the DIFET.

In FET 230 shown in Figure 36, optimal neutralization may be achieved by carefully selecting the amount of overlap 249 between the $p^+$ layer 234 of the base electrode, and the channel region 242. Increasing the amount of overlap 249 allows increased hole injection to take place. The number of holes injected into layer 48 of DIFET 230 is a function of the number of electrons injected at the source, which in turn is a function of gate bias and anode-cathode voltage for any given FET. The precise amount of overlap needed to obtain optimal balancing for a four terminal DIFET for a given size and a given range of operating voltages can be experimentally determined by testing overlaps of different sizes.

Figure 37 shows an alternate embodiment of the four terminal DIFET of the present invention arranged in a manner similar to DIFET 230 of Figure 36, except that the conductivity

Case 885

types of the current carrying electrodes have been reversed and
the amount of overlap 249 between the base electrode 236 and
the channel region 242 has been reduced. DIFET 255 represents
a preferred embodiment of the four terminal devices of the
present invention having layer 48 made of an amorphous silicon
alloy since electrons serve as the compensating carrier. In
a-Si FETs, this is desirable since electron band mobility
exceeds hole band mobility by four or five. The gate, when
biased to turn FET 230 on, generates an electric field which
acts directly upon the dominant carriers, namely holes, which
require the most assistance to achieve reasonably high field
effect mobilities.

Optimal neutralization is achieved in the Figure 37
device by regulating the charge carriers injected into layer 48
by base electrode 236. This can readily be accomplished by
regulating the voltage applied to the base electrode 236
relative to the voltage applied to the drain electrode 214.
Electron injection from the base 236 is at its maximum
practical level when the base and drain are at about the same
potential. Increasing the level of electron injection beyond
this maximum by substantially lowering the base voltage
relative to that of the drain is considered undesirable since
it would result in substantial forward biased diode current
between the drain and base not subject to control by the
applied gate voltage. Raising the voltage of the base 234
relative to that of the drain 214 reverse biases this diode,
preventing drain-base current flow. The voltage applied to the
base may come from the same power source supplying power to the
drain electrode. This voltage may be controlled, for example,

Case 885

by opening and closing switch 240 and/or varying the voltage by adjusting variable resistor 258. Alternately, it may be supplied from an independent controlled source of current or of voltage $V_A$ applied to terminal pad 259. The precise voltage differential required between the drain and base electrodes for any given four terminal FET such as FET 280 may be readily determined by testing.

Figure 38 shows another four terminal FET 260 which is configured very similarly to FET 215 in Figure 35B, and can be operated in the same manner. Achievement of optimal neutralization may be aided in FET 260 by carefully selecting the effective surface areas of $p^+$ electrode layer 52 and $n^+$ electrode layer 46 in intimate electrical contact with active semiconductor layer 48 to provide the correct ratio of holes and electrons to layer 48 for a given anode-cathode voltage when FET 260 is turned on by a suitable gate voltage. Increasing the effective area of an electrode enables it to inject more of its specie of charge carriers into layer 48, although we expect that this relationship is nonlinear. In FET 260, the effective area of the $n^+$ electrode layer 46 should be the amount of area in the overlap 262 between the layers 46 and 48. The effective area of the $p^+$ electrode should be the amount of the area in the overlap 264 between layers 48 and 52. For any given semiconductor material-injector material combination forming the interface between layer 52 (or layer 46) and layer 48, carrier injection efficiency, i.e., the number of carriers per unit area at a given bias applied to the interface, can be readily determined experimentally. The effective areas of the two interfaces can then be selected (or experimentally determined) to optimize space charge neutralization at the desired operating voltages of the FET.

Case 885

Note that in the Figure 38 device, as the space charge becomes more closely balanced, fewer carriers should leave layer 48 by entering the $p^+$ drain electrode layer 214. This is because it is much easier for holes to recombine in layer 48 than it is to be collected by the contact layer 214. Also, as the space charge neutralization approaches its optimized condition, more traps should fill and radiative recombination should account for a higher proportion of the overall carrier recombination. Thus, DIFET 260 may emit appreciable amounts of light. Other DIFETs of the present invention which are suitably constructed and employ optimized neutralization may be made to emit light as well, as is illustrated by the next Figure.

Figure 39 shows an a-Si alloy three terminal FET 270 constructed with different sized $p^+$ electrodes and $n^+$ electrodes to assist in optimized neutralization by the matching of effective areas of electrodes as just described. The FET 270 may be constructed in the same basic manner as FET 170 of Figure 31, but with an additional set of photoresist deposition, patterning and development steps to create vertical outer sides 271 and 274 along layers 44, 46, 48 and 52 as shown, and to create vertical inner sides 272 and 273 respectively along layers 52 and 54 and layers 44 and 46. The horizontal distance between sides 271 and 272 serves to define one dimension of the effective area of $p^+$ layer 52, and the horizontal distance between sides 273 and 274 serves to define one dimension of the effective area of the $n^+$ layer 46. If DIFET 270 is rectilinearly designed, as is customary for integrated circuit devices, the ratio of distances 262 and 264 should define the ratio of effective areas of layers 46 and 52.

Layer 48 of the Figure 39 device may be comprised of a plurality of sublayers 48d and 48e as shown. Sublayer 48e, it will be noted, is separated from gate insulator 152 by sublayer 48d. Alternatively, layer 48 may be comprised of a single layer of semiconductor material. In the former case, each of the sublayers has a band gap distinct from the other to allow DIFET 270 to selectively emit radiation (e.g., visible light) at two or more wavelengths. The wavelength of the emitted light may be less than the band gap, particularly in amorphous materials where substantial numbers of the defect states remain unfilled. Layer 48d, for example, may be made of substantially intrinsic amorphous silicon alloy which has a band gap of 1.7 eV (corresponding to an emission wavelength of about 7300 angstroms, or more). Layer 48e, for example, may be made of substantially intrinsic amorphous silicon alloy with significant amounts of carbon added, so as to produce a band gap greater than 1.7 eV, for example, 2.5 eV (corresponding to an emission wavelength of about 5000 angstroms, or more). In operation, the width of the space charge region of DIFET 270 increases as gate voltage is increased. Thus, the spectrum of the optical output of DIFET 270 may be varied by appropriately varying the applied gate voltage as follows. The FET 270 is driven at a selected first gate voltage to produce emissions which are largely at one wavelength due to carrier recombination in layer 48d, and is driven at a second larger gate voltage to produce emissions at both wavelengths due to carrier recombination in both of layers 48d and 48e. The former result is achieved when the thickness of the band bending region extends into layer 48d, and the latter result is achieved when the thickness of the band bending region extends fully across layer 48d and a substantial distance into layer 48e.

Case 885

A DIFET having a single homogeneous layer 48, as mentioned in the latter case above, may also be made to emit light at different frequencies by varying the gate voltage. Specifically, the frequency of light emissions produced by a DIFET may be modulated between two or more distinguishable frequencies (or narrow bands of frequencies) which are reasonably close to one another by modulating the gate voltage so as to alter the energy difference between the electron and hole quasi-Fermi levels, whether this be when they lie in defect states which are partially unfilled or in the extended states. If the quasi-Fermi levels do lie in the extended states, increasing gate voltage will push them further into these extended states.

The amplitude or intensity of light emissions of a DIFET can also be varied by varying the gate voltage. Also, the amplitude and even the frequency of the light emissions can be varied by modulating the applied anode-cathode voltage, since this will also influence current in the DIFET. However, this latter technique likely involves modulating far more electrical power than does varying the gate voltage, and hence is not deemed to be as desirable a method.

The light produced may exit from DIFET 270 through the upper horizontal surface 269 between electrodes 46 and 52. Exterior sides 271 and 274 will not provide an exit for the light if metal 54 and 44 is made thick enough to substantially block or reflect such emissions. A suitably thick layer of reflective material may be used to block light from escaping from other surfaces, if desired. The light may also be made to

Case 885

exit from the bottom of DIFET 270 by forming gate layer 50 from a transparent conductive material such as indium tin oxide or tin oxide, and utilizing a transparent material, such as glass, for substrate 42.

Figure 40A illustrates a three terminal FET 275 of the present invention which has a resonant optical cavity and forms a solid-state semiconductor laser from amorphous semiconductor material, preferably an amorphous silicon alloy. This DIFET laser 275 may be constructed in a manner similar to that of FET 270 of Figure 39, with the addition of top insulating layer 276 over the most of the device and of top metal layer 277 in the center of the device as shown.

It is well-known to those skilled in the art of solid-state lasers that the fundamental light-producing mechanism in the semiconductor of a solid-state laser is the direct recombination of conduction-band electrons and valence-band holes. In a suitable Fabry-Parot optical cavity, the lasing threshold is reached when a light pulse can make a round trip in the cavity without attentuation, which satisfies the following formula:

$$R_2 R_1 \exp[(g-a)2W] = 1 \quad , \text{ where}$$

$R_1$, $R_2$ = the reflectances at the cavity ends,

$g$ = gain per unit length,

$a$ = absorption per unit length, and

$W$ = cavity width.

Case 885

Cavity thickness, i.e., the thickness of layer 48, is preferably as close as possible to being an even multiple of one-quarter of the wavelength of the photons to be emitted to reduce optical losses. As is well known in the amorphous silicon device art, thickness of individual layers within a multi-layered structure made of deposited amorphous materials may be controlled with precision. By having selected layers in DIFET 275 comprised of different materials, optically significant changes in indexes of refraction between these layers can be obtained, thereby forming a optical cavity with the substantial internal reflection required in a semiconductor laser. The channel length, the channel width and the thickness of one or more selected layers in DIFET 275 may be chosen so as to form a suitable resonant optical cavity. In one arrangement, semiconductor layer 48 may be one-half or one wavelength thick. The interfaces between semiconductor layer 48 and insulator layers 152 and 256 form one set of spaced planar cavity surfaces. The side surfaces 271 and 274 form another possible set of planar cavity surfaces, and the front and rear surfaces 278 and 281 form yet another possible set of planar cavity surfaces. If the reflectance of the interfaces at these various surfaces are sufficiently high, this optical cavity by itself may be suitable to produce lasing action in DIFET 275.

If an optical cavity having an even higher amount of internal reflectance is desired, insulating layers 152 and 276 may be made of a material substantially transparent to the wavelength of the coherent light to be produced, so that a second set of planar reflective cavity surfaces may be formed

Case 885

between the interfaces of these insulating layers and metal gate layer 50 and metal cover layer 277. Any suitable insulating material known to those in the semiconductor laser art may be used. Silicon nitride, silicon oxide, or a high dielectric constant insulator, such as tantalum oxide, may be satisfactory. Layers 152 and 276 may be made of different materials. The processing temperatures of the material selected for layer 276 should not be so high as to damage the electronic or optical properties of layer 48. Figure 40B is an enlarged view of a portion of FET 275 showing one such preferred arrangement of the relative thicknesses of the layers in the device as a function of the wavelength of the coherent lignt to be produced. Note that the thickness of the ohmic contact layers 46 and 52 may also be controlled in a similar fashion to form partial interfaces with metal layers 44 and 52. In another preferred arrangement of tne type illustrated in Figure 40B, layer 48 is one-half wavelength thick. Other arrangements which space apart the various sets of reflecting surfaces of the optical cavity by an even multiple of one-quarter of the wavelength may also be used.

In laser configurations of the type illustrated in Figure 40B, layers 50 and 277 are preferably made of a metal having a high reflectivity at the wavelength of the laser light. If semiconductor layer 48 is formed of an amorphous silicon alloy, for example, silver, copper, gold, chromium or aluminum may be satisfactory for use as a high reflectivity material for layers 50 and 277. A high reflectivity metal also preferably covers the vertical side surfaces 271 and 274, which form the sides of the optical cavity. The vertical surface 281

Case 885

forming the rear end of the optical cavity is also preferably covered with a reflective insulating material, or otherwise prepared in any suitable or conventional manner to form a substantially reflective end that does not short the anode to cathode. The vertical surface 273 forming the front end of the optical cavity is preferably partially reflecting to increase lasing action between the two cavity ends. This may also be accomplished by using an insulating material or in any conventional or suitable manner. As shown in Figure 40A, metal layers 52 and 54 may be formed so as to provide the aforementioned reflective covering for side surfaces 271 and 274. The increased internal reflection provided by an optical cavity having plural sets of reflective cavity ends and reflective side and rear surfaces as just described makes it easier to achieve lasing action at a lower input power.

DIFET 275, it will be recalled, has optimal neutralization for maximum current handling capabilities. If the such neutralization proves too difficult to achieve or maintain in practice by matching effective areas of electrodes 46 and 52, then neutralization by use of a base electrode as taught in the embodiments of Figure 36 or 37 may be employed in its stead in the DIFET laser of the present invention. If DIFET 275 is driven hard enough, enough of the defect states in the a-Si alloy semiconductor material of layer 48 should be filled to push the quasi-Fermi levels of electrons and holes into the conduction and valence bands respectively, and to permit significant levels of direct recombination to occur, since the defect states or traps should be substantially filled, thereby producing photon emissions. At this point, given optical cavity surfaces and ends which are sufficiently reflective, lasing threshold will be reached, and coherent light emission will take place. Since layers 50 and 277 largely block the light and since the side and rear surfaces are preferably made substantially reflective, most of the coherent light will be emitted from the vertical front surface 278 of layer 48, as indicated by broad arrow 279. To maximize lasing action in the direction of the major axis 282 of the DIFET 275, which extends between the front and rear cavity ends, it it is preferable to use relatively large W/L channel ratios. By reducing the channel length in DIFET 275 to a few microns or less, increased currents are possible, which should permit DIFET 275 to achieve coherent light emission at lower power levels. Both pulsed and continuous wave (CW) operation is contemplated for the laser DIFETs of the present invention. CW operation will likely require some form of heat dissipation or cooling. This can be provided in any number of ways using techniques well known to those in the semiconductor laser art.

As previously mentioned with respect to Figure 39, it is possible to modulate the amplitude and frequency of the optical output of the light emitting DIFETs of the present invention by modulating the applied gate voltage or by modulating the voltage between the current-carrying electrodes. These modulation techniques can also be used in the DIFET lasers of the present invention. For example, since the optical cavities described above will support resonance at selected frequencies within a relatively narrow band of frequencies about the nominal resonant frequency of the cavity, frequency modulation of the DIFET laser is possible.

Accordingly, both the light emitting and lasing DIFETs of the present invention may be used to transmit information by modulating optical amplitude or frequency through changes in gate voltage. Since only the gate drive is being modulated, a relatively large power amplifier or switch is not required. Moreover, those in the art should appreciate that, if desired, the light emitting and lasing DIFETs of the present invention may be switched between an off state and an on state by suitable variations of the applied gate voltage. In other words, a relatively low power gate signal can control the optical output of a DIFET. This is made possible by the large power gain inherent in the DIFETs of the present invention, and represents an important advantage over two terminal light emitting diodes and lasers wherein the main drive power must be switched off and on by a separate active power element. Such optical modulation by varying gate voltage may be carried out at rates of several tens or several hundreds of megahertz, which makes the light emitting and lasing DIFETs of the present invention very valuable in communications and computer applications and in other applications as well.

Figures 29 through 40 have shown various horizontal embodiments of the DIFET of the present invention which are operated chiefly in the enhancement mode. Figure 43 shows a vertical embodiment of an enhancement mode DIFET. DIFET 285 in Figure 43 may be constructed using the process steps similar to those used to contruct transistor 80a of Figure 19B. DIFET 285 includes: a substrate 42; a bottom electrode comprised of metal layer 44 and $n^+$-type a-Si ohmic contact layer 46; metal gate layer 50 surrounded by insulating material in the form of bottom insulating layer 62, side insulating layers 152a and 152b, and top insulating layer 64; and a top electrode comprised of ohmic contact layer 52 made of $p^+$-type a-Si ohmic contact layer and metal layer 54. DIFET 285 also includes at least one opening 51p which extends between the top and bottom electrodes and through gate 50 and gate insulating layers 62 and 64. The opening 51p is filled with a substantially intrinsic a-Si semiconductor material 48 which forms the current path between the top and bottom electrodes. As explained with respect to other vertical embodiments of the present invention, the thickness of the various layers of DIFET 285 may be varied so as to suit different operating voltages. For example, exemplary thicknesses of the various layers of the DIFET 285 may be as follows: metal layers 44 and 54 -- 300 to 1,500 angstroms; ohmic contact layer 46 and 52 -- 500 to 1,500 angstroms; top, side and bottom insulation layers 62 and 64 -- 300 to 1,000 angstroms; metal gate layer 50 -- 4,000 to 20,000 angstroms. The average size of opening 51p between insulating layers 152a and 152b as shown may be about one-half micron to several microns.

To construct DIFET 285, layers 44, 46, 62, 50 and 64 may be initially deposited as continuous layers, i.e., without an opening in them. Then, photoresist may be deposited on top of layer 64, and patterned and developed so as to leave an opening corresponding in size to the bottom of opening 51p shown in Figure 43. Thereafter, the structure may be subjected to a plasma etch to create opening 51p and shape layers 64, 50 and 62 as shown in Figure 43. Ion milling could also be used. (The V-shape of opening 51p is due to the underetching of the photoresist mask which normally will occur as the relatively thick layer 50 is etched away to form the opening.) Then, after the photoresist is stripped away, insulating layers 152a and 152b are deposited as shown. If excess material from this insulation deposition step is in region 46a, it may be removed by using a directional reactive ion etching, which will remove the excess material from region 46a without removing too much of gate insulating layer 152a and 152b. Intrinsic layer 48 and the $p^+$ ohmic contact layer 52 are deposited next. Thereafter the resulting structure may be leveled, if desired, by etching or ion milling to remove the intrinsic material from the top of layer 64, as well as any excess insulating material which may be there from the deposition of insulation layers 152a and 152b. Finally the layer 52 and metal layer 54 may thereafter be deposited, thus completing construction of DIFET 285.

The forward-biased diode current between the anode 54 and cathode 44 of DIFET 285 may be enhanced or reduced, depending upon the applied gate voltage. To operate DIFET 285 in the enhancement mode, cathode 44 may be grounded and anode 54 may be biased at several volts while a sufficiently positive voltage is applied to gate 50. This creates substantially vertical conduction channels 242a and 242b in intrinsic layer 48 which extend substantially between the $p^+$ electrode 52 and the $n^+$ electrode 46. The outer boundaries of conduction channels 242a and 242b are schematically indicated respectively by dashed lines 244a and 244b. Ohmic contact layers 46 and 52 each have an accumulation region containing a high density of charge carriers of its respective conductivity type within an accumulation region that extends outwardly therefrom. For example, the $p^+$ electrode layer 52 has an accumulation region 52a containing excess holes which extend outwardly into intrinsic layer 48 at least about 1,000 angstroms as indicated by dotted line 52b. Similarly, $n^+$ electrode layer 46 has an accumulation region 46a extending outwardly at least 1,000 angstroms as indicated by dotted line 46b. The conduction channels 242a and 242b extend into the accumulation regions 46a and 52a, thus ensuring that the charge carriers traveling along the conduction channels do not encounter a region of relatively high resistance within intrinsic layer 48. Accordingly, the over-all conductivity of each conduction channel is very high.

DIFET 285 is able to operate at very high current densities and very high switching rates because of its short channel length and its enhancement mode operation. Armed with the teachings of the present invention, especially those relating to vertical transistor structures, those skilled in the art should be able to readily engineer and construct other enhancement mode vertical DIFET structures falling within the scope of the present invention.

Although the ambipolar embodiments of the transistor of the invention have been generally described above as having the layers 46 and 52 being formed of $n^+$ and $p^+$ semiconductor material respectively, those in the art will appreciate that layers 46 and 52 in many embodiments could be made of $p^+$ and $n^+$ semiconductor material without changing the basic behavior or performance of these embodiments. In the same vein, various embodiments, such as transistors 95, 100, 110, 130 and 140, which were generally described above as

-113-

ambipolar, may be made in a unipolar version by having the ohmic contact layers 46 and 52 be made of material having the same conductivity type. In the unipolar embodiments of such transistors (e.g., those used for logic gates), the same general combination of gate electrodes placed between current path electrodes can be used, but the relative position of the gate electrodes between the current path electrodes, the spacing between gate electrodes and the voltages applied to the gate and current path electrodes should be tailored to compensate for the difference in operating characteristics between the unipolar and ambipolar transistors of the present invention. Other possible variations will be readily apparent to those skilled in the art. For example, in most of the various VMIT embodiments of the invention, those gate layers shown as uninsulated may be insulated in a manner similar to that shown in Figures 15 and 18.

The present invention has been described herein with reference to thin film transistor devices formed with semiconductor regions or layers made from amorphous materials such as amorphous silicon alloys. However, semiconductors materials other than amorphous silicon alloys may also be used. Those in the art will readily appreciate the suitability of the present invention for TFTs formed using any suitable substantially microcrystalline, substantially polycrystalline or other thin film semiconductor materials as well. These semiconductor materials, as well as the insulating layers and metal gate and electrode layers, may be deposited by techniques including, by way of illustration but not limitation, glow discharge deposition, chemical vapor deposition, sputtering, evaporation, ion plating, or the like.

-114-

Those in the art will also recognize the applicability of the novel transistor structures and operating principles disclosed herein to make novel crystalline transistor devices of the type epitaxially grown or otherwise constructed from or on a monolithic crystalline substrate. By applying the teaching of the present disclosure, such individuals could readily to modify conventional crystalline FETs so as to utilize the novel structures and operating principles of the present invention. S.M. Sze, PHYSICS OF SEMICONDUCTOR DEVICES, (2d Ed. 1981), at pages 431-496 discusses some conventional crystalline MOSFETs, including a few with short channel length, which could be so modified. Pages 312-358 therein describe some conventional crystalline JFETs and MESFETs which could be so modified. The cited portions of the Sze treatise are hereby incorporated by reference. In many instances, the only structural modification required to convert a conventional FET into an ambipolar FET of the general type disclosed herein is the changing of one of the current carrying electrodes in such a conventional FET to a semiconductor material of the opposite conductivity type.

Figures 41A through 42B provide a brief illustration of the applicability of the present invention to crystalline FET devices. Figure 41A shows an insulated gate field effect transistor of present invention constructed on any suitable single crystal substrate 282. The crystal of substrate 282 in Figure 41A is preferably epitaxially grown from a reasonably pure or substantially intrinsic (that is, undoped) semiconductor material such as silicon. Alternatively, substrate 282 may be formed from doped crystalline material as

-115-

Case 885

long as suitable precautions or steps well-known in the art are taken to minimize leakage current between electrodes and the substrate. The substrate 282 is covered by a thin (such as 1,000 to 2,000 angstroms) insulating film 284, such as silicon dioxide or silicon nitride, which has openings 286 and 288 therein to respectively allow drain electrode 290 to ohmically contact a $p^+$ diffusion region 292, and source electrode 294 to ohmically contact an $n^+$ region 296. Insulating layer 284 electrically isolates gate electrode 298 from the $p^+$ region 292, the $n^+$ diffusion region 296, and an conduction region 300 of substantially intrinsic semiconductor material located between the $p^+$ and $n^+$ regions. Preferably, region 300 is simply an undoped portion of substrate 282 between diffusion regions 292 and 296. The $p^+$ region 292 and the drain electrode 290 respectively correspond to the $p^+$ layer 52 and metal layer 54 of transistor 150 in Figure 29A. The $n^+$ diffusion region 296 and source electrode 294 of transistor 280 correspond to the $n^+$ layer 46 and metal source electrode 44 of transistor 150. The conduction channel or region 300 of transistor 280 corresponds in function to the amorphous semiconductor layer 43 of transistor 150, in that the conduction channel is located therein.

The ambipolar transistor 305 of Figure 41B is constructed just like transistor 280 of Figure 41A, except that the conduction region 306 is doped with donor or n-type impurities to promote conduction of electrons in the conduction channel. In practice, the amount of doping should be substantially lighter than the $n^+$ or $p^+$ regions. The optimal doping level may vary depending on device geometry and the desired threshold voltage. Preferably, channel region 306 is formed with a lightly doped n-type semiconductor, which those in the art sometimes refer to as $n^-$-type or nu-type semiconductor. Since channel 306 is formed with such donor material, transistor 305 functions best as an ambipolar n-channel MOSFET. In other words, the best current flow is achieved when a positive bias is applied to gate electrode 198 to draw excess electrons into channel 306 during operation of transistor 205.

Figure 41C shows an alternative crystalline embodiment of the present invention which is substantially identical to transistor 280 in Figure 41A, except that its conduction region 312 is formed of intrinsic material doped with acceptor or p-type impurities to promote the conduction of holes in the conduction channel. Preferably channel region 312 is acceptor or formed with a lightly doped p-type semiconductor material is sometimes called a $p^-$-type or pi-type semiconductor. The optimal majority carriers for ambipolar transistor 310 are holes, rather than electrons. Holes may be drawn towards the gate to form a channel by placing a negative bias on gate 198.

In operation, transistors 280, 305 and 310 will each exhibit ambipolar current flow. Nevertheless, the presence of charge carriers of both types in each conduction channel increases the current density and channel depth in comparison to that which would be achieved by equivalent voltages applied to conventional crystalline, unipolar insulated gate transistor of similar size and geometry.

Case 885

In a conventional p-channel enhancement mode MOSFET, the channel region is typically formed of a lightly doped n-type material and the drain and source diffusion regions are formed of $p^+$-type material. Similarly, in a conventional n-channel enhancement mode MOSFET, the channel region is typically formed of a lightly doped p-type material, and source and drain diffusion regions are typically formed of $n^+$-type material. Extremely high channel resistances are thus achieved when such MOSFETs are off, since one of the junctions between the channel and diffusion regions is reverse-biased. Since the conduction region 300 in DIFET 280 is made of intrinsic crystalline material, it has a reasonably high resistance when gate 298 and the channel length is not too short. In contrast, the crystalline DIFETs shown in Figures 41B and 41C are doped with impurities which are of the same type as the polarity of the dominant carrier. In this regard, they are similar to depletion mode MOSFETs, which typically have a channel diffused between the source and the drain with the same type of impurity as used for the source and drain diffusion regions. Thus, no reverse-biased junction exists to help shut off current between the two current-carrying electrodes. If the level of doping is high and the channel length is relatively short, these transistors may not have a suitably low off current. The off current in a transistor having the same channel length and a nu-type or pi-type channel region (in the absence of an applied gate voltage) may, however, have a sufficiently low off current due to increased resistivity on account of lighter doping. By limiting the amount of doping in the nu-type channel of transistor 205 or the pi-type channel of transistor 210, then, reasonable off

Case 885

currents can be achieved in these transistors in the absence of an applied gate voltage given a suitably long channel length. Preferably, however, the channels in these transistors are turned off by applying a bias to their gate which creates a field that tends to force the dominant carriers out of the channel region, thereby substantially reducing the number of dominant carriers which would otherwise be in the channel region as drift current. As previously mentioned, reducing the number of dominant carriers also tends to reduce the number of compensating carriers. The bias voltage should not be so great, however, as to create a conduction channel composed primarily of carriers of the opposite polarity.

The transistors of Figure 41A through 41C can be formed using fabrication techniques well known in the crystalline art. Briefly, one such techinque, suitable for constructing transistor 280, involves: (1) growing an intrinsic substrate (e.g., 5 to 25 microns thick) upon a crystalline wafer; (2) growing a thin layer of insulating material over the entire wafer; (3) removing the insulating layer at the opening 286 by means of a photolithographic etching process and subjecting the opening to isolation diffusion to cause p-type impurities to penetrate the i-type epitaxial layer through the opening, thereby forming p+ region 292; (4) after removing the remaining portions of the insulating layer, forming a new insulating layer, forming opening 288 via photolithographic techniques, and diffusing n-type impurities through the opening into intrinsic layer 282 to create $n^+$ region 296; (5) removing the remaining insulating material, forming a new layer of insulating material, photolithographically forming a set of

-119-

windows corresponding to openings 286 and 288 where the ohmic contact is to be made between the doped region and metal electrodes; and (6) vacuum depositing a thin coating of aluminum over the entire wafer, and thereafter using the photoresist technique to etch away all undesired aluminum areas, leaving the desired pattern of aluminum in the form of drain electrode 290, source electrode 294 and gate electrode 298.

To form the transistor 305 of Figure 41B, the same basic procedure just outlined may be used, but modified in the following manner. Prior to step (3), the insulating material may be masked and etched to create an opening above the areas where ohmic contact layers 296 and 298 and the n-type or nu-type channel region 306 are to be located. Then, through this opening, the substrate 282 may be lightly doped with n-type impurities to form an extra long nu-type channel region. Processing may then continue with step (3) above. Those in the art will appreciate the heavily doped diffusion regions 292 and 296 thereafter formed will completely dominate or mask the effects of the deposited n-type or nu-type layer within regions 292 and 296, thus restoring channel 306 to the desired length schematically shown in Figure 42B.

Those in the art will appreciate that transistor 310 of Figure 41C can be made in a manner analogous to that used for making transistor 305. Of course, more up-to-date techniques for integrated circuit manufacture may be used as well to form the monolithic transistor devices shown in Figure 41A through 41C.

A wide number of conventional FET structures (whether
amorphous, polycrystalline, crystalline, etc.) may be easily
modified so as to operate an ambipolar FETs or DIFETs of the
present invention, as previously explained. One such example
is provided in Figure 42. Figure 42A is a cross-sectional view
of two crystalline transistors or DIFETs of the present
invention arranged as a complimentary MOS inverter 320, as is
schematically illustrated in Figure 42B. Figure 42B, it should
be noted, features two modified MOSFET circuit symbols, each
with two arrows instead the usual one to signify the ambipolar
current flow in our new type of FET, the DIFET. The full arrow
in each symbol represents a diodic semiconductor junction
formed between p-type and n-type semiconductor materials, and
the half arrow in each symbol represents an ohmic semiconductor
junction between $n^+$ and $n^-$ semiconductor materials, or $p^+$
and $p^-$ semiconductor materials. It is well known that CMOS
devices reduce power dissipation to very small levels by using
complimentary p-channel and n-channel enhancement MOS
transistors on the same chip. Transistor $Q_1$ shown in Figure
42A is the p-channel device, and transistor $Q_2$ is the
n-channel device. In inverter 320, the cathode $K_1$ and anode
$A_2$ are tied together and the gates $G_1$ and $G_2$ are
connected together. The two transistors $Q_1$ and $Q_2$ are in
series with only one of them being turned on at a time, when
either a logical one or logical zero is presented at the
combined gate terminal G. Since in either logic state, one of
the transistors is off, the quiescent power dissipation for
this inverter 320 is the product of the off-leakage current and
the power supply voltage $(-V_{DD})$ applied to cathode electrode
$K_2$. Those in the art will appreciate that more complicated

-121-

Case 835

digital circuits such as NOR gates, NAND gates, and flip-flops, can be formed by combining simple inverter circuits of the type shown in Figure 42B.

As can be appreciated by those skilled in the art, the present invention can be practiced otherwise than as specifically disclosed herein. For example, those skilled in the art will readily be able to design and construct additional DIFET and VMIT structures, including logic gates, using logical and straight-forward combinations of selected features from various embodiments of the present invention. Therefore, it is to be understood that within the scope of the appended claims the invention can be practiced otherwise than has been specifically described above.

0416r

CLAIMS:

1. A solid-state electronic device (40b;60,70;80;90;150;155;160;165;170;210;215;230;255; 260;270;275;280;285;305;310), comprising:

first and second electrodes (46,52; and

a body of semiconductor material (48;300;306;312) arranged to form a current path between said first and second electrodes;

means for ambipolar carrier injection (46,52;292,296) into said current path in response to an externally applied voltage, characterized by:

electric field means (50;298) for exerting an electric field substantially along the length of said current path to increase the ambipolar current flow in said current path, said exerted electric field being distinct from the electric field induced by said applied voltage.

2. An electronic device as described in claim 1 wherein said semiconductor material is either substantially intrinsic or is doped.

3. An electronic device as described in claim 1, wherein said semiconductor material is selected from a group of semiconductor materials consisting of crystalline semiconductor material, substantially polycrystalline semiconductor material, substantially microcrystalline semiconductor material, and substantially amorphous semiconductor material.

4. An electronic device as described in claim 9 wherein said semiconductor material is an amorphous alloy of silicon.

5. An electronic device as described in claim 1 wherein said electric field means includes at least one control electrode (50;298) adapted to receive an applied control voltage, said control electrode extending substantially along the length of and being in close proximity to said current path.

6. An electronic device as described in claim 1 further characterized by said electric field means including barrier means (62,64) for minimizing leakage current between said control electrode and said current path.

7. An electronic device as described in claim 6, wherein said barrier means is selected from the group of electronic barriers consisting of an insulating material, a Schottky barrier, and a reverse biased semiconductor-to-semiconductor junction.

8. An electronic device as described in claim 1, wherein said electric field means, when said electric field is exerted and said voltage is applied, changes the effective electrical conductivity of said current path by causing increased density of carriers of both polarities in at least a portion of said current path.

9. An electronic device as described in claim 8 wherein said semiconductor body has a substantial number of defect states therein and said increased density of carriers fills a substantial proportion of said defect states in the current path.

10. An electronic device as described in claim 1 wherein the space charge due to carriers of a first polarity in the current path neutralizes at least a portion of the space charge due to carriers of a second and opposite polarity.

11. An electronic device as described in claim 10 wherein the depth of said current path is substantially increased due to said neutralization.

12. An electronic device as described in claim 10 further characterized by:

means (234,249;236,240,258,259;262,264) for optimizing said space charge neutralization.

13. An electronic device as described in claim 1, further characterized by said means for ambipolar carrier injection including said first and second electrodes, each of said electrodes including a region of heavily doped semiconductor material for efficient injection of one polarity of charge carriers into said body of semiconductor material.

14. An electronic device as described in claim 13 wherein said region in said first electrode is a heavily doped n-type semiconductor material (46) and said region in said second electrode is a heavily doped p-type semiconductor material (52).

15. An electronic device as described in claim 1 wherein said body (48,148) of semiconductor material has first and second regions, said current path being substantially in only said first region (48), and further characterized by said second region (148) having many more defect states than said first region to promote carrier recombination when said electronic device is turned off.

16. An electronic device (40b;60;70;80;90;285) as described in claim 1 further characterized by said device being vertically arranged such that said first electrode is vertically spaced apart from said second electrode and at least a portion of the semiconductor body containing said current path is located therebetween, whereby at least a substantial segment of said current path is non-horizontal.

17. An electronic device as described in claim 16 further characterized by at least a part of said electric field means (50) is at least partially embedded within said portion of said semiconductor body.

18. An electronic device (150;155;160;165;170;210;215;230;255;260;270;275;280;

305;310) as described in claim 1 wherein said device is horizontally arranged and includes a first electrode horizontally spaced apart from a second electrode, with at least a portion of the semiconductor body containing said current path being located therebetween, whereby at least a substantial segment of said current path is substantially horizontal.

19. An electronic device as is described in claim 1 further characterized by:

means (212;214;44,46) for extracting charge carriers of one polarity from said current path.

20. An electronic device as described in claim 1 further characterized by:

second electric field (162;162a,162b) means for exerting a second electric field along a portion of said current path to decrease the ambipolar current flow in said current path, said second electric field being distinct from the electric field induced by said applied voltage.

21. A solid-state light emitting electronic device (270,275), comprising:

first and second electrodes (46,52);

a body of semiconductor material (48;48d,48e) arranged to form a current path between said first and second electrodes;

means (46,52) for ambipolar carrier injection into said current path in response to an externally applied voltage, and characterized by:

electric field means (50) for exerting an electric field along at least a portion of said current path to produce radiative recombination of holes and electrons in said current path resulting in a useful level of optical emissions, said exerted electric field being distinct from the electric field induced by said applied voltage.

22. A light emitting device as described in claim 21 wherein said body of semiconductor material is selected from a group of semiconductor materials consisting of crystalline semiconductor material, substantially polycrystalline semiconductor material, and substantially microcrystalline semiconductor material.

23. A solid-state light emitting device as described in claim 21 wherein said semiconductor material is an amorphous semiconductor material.

24. An electronic device as described in claim 23 wherein said amorphous semiconductor material includes an amorphous alloy of silicon.

25. An electronic device as described in claim 21 further characterized by:

means (234,249;236,240,258,259;262,264) for producing optimal space charge neutralization in at least a portion of said current path to increase radiative recombinations.

26. An electronic device as described in claim 21 further characterized by:

means (48d,48e)for changing the frequency of optical emissions by varying said exerted electric field.

27. An electronic device as described in claim 21 further characterized by:

means for varying the amplitude of said optical emissions by varying said exerted electric field.

28. A transistor (40;40a;40b;60;70;80;80a;90;95;100;110;130;140;285) comprising:

a bottom electrode (46);

a body (48a,48b) of substantially amorphous semiconductor material deposited over said bottom electrode;

a top electrode (52) formed over said body of semiconductor material, said body of semiconductor material being electrically connected to said top and bottom electrodes and arranged to form a current conducting path therebetween; and characterized by:

a control electrode (50;50a,50b;50c,50d) arranged between said top and bottom electrodes and having at least one opening (51;51a,51b;51f,51g)through which at least a portion of said semiconductor material and a portion of said current path extend,

said control electrode being positioned and said opening being sized so as to be able to exert a controllably variable electric field over at least that portion of said current path in said opening, and thereby control the flow of current between said top and bottom electrodes.

29.  A transistor (Figs.12A,12B,25A, 26A,27A,28A) as described in claim 28 wherein said amorphous semiconductor material is an amorphous alloy of silicon.

30.  A transistor as described in claim 28 wherein said control electrode is substantially closer to one of said top and bottom electrodes than the other.

31.  A transistor as described in claim 28 wherein said control electrode is made of a material which forms a rectifying junction with said body of semiconductor material.

32.  A transistor (Fig. 8) as described in claim 28 wherein said at least one opening in the layer of said control electrode through which the semiconductor material extends is sufficiently narrow so that the rectifying junction formed between the material of the control electrode and the material of the semiconductor body extends an electric field sufficient to repel charge carriers all the way across said opening without the application of an external voltage to said control electrode, so that said transistor tends to be off in the absence of the application of a voltage to its control electrode.

33. A transistor as described in claim 28 further comprising at least one layer (62;64) of electrically insulating material which insulates a major portion of said control electrode in the vicinity of said current path from said body of semiconductor material.

34. A transistor as described in claim 28 wherein both of said top and bottom electrodes have the property of injecting substantially only charge carriers of the same polarity into said body of semiconductor material, whereby the current in the current path of said transistor includes substantially only one type of charge carrier.

35. A transistor (Fig. 8) as described in claim 28 wherein at least a portion of said current path adjacent said control electrode is sufficiently narrow so that the rectifying junction formed by the contact between the material of the control electrode and the material of the semiconductor body extends an electric field sufficient to repel charge carriers all the way across said portion of said current path without the application of an external voltage to said control electrode, so that said transistor tends to be off in the absence of the application of a voltage to its control electrode.

36. A transistor (90;100;110;130;140) comprising:

a bottom electrode (36);

a body (48) of semiconductor material formed over said bottom electrode.

37. A transistor (110;140) as described in claim 36 , wherein each of said control electrodes has an opening through which said current path extends, and wherein the portion of the current path which passes through the opening in one electrode is electrically in series with the portion of the current path which passes through the opening in the other.

38. A transistor (110;140) as described in claim 36 wherein each of said control electrodes has an opening through which said current path extends, and wherein the portion of the current path which passes through the opening in one electrode is electrically in parallel with the portion of the current path which passes through the opening in the other.

FIG. 1

FIG. 2

FIG. 3

EP 0212328

FIG. 4A

FIG. 4B

FIG. 5

FIG. 6

FIG. 7

FIG. 8

FIG. 9

FIG. 10A

FIG. 10B

FIG. 11A

FIG. 11B

FIG. 12A

FIG. 12B

FIG. 13A

FIG. 13B

FIG. 14A

FIG 14B

FIG. 15

FIG. 16

FIG. 17

FIG. 18

FIG. 19A

FIG. 19B

H 25 0212328

FIG. 20

FIG. 21

FIG. 22

M25 · C0212328

**FIG. 23**

**FIG. 24A**

**FIG. 24B**

FIG. 25A

OR GATE

| $G_1$ | $G_2$ | $I$ | $V_0$ |
|---|---|---|---|
| 0 | 0 | FULLY ON | 0 |
| 0 | 1 | MOSTLY OFF | 1 |
| 1 | 0 | MOSTLY OFF | 1 |
| 1 | 1 | FULLY OFF | 1 |

FIG. 25B

FIG. 25C

## FIG. 26A

## FIG. 26B

| AND GATE | | | |
|---|---|---|---|
| $G_1$ | $G_2$ | $I$ | $V_0$ |
| 0 | 0 | FULLY ON | 0 |
| 0 | 1 | MOSTLY ON | 0 |
| 1 | 0 | MOSTLY ON | 0 |
| 1 | 1 | FULLY OFF | 1 |

## FIG. 26C

101 · Vo · 51f · 130 · 54 · 52 · G₁ · G₂ · 51g · 48 · 46 · I · 44

## FIG. 27A

### NAND GATE

| $G_1$ | $G_2$ | $I$ | $V_0$ |
|---|---|---|---|
| 0 | 0 | OFF | 1 |
| 0 | 1 | OFF | 1 |
| 1 | 0 | OFF | 1 |
| 1 | 1 | ON | 0 |

## FIG. 27B

101 · Vo · 140 · 54 · 52 · 64 · 64 · G₁ · G₂ · 50 · 51h · 64a · 51i · 48 · 46 · I · 44

## FIG. 28A

### NOR GATE

| $G_1$ | $G_2$ | $I$ | $V_0$ |
|---|---|---|---|
| 0 | 0 | FULLY OFF | 1 |
| 0 | 1 | MOSTLY ON | 0 |
| 1 | 0 | MOSTLY ON | 0 |
| 1 | 1 | FULLY ON | 0 |

## FIG. 28B

64 · 51h · 64a · 64 · 51i · 64 · G₁ · G₂ · 50 · 62 · 50c · 50d · 48

## FIG. 28C

FIG. 29A

FIG. 29B

FIG. 30A

FIG. 30B

**FIG. 31**

**FIG. 32**

**FIG. 33**

**FIG. 34**

**FIG. 35A**

**FIG. 35B**

FIG. 36

FIG. 37

FIG. 38

FIG. 39

FIG. 40A

FIG. 40B

**FIG. 41A**

**FIG. 41B**

**FIG. 41C**

0212328

FIG. 42A

FIG. 42B

FIG. 43

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-3 680 204 (APONICK et al.)<br><br>* column 3, lines 16-34 * | 1-5,7, 8,13, 14,16, 17,19, 28,29, 31,33, 34 | H 01 L  29/68<br>H 01 L  33/00 |
| Y | US-A-3 465 216 (S. TESZNER)<br><br>* column 5, lines 46-58 * | 1-5,7, 8,13, 14,16, 17,19, 28,29, 31,33, 34 | |
| Y | JAPANESE JOURNAL OF APPLIED PHYSICS, vol. 24, no. 4, april 1985, pages 467-471, Tokyo, JP; M. UEDA et al.: "Amorphous silicon static induction transistor"<br><br>* figure 1 *<br><br>---      -/- | 1-5,7, 8,13, 14,16, 17,19, 28,29, 31,33, 34 | TECHNICAL FIELDS SEARCHED (Int. Cl.4)<br><br>H 01 L  29/68<br>H 01 L  33/00 |

The present search report has been drawn up for all claims

| Place of search | Date of completion of the search | Examiner |
|---|---|---|
| BERLIN | 23-10-1986 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82

## DOCUMENTS CONSIDERED TO BE RELEVANT

Page 2

| Category | Citation of document with indication, where appropriate, of relevant passages | Relevant to claim | CLASSIFICATION OF THE APPLICATION (Int Cl 4) |
|---|---|---|---|
| Y | IEEE ELECTRON DEVICE LETTERS, vol. EDL-5, no. 4, April 1984, pages 105-107, New York, US; Y. UCHIDA et al.: "Proposed vertical-type amorphous-silicon field-effect transistors"<br><br>* figures 1, 2 * | 1-5,7, 8,13, 14,16, 17,19, 28,29, 31,33, 34 | |
| A | IEEE ELECTRON DEVICE LETTERS, vol. EDL-1, no. 2, February 1980, pages 20, 21, New York, US; H.Q. TSERNG et al.: "Light emission of GaAs power MESFETs under RF drive" | 21 | |
| A | IEEE ELECTRON DEVICE LETTERS, vol. EDL-5, no. 7, July 1984, pages 270-272, New York, US; B.A. VOJAK et al.: "A self-aligned dual-grating GaAs permeable base transistor"<br>* figure 1 * | 36-38 | TECHNICAL FIELDS SEARCHED (Int Cl 4) |

The present search report has been drawn up for all claims

| Place of search | Date of completion of the search | Examiner |
|---|---|---|
| BERLIN | 23-10-1986 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding
 - document

EPO Form 1503 03 82